Europäisches Patentamt

European Patent Office

Office européen des brevets

(19)

(11) Publication number: **0 310 041**
**A2**

## EUROPEAN PATENT APPLICATION

(21) Application number: 88116018.8

(22) Date of filing: 28.09.88

(51) Int. Cl.⁴: **H03M 5/14 , G11B 20/14**

(30) Priority: 28.09.87 JP 242987/87
29.12.87 JP 332910/87
14.01.88 JP 6445/88
12.02.88 JP 28968/88

(43) Date of publication of application:
05.04.89 Bulletin 89/14

(84) Designated Contracting States:
**DE GB**

(71) Applicant: **NEC HOME ELECTRONICS, LTD.**
**5-24, Miyahara 3-chome Yodogawa-ku**
**Osaka-Shi Osaka(JP)**

(72) Inventor: **Satoshi, Itoi c/o Nec Home**
**Electronics Ltd.**
**No. 5-24, Miyahara 3-chome Yodogawa-ku**
**Osaka-shi Osaka(JP)**

(74) Representative: **Diehl, Hermann Dr. et al**
**Diehl & Glaeser, Hiltl & Partner**
**Flüggenstrasse 13**
**D-8000 München 19(DE)**

(54) 8-bit to 9-bit code conversion system and 8/9 converter.

(57) An 8/9 code conversion system (11) for perform-
ing the code conversion of 8-bit data into 9-bit data,
the 8/9 code conversion system being characterized
in that a pair of conversion tables (A1,A2) which are
differentiated based upon whether the digital sum
variation (DSV), which indicates the direct current
balance of the 9-bit data after their code conversion,
is positive or negative. The appropriate conversion
table (A1,A2) is selected in accordance with the
positive or negative polarity of the integrated DSV
value, which is updated at the time of each conver-
sion. The code conversion is then performed in such
a manner that the integrated DSV value converges
on zero.

*FIG. 2*

EP 0 310 041 A2

## 8-BIT TO 9-BIT CODE CONVERSION SYSTEM AND 8/9 CONVERTER

This invention relates to an 8/9 conversion system which is suitable for the digital processing of voice and visual signals and an 8/9 encoder using this system or method.

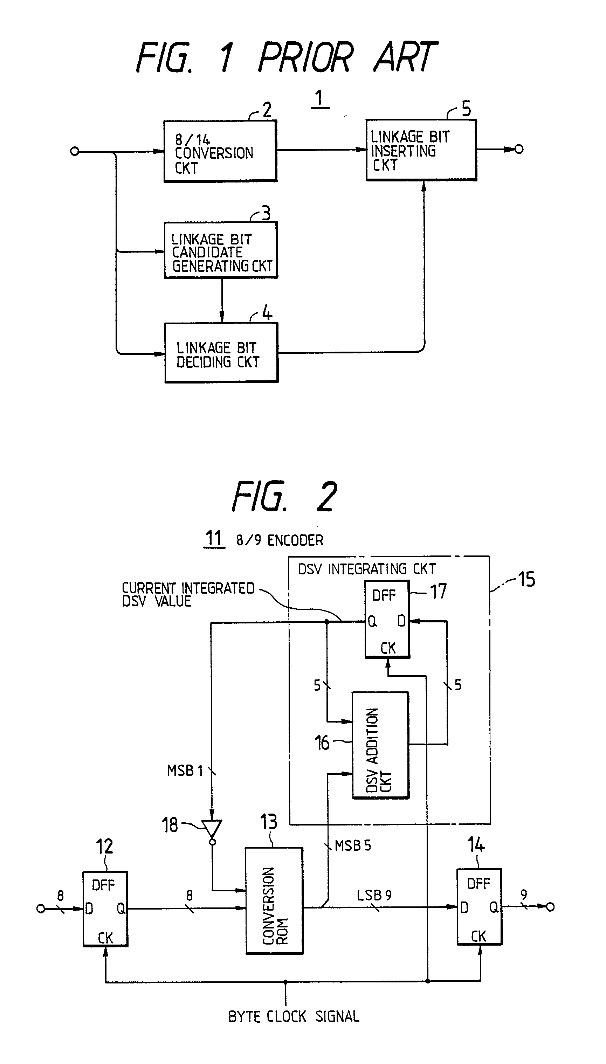

A compact disc may be played back with a CD (compact disc) player having an EFM (8/14 code conversion) register which is suitable for the tracking servo operation at the time of the reproduction of signals. The conventional 8/14 encoder 1 shown in Fig. 1 is provided with an 8/14 conversion circuit 2 which converts the inputted 8-bit data streams after they are subjected to error-correction by means of a CIRC encoder (not illustrated in the drawing) into 14-bit channel streams according to the conversion table. The data bits are fed not only into the 8/14 conversion circuit 2, but also into the linkage-bit-candidate-generating circuit 3, which generates linkage bit candidates subject to the bit conversion rules, and into the linkage-bit-deciding circuit 4, which makes a decision on the optimum linkage bit out of the linkage bit candidates in accordance with the digital sum variation (DSV) evaluation to be described later. By inserting in the linkage-bit-inserting circuit 5 the optimum linkage bit decided by the linkage-bit-deciding circuit 4 into the 14-bit data, which are the output from the 8/14 conversion circuit 2, the 14-bit data are linked with each other.

The 8/14 conversion circuit 2 is provided with a ROM (Read Only Memory) which accommodates in the form of a conversion table the $2^8$ (256) patterns selected, in accordance with the bit conversion rules that there should be two or more "0"'s between "1" and "1" and that the number of "0"'s should be ten or less out of $2^{14}$ patterns of combinations of "1" indicative of a reversal and "0" indicative of a non-reversal, and that the input 8-bit data are converted into 14-bit data in unitarily defined correspondence. Moreover, the linkage-bit-candidate-generating circuit 3, which generates candidates for the linkage bits to be inserted between the 14-bit data, is designed for adjustment with the bit conversion rules by inserting the 3-bit linkage bits between mutually adjacent 14-bit data so that the circuit may deal properly with such a case in which the final part in the preceding 14-bit data ends with "1" and the succeeding channel bit begins with "1", and this circuit feeds those patterns which do not violate the bit conversion rules out of the four kinds of patterns, 000, 001, 010, and 100, which are conceivable as the linkage bits, as the linkage bit candidates to the linkage-bit-deciding circuit 4. Then, the linkage-bit-deciding circuit selects as the optimum linkage bits the pattern which minimizes the DSV (Digital Sum Variation), which represents the direct current component of the 31-bit portion of 28 bits of the mutually adjacent 14-bit data and the 3-bit linkage bits out of the linkage bit candidates fed from the linkage-bit-candidate-generating circuit 3.

The DSV mentioned above represents the total number of points accumulated along with the progress of the 14-bit data, with the high level of the signal waveform of the 14-bit data being given + 1 point and the low level of the signal waveform being given -1 point. Thus, the smaller the absolute value of the DSV is, the less the direct current component and the low frequency component will be in the 14-bit data and the less susceptible the data will be to the influence given by the flaws or the like which may be present on the surface of the compact disc. Therefore, the linkage bits which minimize the DSV obtained in the final part of the mutually adjacent 14-bit data are selected as the optimum linkage bits.

The conventional 8/14 encoder 1 described above has had such problems as the requirement of a fairly large number of redundant bits for the conversion of 8-bit data, including the linkage bits for linking the 14-bit data with one another, so that the transmission bandwidth for the signals has to be broadened, even though the encoder can cancel off the direct current component in the signals. Another problem has been that the encoder has a comparatively small value, i.e., 0.47 T to the bit interval T, for the detection port width, Tw, which expresses the degree of tolerance (i.e. the jitter margin) for preventing the occurrence of a code error when the time axis for the reproduced signals fluctuates.

Moreover, an 8/10 encoder, which has the maximum code reversal interval, T max, reduced to 3.2 T, as compared with 5.18 T for the 8/14 encoder, through a reduction of redundancy by four bits, presents such problems as its having a relatively small value, 0.8 T, in its minimum code reversal interval, T min., which necessarily results in a high level of the maximum recording frequency, thereby making it necessary to increase the resolution in the recording system and consequently rendering this encoder inappropriate for high-density recording. Also, an encoder of the 1.5 T type, which has realized a T min. value of 1.5 T, as the result of the importance attached to the minimum code reversal interval rather than the detection port width, Tw, has had a problem, among others, in that it is not free from the direct current components.

Furthermore, an 8/9 encoder, which can work well with one bit, i.e., the minimum bit number, for the number of redundant bits necessary in connection with the code conversion, permits an extension of the minimum code reversal interval, T min., to 0.89 T, though the extension is slight, but this encoder has presented such problems as one associated with the fact that the recording frequency band develops a broadened bandwidth since it has a fairly large value, 20 T, in the maximum code reversal interval, T max.

It is the purpose of this invention to solve the problems found in the conventional code conversion systems described above. This object is solved by the systems described in independent claims 1 to 4 and by the 8/9 converters of the independent claims 5,6,11 and 15. Further advantageous features are evident from the dependent claims.

The present invention proposes an 8/9 code conversion system which performs the conversion of the 8-bit data into 9-bit data, by operating with a pair of conversion tables provided in the system designed for differentiation of the data on the basis of the distinction whether the DSV, which indicates the direct current balance of the 9-bit data after the code conversion, is positive or negative, by selecting the appropriate conversion table depending on whether the integrated DSV value is renewed at each time of conversion, and by performing the code conversion in such a manner that the integrated DSV value converges on zero.

In another aspect in accordance with the present invention, the above-mentioned 8/9 conversion system consists of the steps of differentiating the 9-bit data after their code conversion on the basis of the distinction whether the DSV value, which indicates their current balance, is positive or negative, preparing conversion tables representing the correlation of such data in the order from the smallest absolute value of the DSV so that the data so differentiated will respectively center around the value midway between the maximum value and the minimum value for the 8-bit data, and performing the code conversion by selecting one of the conversion tables out of the pair of the prepared conversion tables in such a manner that the integrated DSV value, which is renewed at each time of such conversion, will converge on zero.

As still another aspect of accomplishing the purpose of this invention in the 8/9 code conversion system described above, a pair of conversion tables, i.e., a main table and an auxiliary table, are prepared for setting mutually different 9-bit data in correspondence to one 8-bit data, and code conversion is performed in accordance with the main conversion table when the integrated DSV value, which is renewed at each time of conversion, is within a certain predetermined range, whereas when the integrated DSV value deviates from the above-mentioned predetermined range, code conversion is performed in accordance with the proper one of the main conversion table or the auxiliary conversion table so that the integrated DSV value will converge on zero, with priority being given to the condition that 13 bits or more of the same kind of bits should not occur in succession.

Furthermore, the purpose of this invention is accomplished in the 8/9 code conversion system mentioned above by executing code conversion with a main conversion table prepared for conversion of one eight-bit data stream into a 9-bit data stream with an absolute value of 3 or less for the DSV, which indicates the direct current balance of the individual data, and an auxiliary conversion table prepared for conversion of the data into 9-bit data with an absolute DSV value of 3 or more and with a DSV polarity reverse to that of the data processed with the main conversion table mentioned above, the code conversion being performed in accordance with the main conversion table when the integrated DSV value, which is renewed at each time of conversion, is within a certain predetermined range, but in accordance with the appropriate one of the main conversion table and the auxiliary conversion table when the integrated DSV value deviates from the predetermined range. The table is chosen in such a way that the integrated DSV value converges on zero.

The 8/9 code conversion system proposed in this invention makes it possible to generate encoded data with a high degree of efficiency in satisfaction of the RLLC (Run Length Limited Code) Rules by cancelling off the direct current component of the converted signals while keeping the integrated DSV value within a certain limited framework.

Fig. 1 is a circuit block diagram showing one embodiment of the conventional 8/14 encoder.

Fig. 2 is a circuit block diagram illustrating the first embodiment of the 8/9 encoder to which the 8/9 code conversion system of the first and second embodiments are applied.

Fig. 3 is a circuit block diagram showing the second embodiment of the 8/9 encoder to which the 8/9 code conversion system of the third embodiment is applied.

Fig. 4 is a circuit block diagram showing the third embodiment of the 8/9 encoder to which the 8/9 code conversion system of the fourth embodiment is applied.

In the following, the embodiments of this invention will be described with reference to the drawings and the tables. Fig. 2 is a circuit block diagram illustrating the first embodiment of the 8/9 encoder to which the 8/9 code conversion system of this invention is applied. Table 1-1 through Table 1-8 are respectively the conversion tables used for code conversion with the 8/9 encoder illustrated in Fig. 2.

The 8/9 encoder shown in Fig. 2 is one which performs the conversion of 8-bit data into 9-bit data, and the working principle of this encoder consists in providing a pair of conversion tables A1 and B1, which are differentiated on the basis of the point whether the DSV indicating the direct current balance of the 9-bit data after their code conversion is positive or negative, and then performing the code conversion in such a manner that the integrated DSV value converges on zero by selecting either the conversion table A1 or B1 as appropriate, depending on the point whether the integrated DSV value, which is renewed at each time of such conversion, is positive or negative.

The 8-bit data are fed into the conversion ROM 13 by way of the D flip-flop circuit 12 in the initial stage. Then, after the data are converted into 14-bit data in accordance with either one of the conversion tables A1 and B1 provided within the conversion ROM 13, the data so processed are divided into two groups, i.e., the nine lower-order bits and the five higher-order bits, both these groups of bits being respectively fed into the D flip-flop (DFF) circuit 14 for output to external equipment and into the DSV integrating circuit 15 for internal feedback in the system. The DSV integrating circuit 15 is composed of an integrating circuit 16, which renews the integrated DSV value with the addition of the DSV up to that point in time to the output of the five higher-order bits from the conversion ROM, and a D flip-flop circuit 17, which latches the output from this integrating circuit 16, and the output from the D flip-flop circuit 17, which represents the integrated DSV value at the present moment, is taken as the integrated output from the integrating circuit 15.

Furthermore, for the reasons to be mentioned below, the highest-order bit in the output from the D flip-flop circuit 17 becomes either "0" or "1" depending on the polarity (positive or negative) of the integrated DSV value, and the bit is fed into the conversion ROM 13 via the polarity reversing circuit 18 as the data for the selection of the proper conversion table within the conversion ROM 13.

In this regard, the pair of conversion tables accommodated inside of the conversion ROM 13 are composed of Conversion Table A1, in which the DSV showing the direct current balance of the 9-bit data after the conversion is positive, and the Conversion Table B1, in which the DSV is negative, and either of these conversion tables has a data arrangement in which the data with a value closer to the middle value of the 8-bit data are set in proportionate correspondence to the 9-bit data with greater value for the number of times of code reversal INV. Consequently, the higher the frequency of occurrence of any given 9-bit data, the greater the value is for the number of times of their code reversal INV, and this reflects the designing effort to attain the highest effectiveness possible in the stabilization of the direct current balance by nullification of the direct current component (the realization of a DC-free state).

Moreover, for the conversion tables actually accommodated inside of the conversion ROM 13 are used those tables which are compiled in a tabular form actually by adding the data representing the DSV in terms of the complement of 2 for each data bit in the higher-order positions of the 9-bit data given on the conversion tables A1 and B1 with 256 items of addresses from (00) H to (FF) H assigned to such data. Accordingly, in the conversion ROM 13, data are stored in the pattern comprising five DSV bits placed in the higher-order positions for linkage to the 9-bit data bits, and, when the output from the above-mentioned polarity-reversing circuit 18 is "0" (that is, when the integrated DSV value is negative), the conversion table A1 is selected, whereas when the output is "1" (that is, when the integrated DSV value is positive), the conversion table B1 is selected.

Now, assume that 8-bit data 00000000 in correspondence to the address (00) H has been transmitted when the DSV integrated value is, for example, 11011, i.e. 5 in 2's complement notation. In such a case, the conversion table A1 is selected because the output from the polarity-reversing circuit 18 is "0", and the data in correspondence to the address (00) H, namely, 11001111111110, is output. In this instance, the higher-order five bits, 11001, represent the DSV 7 for the 9-bit data, 111111110, which will be added to the integrated DSV value -5 registered so far inside the DSV integrating circuit 15, and, as a result, the integrated DSV value changes to 2.

When the integrated DSV value becomes 2, the output from the polarity-reversing circuit becomes "1" and, consequently, the 8-bit data transmitted next will necessarily be code-converted with reference to the conversion table B1. In this system, the integrated DSV value will not exceed ± 7 even in the maximum, and the converted output will therefore not have any substantial direct current component.

The data bits which are thus transmitted one after another to the part of the system mentioned above are subjected to the code conversion in a manner which always results in the convergence of the integrated DSV value to zero, and, in this regard, the bit interval of the 9-bit data, i.e., the minimum code reversal interval, T min, is expressed by 8/9 T( = 0.89 T). Then, the maximum code reversal interval, T max., which is considered to be so much better if it is as short as possible, will be the period in which 21 "0's" continue to persist, i.e., 21 T min ( = 18.8T), which will occur in the worst assumed case where the 9-bit data appear in the sequence, 100000000, 000000000, 000011111.

In this manner, the 8/9 encoder 11 described above is so constructed that it is provided with a pair of conversion tables A and B, which are differentiated on the basis of the distinction whether the DSV, which represents the direct current balance of the 9-bit data after their conversion, is positive or negative, selects the conversion table A or the conversion table B in accordance with the positive or negative polarity of the integrated DSV value, which is renewed at each time of such conversion, and performs the code conversion in such a manner as to make the integrated DSV value converge on zero. Therefore, this encoder is capable of cancelling off the direct current component while confining the integrated DSV value within the limits in the range from -7 to +7. It is also capable of readily generating such highly efficient codes that the codes after their conversion show the minimum code reversal interval T min at 0.89 T, the maximum code reversal interval T max at 18.8 T, and the detection port width Tw at 0.89 T, thereby satisfying the RLLC Rules. As for the conversion tables exemplified in Tables 1-1 to 1-8, it is sufficient to provide only two such tables for the 8-bit data, and with 256 addresses it is possible to read the pertinent 9-bit data, by which it is made possible to develop a PLA which gives full play to the advantageous features of a small-scale ROM.

In the first embodiment of this invention described above, the pair of conversion tables A1 and B1 which are accommodated inside of the conversion ROM 13 can accept various modifications in accordance with the basis rules described above, and it is also possible to set up variations freely as necessary in the combinations of the 9-bit data in relationship to the 8-bit data.

Tables 2-1 through 2-8 represent the conversion tables provided in the conversion ROM according to the second embodiment of this invention. For the 8/9 encoder in the second embodiment, the same encoder as the one used in the first embodiment described above is used. Hence, its description is omitted here.

The conversion tables A2 and B2 in the second embodiment set the 9-bit data in correspondence in a sequential order from the smallest of their absolute DSV values in such a manner that they center around the intermediate values (7F) H and (80) H for the maximum value (FF) H and the minimum value (00) H of the 8-bit data. In the second embodiment, the 9-bit data the individual bits of which are in mutually reversed relations are stored in Tables A2 and B2, with the 256 pieces of 8-bit data in hexadecimal representation being used as the addresses, as shown in Tables 2-1 through 2-8. In the meantime, for the purpose of improving the reproduction characteristics for the recorded data, attention has been given also to the code reversal intervals, INV, of the 9-bit data through designing a feature by which those 9-bit data having more frequent code reversal intervals can be obtained in closer proximity of the middle value for the 8-bit data. In addition, the DSV values for the converted data are represented in complements of 2, which are linked in the form of the 5-bit data occupying the higher-order positions preceding the 9-bit data and stored in the tables.

Now, suppose that the 8-bit data, 00000000, which is in correspondence to the address (00) H has come transmitted when the integrated DSV value is 11011, i.e., -5, for example. In such a case, the output from the polarity-reversing circuit 18 is "0" and consequently the conversion table A is selected, and the data 001111111111110 which corresponds to the address (00) H is output. The five higher-order bits in the output obtained at this time are expressive of the DSV 7 for the 9- bit data 111111110, which is added on to the integrated DSV value -5 registered up to that time. As a result, the integrated DSV value changes to 2.

Thus, according to the second embodiment of this invention, the 8/9 encoder 11 described above is so constructed that it differentiates the 9-bit data after their code conversion on the basis of the distinction whether their DSV, which represents their direct current balance, is positive or negative, and provides the conversion tables A2 and B2, which respectively set the correspondence of the converted data in the sequential order from the smallest of the absolute DSV values, so that the values for the data center around the middle value between the maximum value and the minimum value for the 8-bit data. The code conversion is performed by selecting one or the other of the conversion tables A2 and B2 in such a manner that the integrated DSV value, which is renewed at each time of conversion, converges on zero. Therefore, the higher the frequency of occurrence is for the 8-bit data, the smaller the absolute DSV value will be for the 9-bit data into which the 8-bit data can be code-converted, and, additionally, since the selection of the tables is executed for the purpose of achieving the convergence of the integrated DSV value on zero, this system is capable of placing the maximum restraint upon the fluctuations of the direct current component while confining the integrated DSV values of the 9-bit data obtained through their code conversion within a certain limiting framework in the range from -9 to +8.

Moreover, since the encoder has been constructed in such a way that those 9-bit data which have a higher frequency of occurrence will be code-converted into those 9-bit data having proportionately more frequent code reversal intervals, it is possible to place the maximum restraint possible upon the prolongation of the code reversal intervals and thereby to prevent the deterioration of the reproduction characteristics for the recorded data.

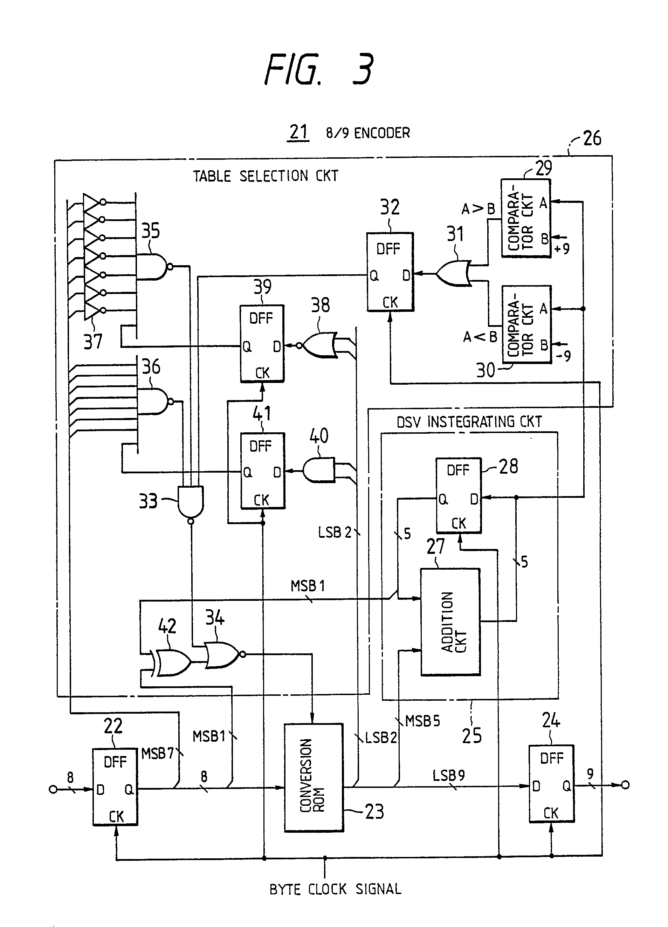

Fig. 3 is a circuit block diagram illustrating the second embodiment of the 8/9 encoder to which the 8/9 code conversion method according to the third embodiment has been applied. Tables 3-1 through 3-8 are drawings showing the conversion tables to be employed for the code conversion with the 8/9 encoder illustrated in Fig. 3.

In Fig. 3, the 8/9 encoder 21 is the one which performs the code conversion of 8-bit data into 9-bit data, and this encoder, being provided with a pair of conversion tables, i.e., a principal one and an auxiliary one which set the mutually different 9-bit data to the individual 8-bit data, performs the code conversion with one of the appropriately selected tables while considering the convergence of the integrated DSV value on zero and the restraint to be placed on T max, the maximum code reversal interval. The principal conversion table and the auxiliary conversion table contain 9-bit data having different polarities in their DSV, together with 256 pieces of 8-bit data in hexadecimal representation serving as addresses, stored in the conversion ROM 23. Both of these tables are so composed that the polarity of the DSV is reversed by the former half and the latter half, i.e., the 8-bit data (00) H ~ (7F) ᴴ and (80) H ~ FF) H. Moreover, the DSV of the converted data are represented in the complements of 2, which are linked in the form of the 5-bit data placed in the higher-order positions preceding the 9-bit data and are stored in the tables.

Furthermore, in the case of the third embodiment, design consideration has been given in such a way that the DSV is set at +1 in relation to (00) H and (01) H, at +3 for (02) H ~ (27) H, and at +1 for (28) H ~ (7F) H, respectively, for the 8-bit data in the former half of the principal conversion table. At least one bit each of "0" and "1" is present in the higher-order three bits of the 9-bit data while at least one bit of "1" is present in the lower-order two bits of the same data. Also, the latter half of the principal conversion table is so designed that the DSV is set at -1 for (80) H ~ (D7) H, at -3 for (D8) H ~ (FD) H, and at -1 for (FE) H and (FF) H, respectively, for the 8-bit data. Additionally, at least one bit each of "0" and "1" is present in the higher-order three bits of the 9-bit data while one bit of "1" is present in the lower-order two bits of the data. By contrast, the auxiliary conversion table is composed in such a way that the 9-bit data (000) H and (001) H are allocated respectively to (00) H and (01) H for the 8-bit data, and (1FE) H and (1FF) H are allocated respectively to (FE) H and (FF) H for the 8-bit data.

In this regard, the 8-bit data are first transmitted, by way of the D flip-flop (DFF) circuit 22 in the initial stage, into the conversion ROM 23 which stores in its memory the principal conversion table and the auxiliary conversion table, and after the 8-bit data are converted into 24-bit data in accordance with either one of the conversion tables in the conversion ROM 23, the nine bits in the lower-order positions and the five bits in the higher-order positions as well as the two bits in the lower-order positions are respectively fed into the D flip-flop circuit 24 for output to external equipment and into the DSV-integrating circuit 25 and the table-selecting circuit 26. The DSV-integrating circuit 25 is composed of an adding circuit 27, which effects the renewal of the integrated DSV value by the addition of the DSV on record up to that point in time to the output on the five higher-order bits from the conversion ROM 23, and the D flip-flop circuit 28, which latches the output from the adding circuit 27. Here, the output which is obtained, with an indication of the current integrated DSV value, from the D flip-flop circuit is taken as the input into the adding circuit 27 for addition thereto.

The integrated DSV value which can be obtained from the adding circuit 27 is fed into the comparator circuits 29 and 30 provided in the table-selecting circuit 26 and calibrated to the comparison criteria at + 9 and - 9, respectively, against which the comparator circuits 29 and 30 determine whether or not the integrated DSV value is within the range of - 9 ~ + 9 as set in advance. The results of the comparison made in the comparator circuits 29 and 30 are unified in the OR gate circuit 31 and then latched in the D flip-flop circuit 32. This latched output from the D flip-flop circuit 32, in the case of this third embodiment, is supplied to the table selection ON terminal in the conversion ROM via the NAND gate circuit 33 and the NOR gate circuit 34, and in case the integrated DSV value is within the range from -9 to + 9 as mentioned above, the low-level latch output from the D flip-flop circuit 32 is used to select the principal conversion table. Moreover, the NOR gate circuit 34, which employs the low-level output as the signal for selection of the principal conversion table, takes the output from the NAND gate 33 as one part of input into it while it takes the other part of its input from the output of the EXCLUSIVE-OR gate circuit 42, which takes the exclusive-or value of the highest-order bit of the input 8-bit data and the highest-order bit of the integrated DSV value. In this case, the highest-order bit of the input 8-bit data has its "0" or "1" in correspondence to either the former half or the latter half, i.e., the positive or negative polarity of the 9-bit output data, and similarly, the highest-order bit of the integrated DSV value, i.e., the "0" or "1" in it, indicates the positive or negative polarity of the integrated DSV value.

Now, the NAND gate circuit 33 is connected not only to the D flip-flop circuit 32, which outputs the data indicating the range of the integrated DSV value, but also with two NAND gate circuits 35 and 36 which enforce the selection of the principal conversion table regardless of the range of the DSV values, and this feature reflects the consideration given to the designing of the system in such a manner not to permit the occurrence of any consecutive series of 13 or more bits consisting solely of "0's" or "1's" when two sets of 9-bit data are mutually adjacent one preceding the other in a directly contiguous sequence. That is to say, the NAND gate circuit 35 is supplied with the data obtained by code conversion of the seven higher-order bits of the input 8-bit data via the inverter circuit 37 and also with the latch output from the D flip-flop circuit 39, which is connected with the NOR gate circuit 38 that judges whether the two lower-order bits in the output 9-bit data one clock in advance are 00 or not. Due to this feature, code conversion will be performed necessarily with the principal conversion table by the low-level output from the NAND gate circuit 35 in case the two lower-order bits in the output 9-bit data one clock in advance are 00 while the input 8-bit data are (00) H or (01) H. Moreover, the NAND gate circuit 36 is supplied with the seven higher-order bits of the input 8-bit data and with the latch output from the D flip-flop circuit 41 which is connected to the AND gate circuit 40 that judges whether the two lower-order bits of the output 9-bit data one clock in advance are 11 or not. Due to this feature, code conversion with the principal conversion table is necessarily performed by the effect of the low-level output from the NAND gate 36 in case the two lower-order bits in the output 9-bit data one clock in advance are 11 while the input 8-bit data are (FE) H or (FF) H.

Assume that 00001010 in correspondence to the address (10) H has come transmitted in the form of 8-bit data when the integrated DSV value is 01001, i.e. + 9, for example. In this case, the outputs from the NOR gate circuits 31 and 34 are both low-level outputs, for which reason code conversion with the principal conversion table is performed, and the data, 000011110101110, corresponding to the address (10) H will be output. Moreover, the five higher-order bits, 00011, in the output data at this time represents the DSV + 3 in relationship to the 9-bit data, and as a result of its addition to the integrated DSV value + 9 up to the time within the DSV integrating circuit 15, the integrated DSV value changes to + 12.

Next, suppose that (5D) H has come transmitted in the form of input 8-bit data. In this case, the output from the NOR gate circuit 31 has already changed to a high level at the point in time when the integrated DSV value exceeds + 9, and consequently the output from the NAND gate circuit 33 shifts to a low level. In the meantime, since the output from the EXCLUSIVE-OR gate is also at a low level, the output from the NOR gate which is located at the final stage, will assume a high level, with the result that the auxiliary conversion table is selected. Therefore, the 9-bit data, 111100000, having the DSV of - 1 is selected, so that the integrated DSV value is pulled back towards the zero side and assumes + 11.

Furthermore, assume that (00) H has come transmitted in the form of input 8-bit data following (5D) H. In this case, the output from the NAND gate circuit 35 will be at a low level since the two lower-order bits in the 9-bit data output one clock in advance was 00, and in spite of the fact that the integrated DSV value is in excess of + 9, the principal conversion table is selected in spite of the fact that the integrated DSV value exceeds + 9 in the conversion ROM 23 upon its reception of the low-level output from the NOR gate circuit. As a result, the integrated DSV value assumes + 10, marking a transitory swing towards the side which means a movement away from zero, and yet this selection of the principal conversion table can prevent the inadequate state that "0" occurs in succession through 14 bits, which would happen in case the auxiliary conversion table were selected.

Thus, the data bits which come transmitted one after another are processed for their code conversion in a manner always working towards the convergence of the integrated DSV value, and, in this process, the bit interval of the 9-bit data, i.e. the minimum code reversal interval, T min, is expressed as 8/9 T ( = 0.89 T) in comparative relationship to the bit interval, T, for the 8-bit data. The maximum code reversal interval, T max, which is considered to be so much better if it is as short as possible, is 12 T min ( = 10.7 T), which represents the duration through which the 12 pieces of "0" occurs in succession, which is based on the assumption of the worst case in which the 9-bit data occurs in the sequence 10,000000000,001.

As described so far, the 8/9 encoder 21 mentioned above is so constructed that it is provided with a pair of conversion tables, i.e., the principal one and the auxiliary one, which set mutually different 9-bit data in correspondence to one 8-bit data, and performs code conversion in accordance with the principal conversion table when the integrated DSV value, which is renewed at each time of such conversion, is within a certain range i.e. - 9 ~ + 9) established in advance but performs code conversion in accordance with either one of the principal conversion table and the auxiliary conversion table as appropriate. The encoder functions in such a manner that the integrated DSV value will converge on zero, with priority given to the condition that the same kind of bit should not be permitted to occur in succession for any sequential length of 13 bits or more when the integrated DSV value deviates from the afore-mentioned predetermined range. Due to these features, this encoder is capable of placing restraint upon the fluctuations of the direct current component while restricting the integrated DSV values of the 9-bit data within a certain range of limits. This encoder also can hold down the maximum code reversal interval in particular to a value approximately 10.7 times as large as that of the bit interval since the former occurs in case bits of the same kind occur in a sequence of 12 bits in succession, and with this feature at work, this encoder can place restraint on the maximum recorded frequency.

The 8/9 encoder 21 also can store a pair of conversion tables, a principal one and an auxiliary one, in its conversion ROM 23, which has 256 addresses in it, and accepts the addition of a DSV integrating circuit 25 and a table selection circuit 26, which are necessary for the reading of the 9-bit data out of the conversion ROM 23, by which this encoder is capable of obtaining the 9-bit data satisfying the RLLC. This allows achievement of the minimum code reversal interval, T min, at 0.89 T, the maximum code reversal interval, T max, at 10.7 T, and the detection port width Tw at 0.89 T. Thus, this encoder can accomplish the development of a PLA for the effective utilization of the features characteristic of a small-scale ROM, as well as the simplification of the circuitry as a whole.

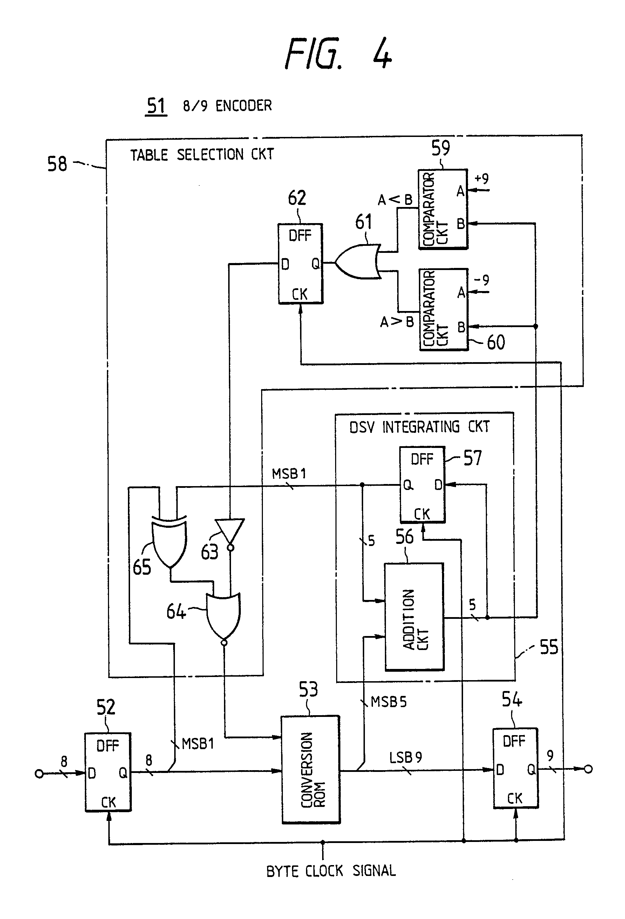

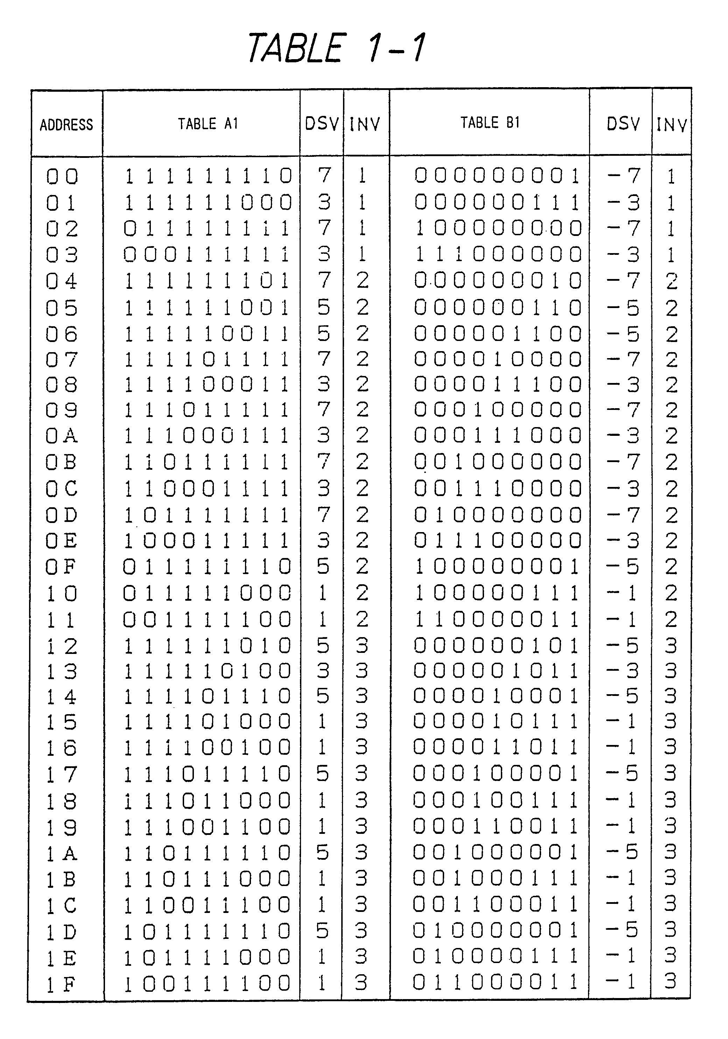

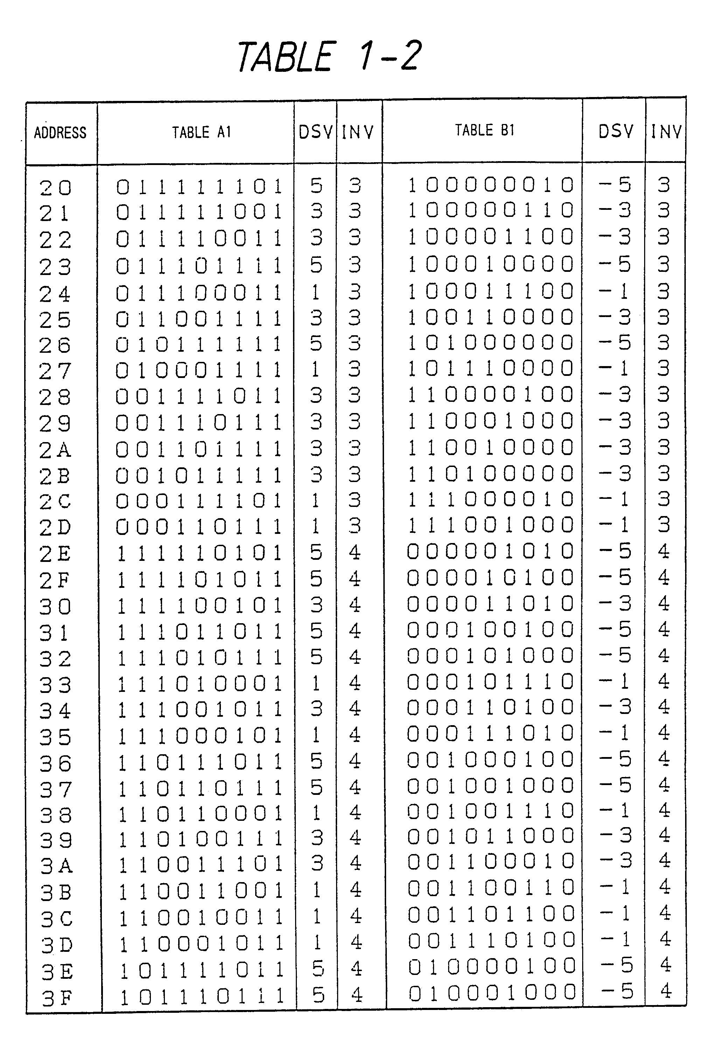

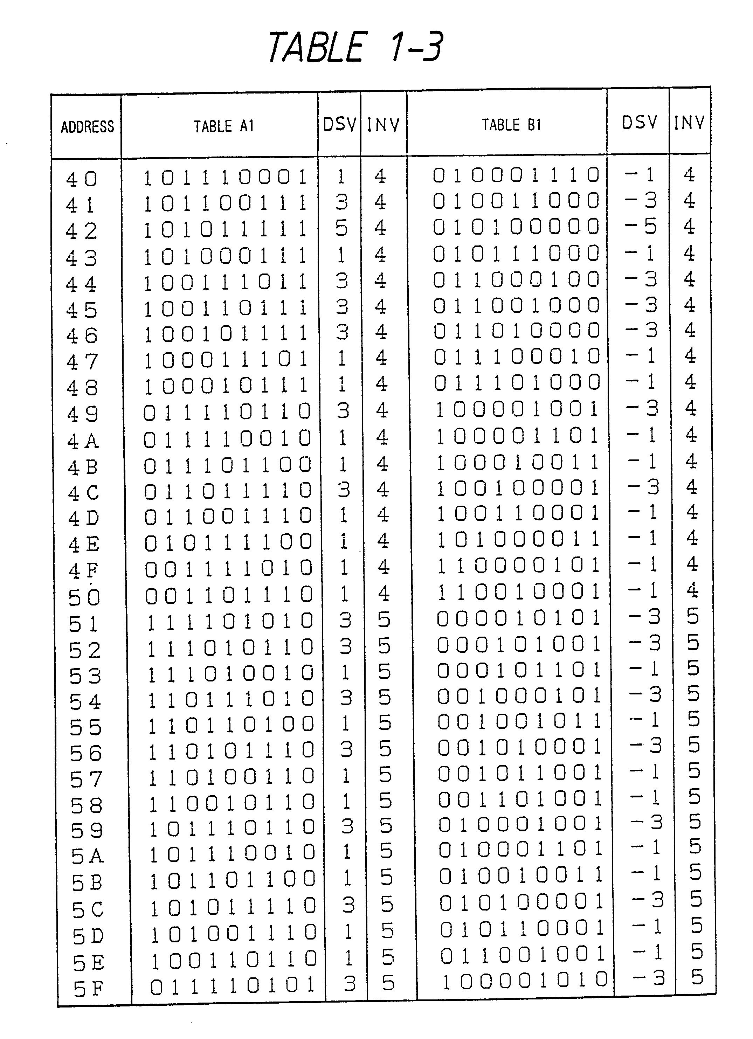

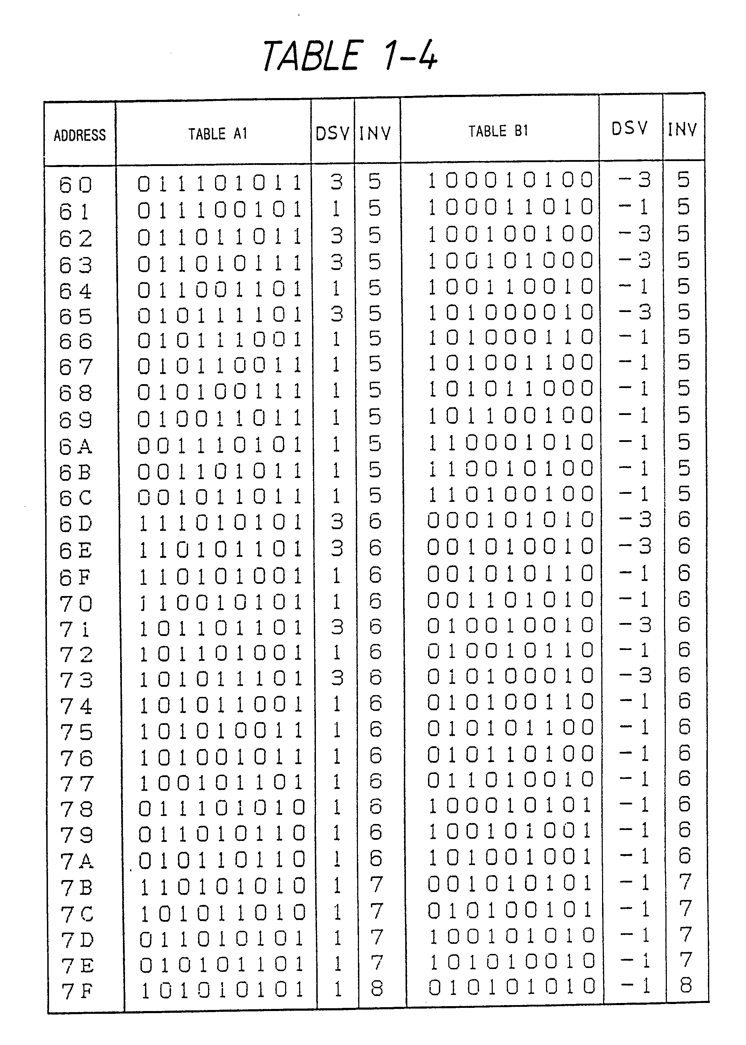

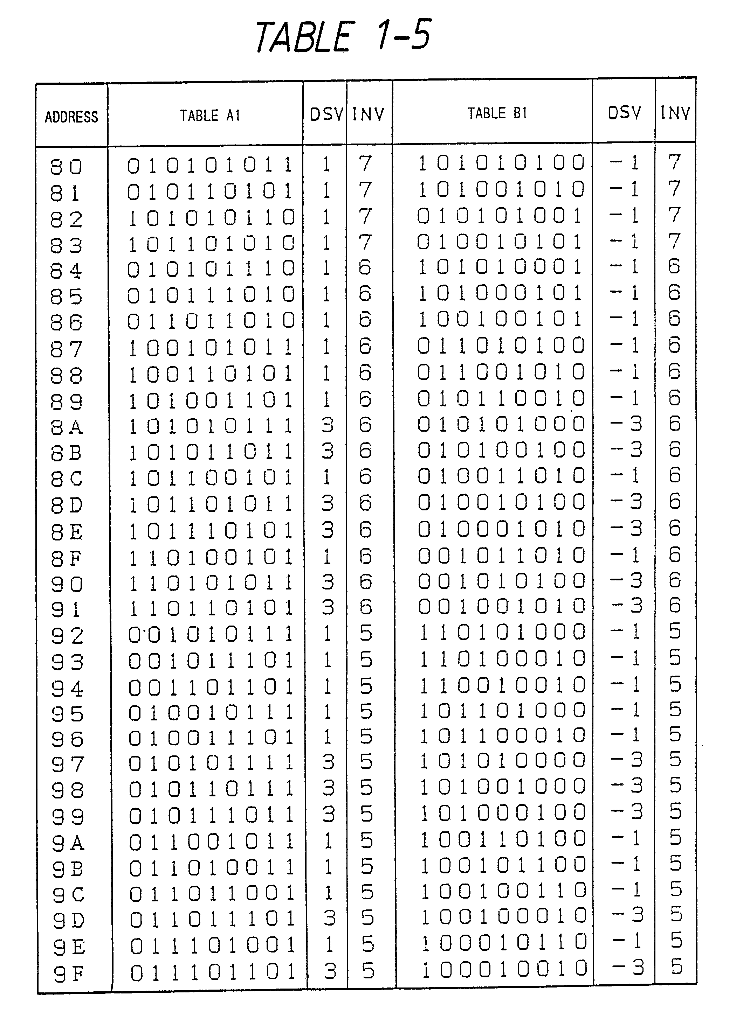

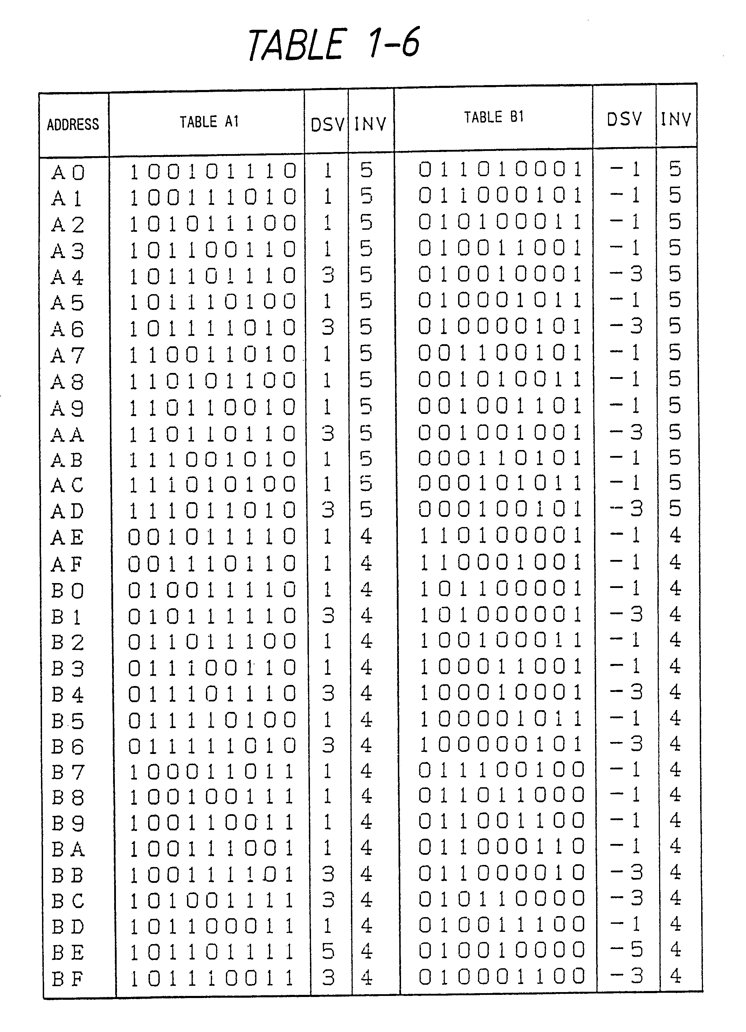

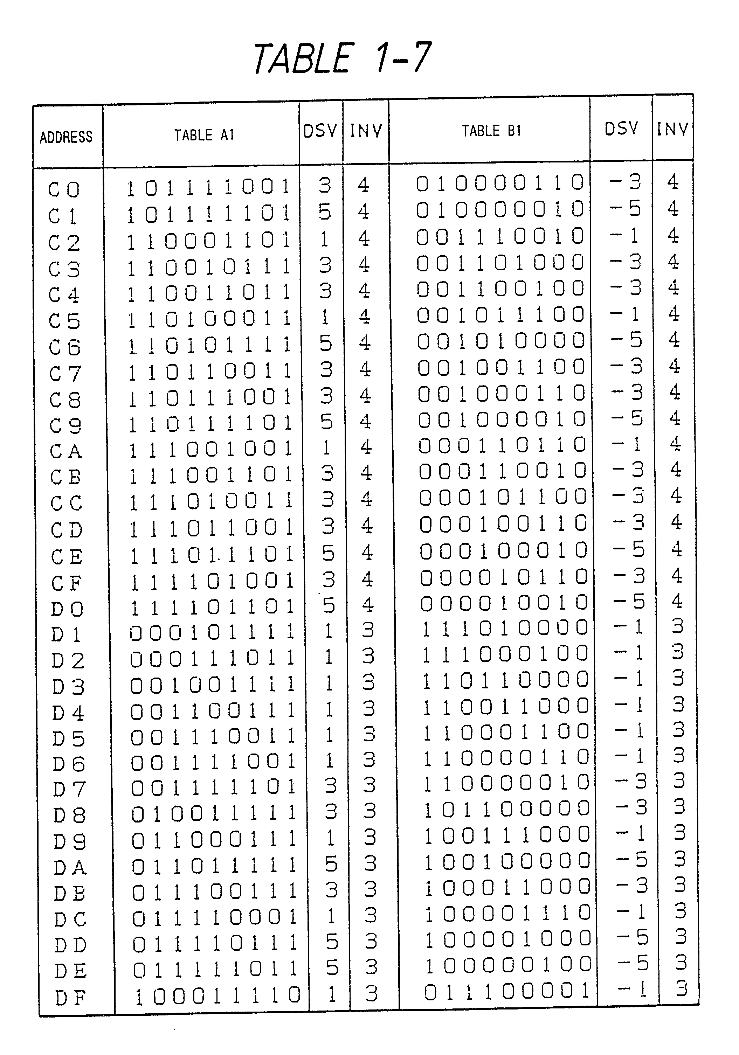

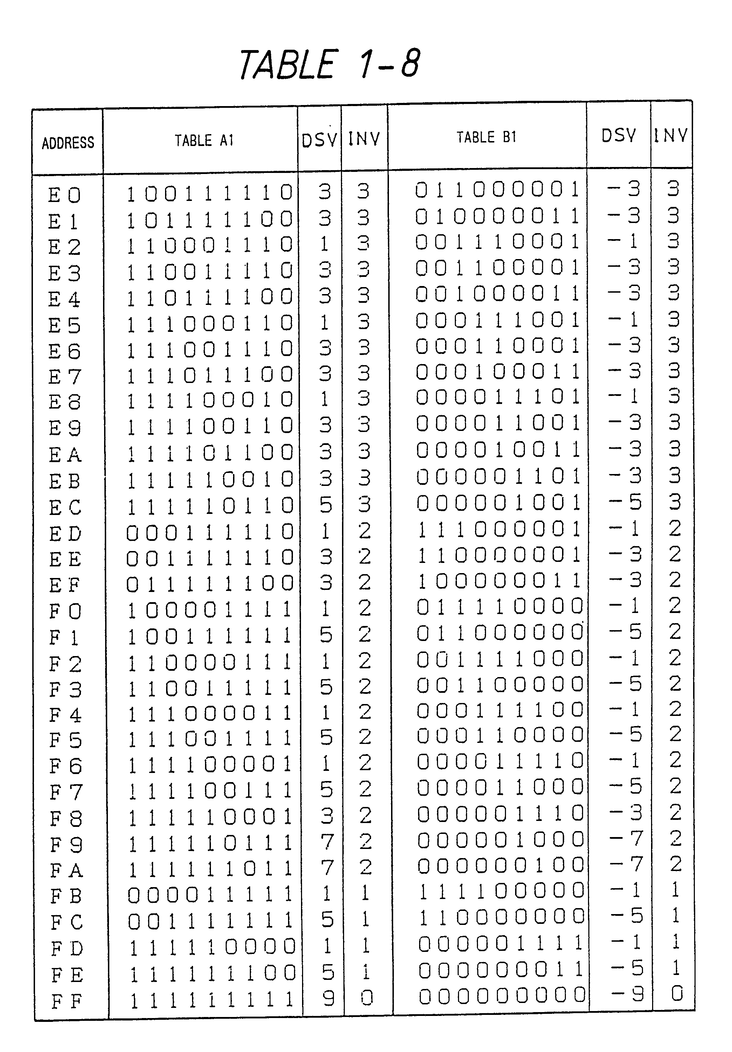

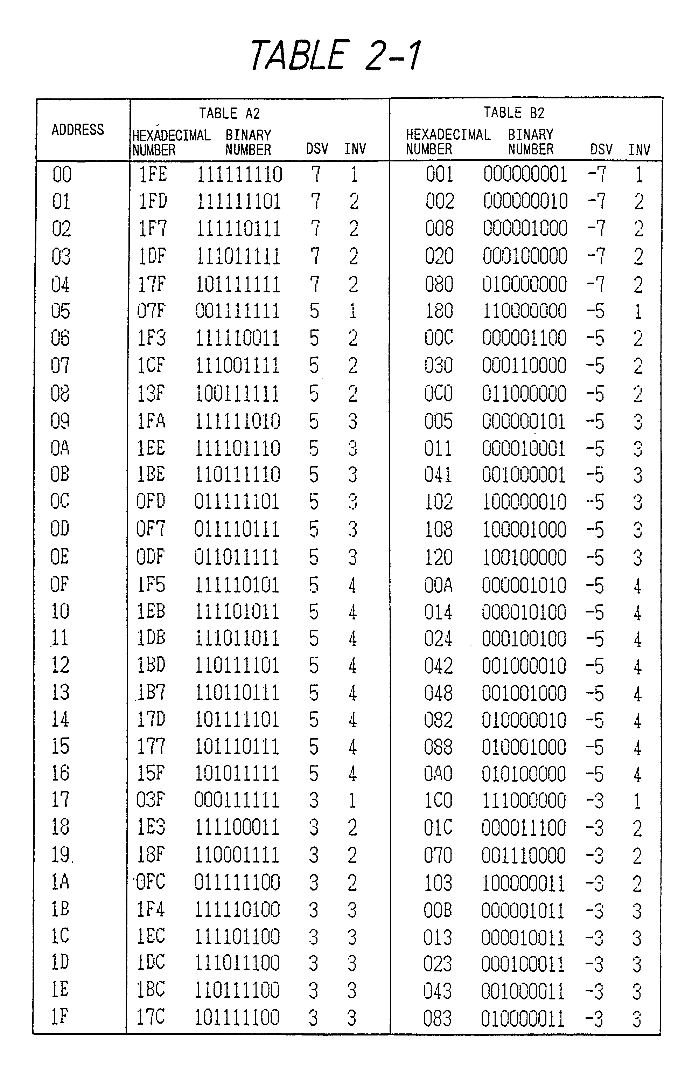

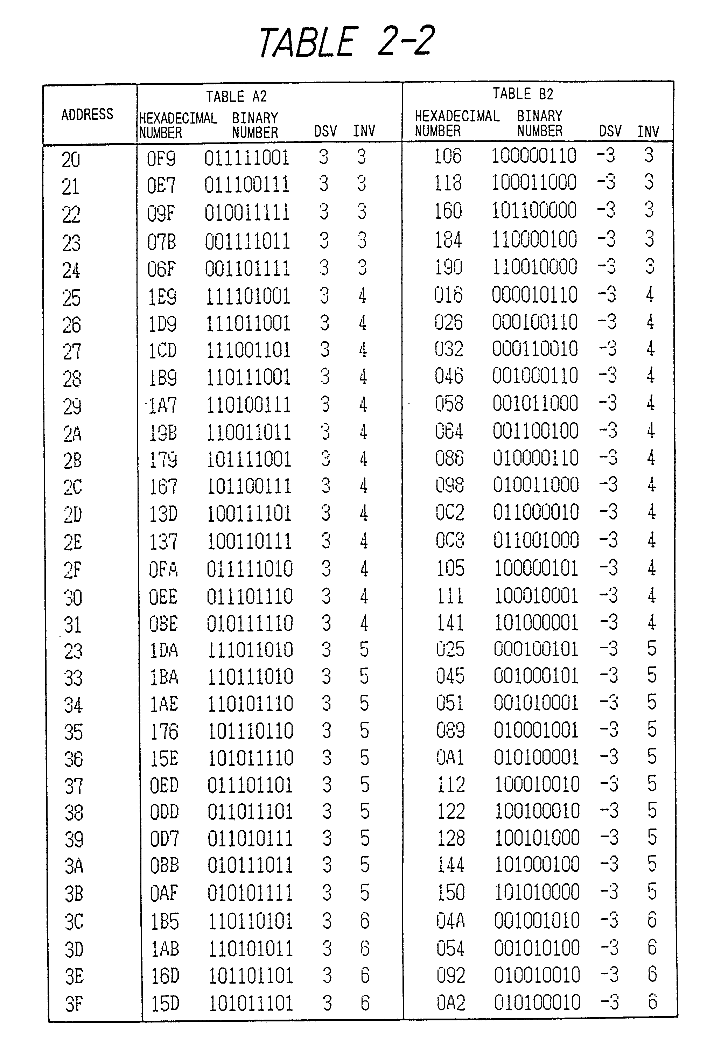

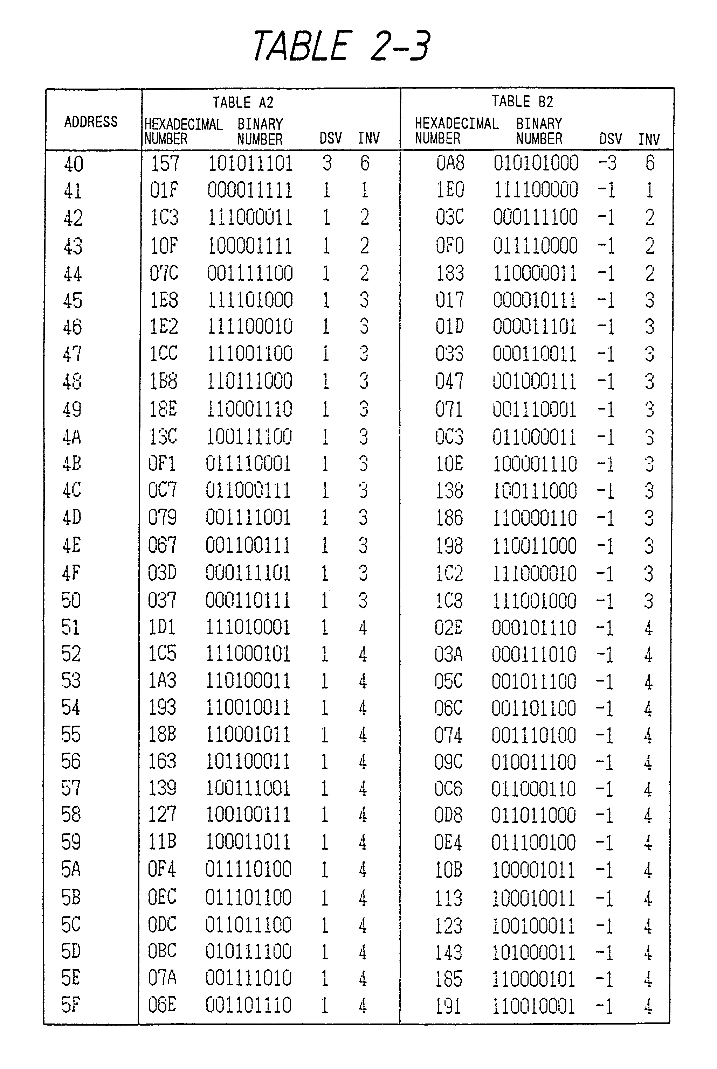

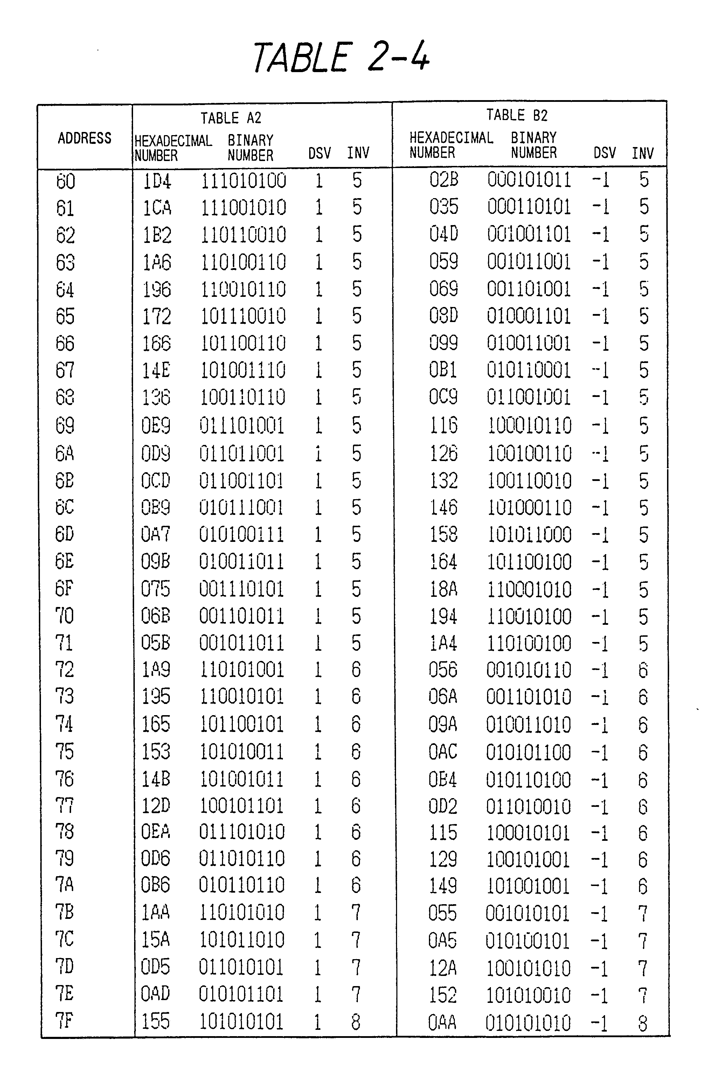

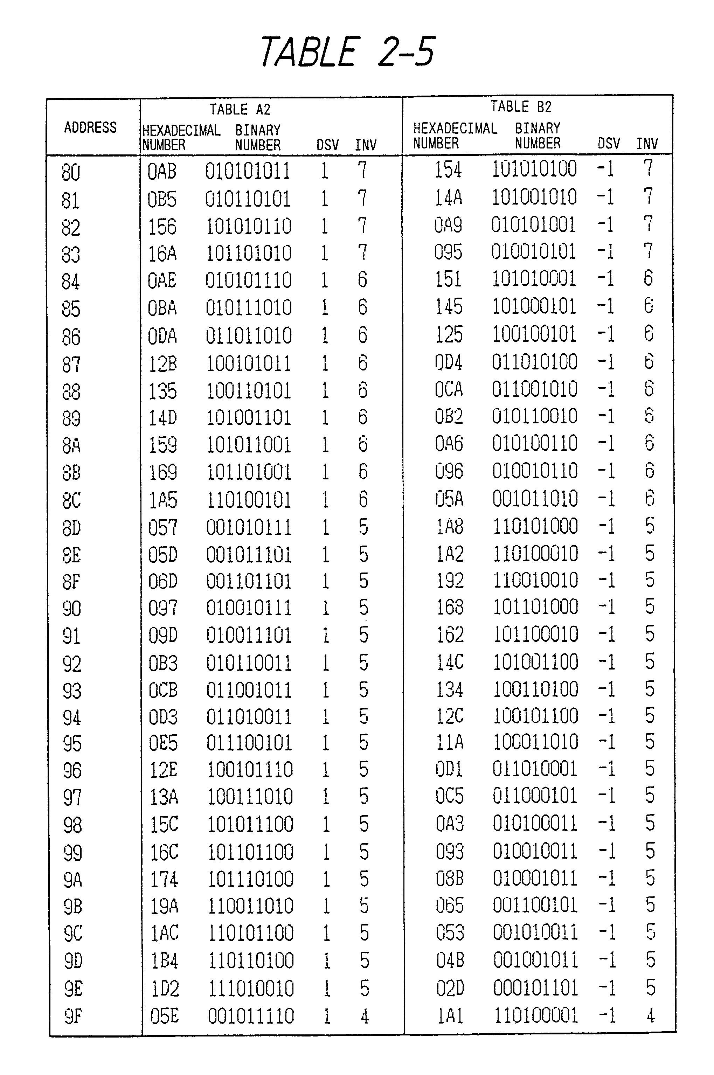

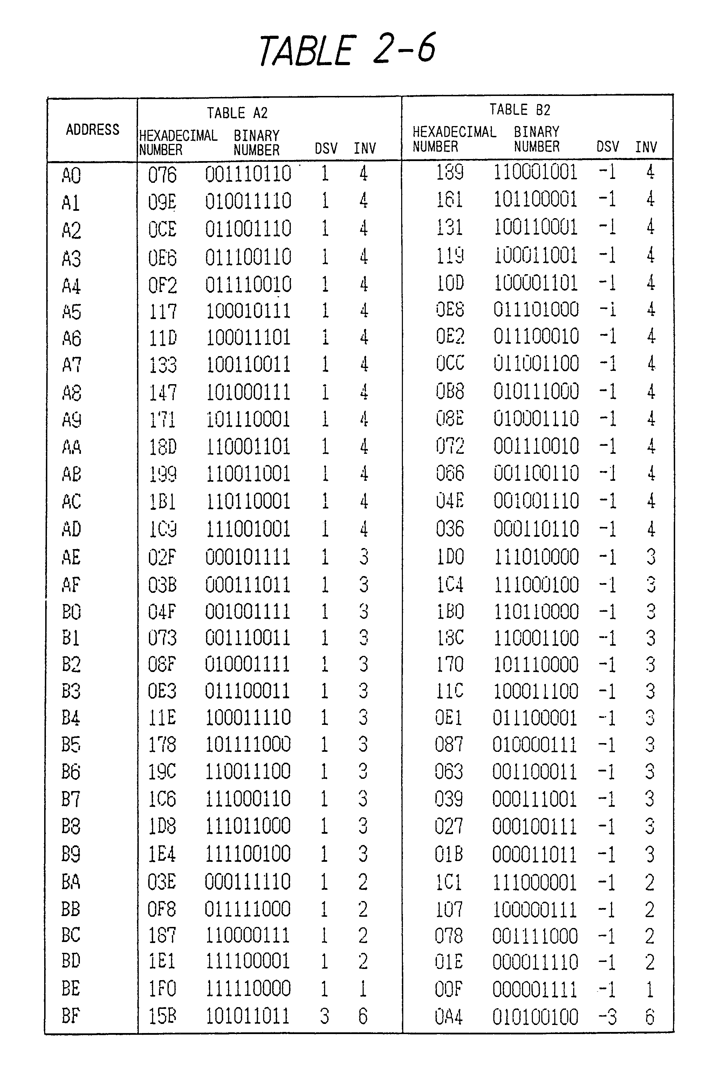

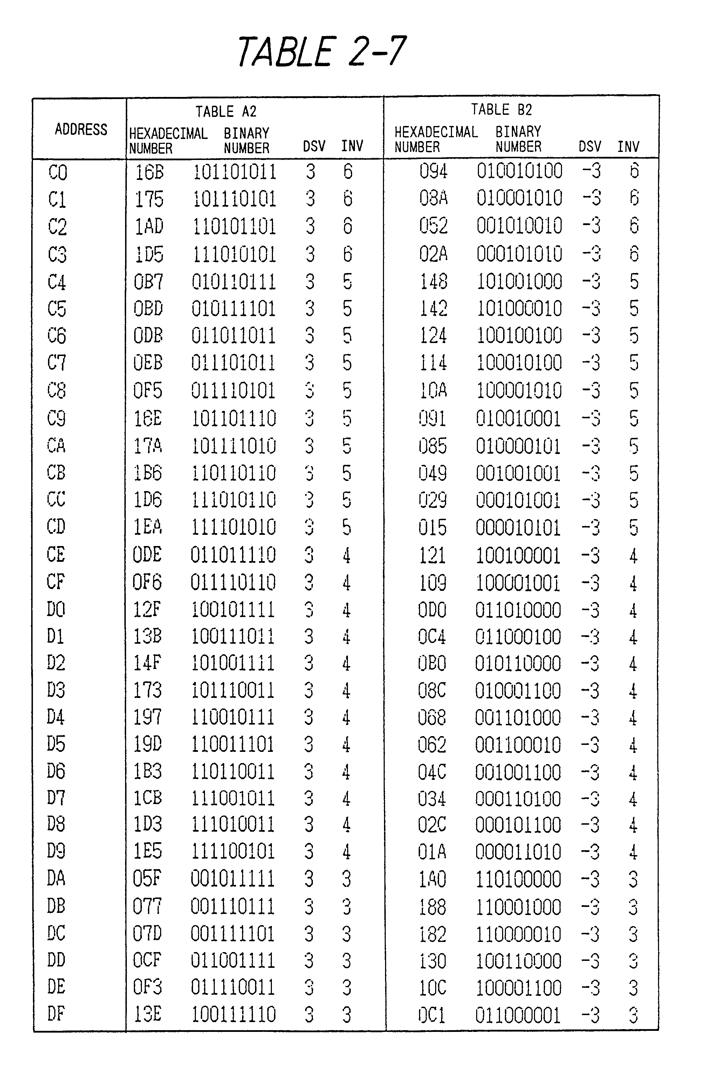

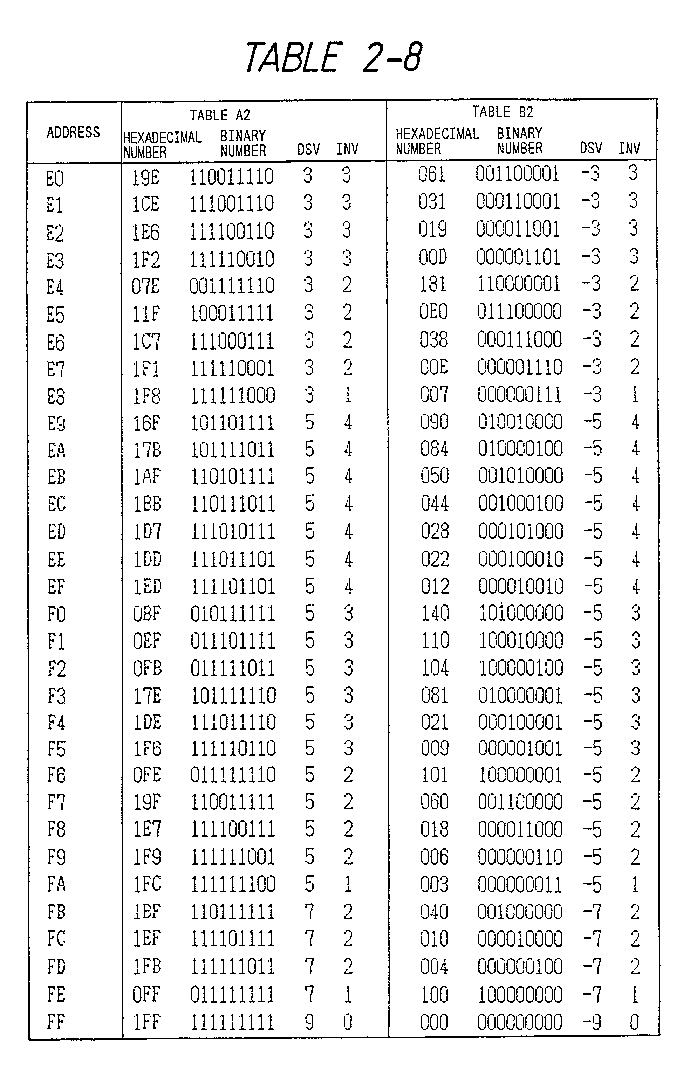

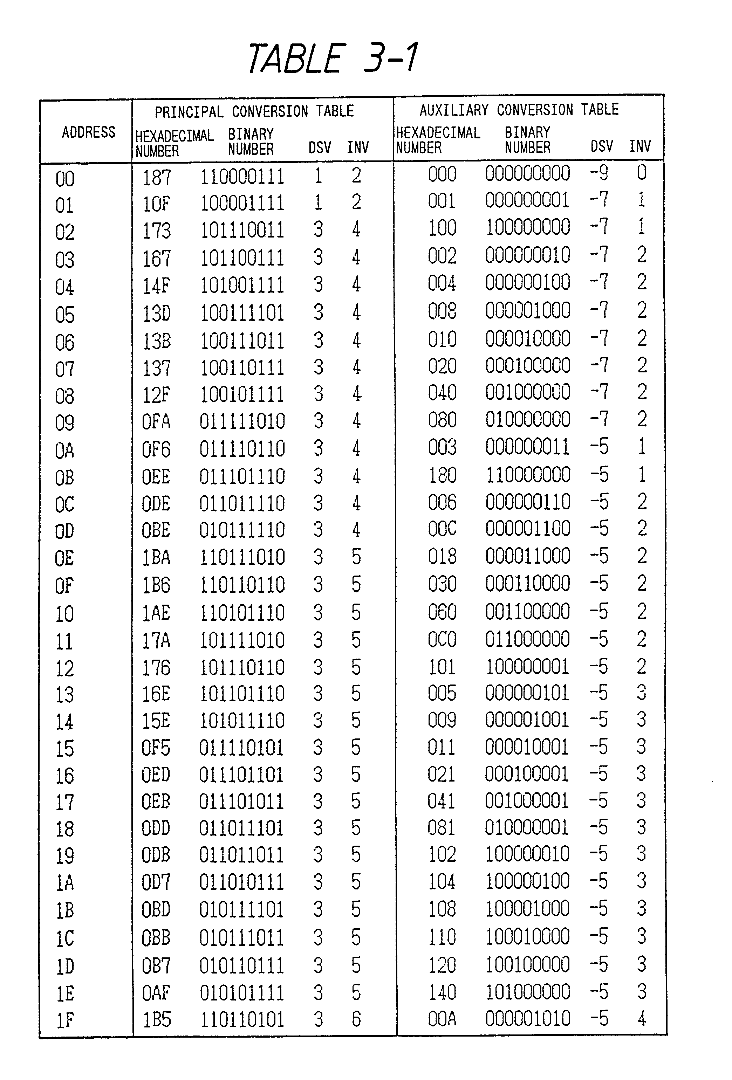

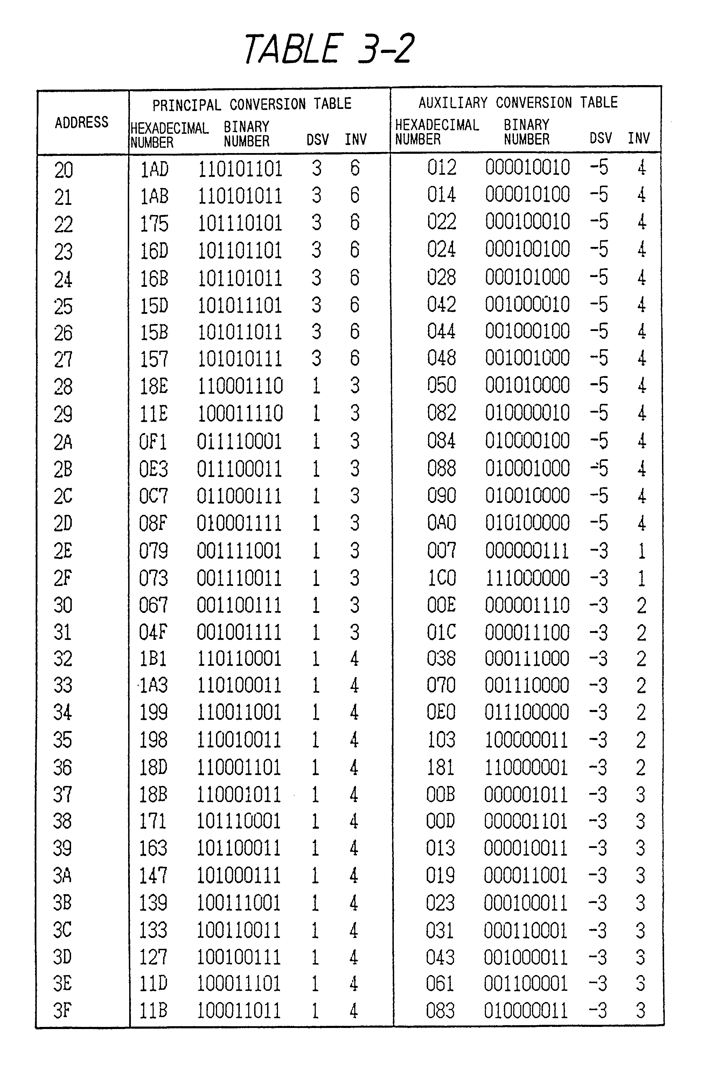

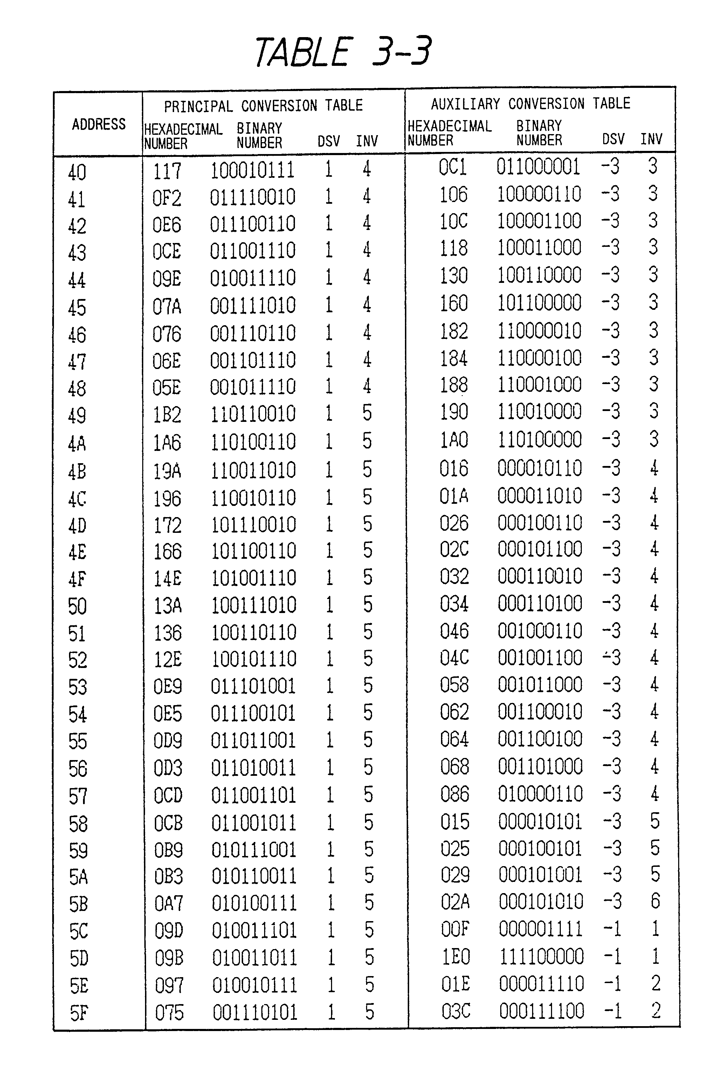

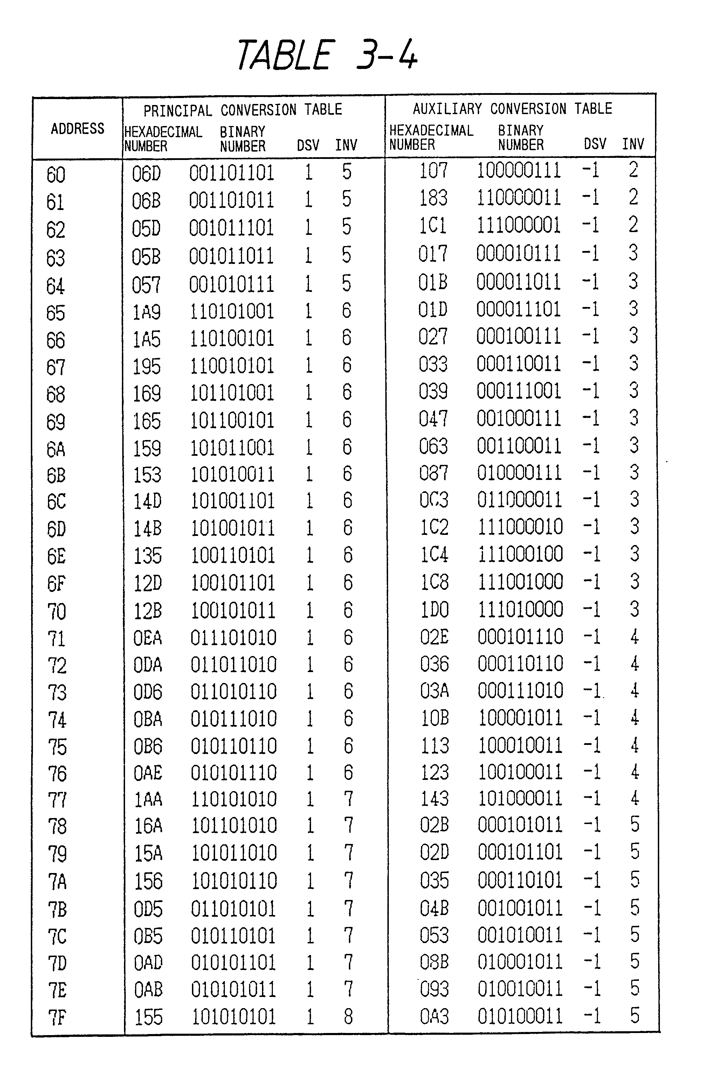

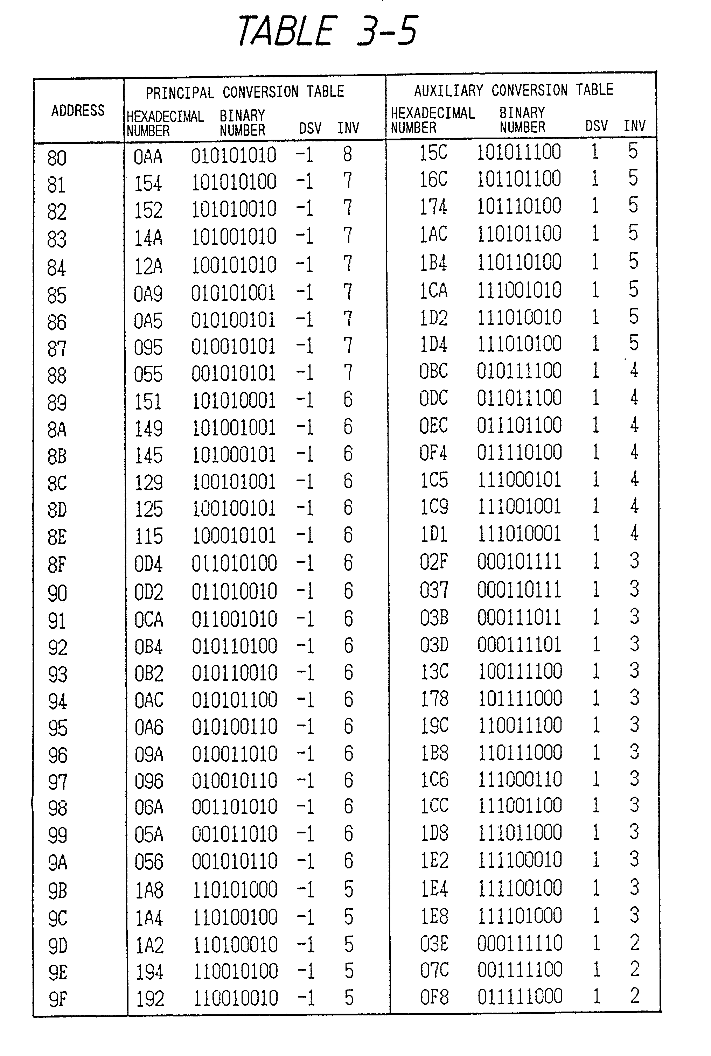

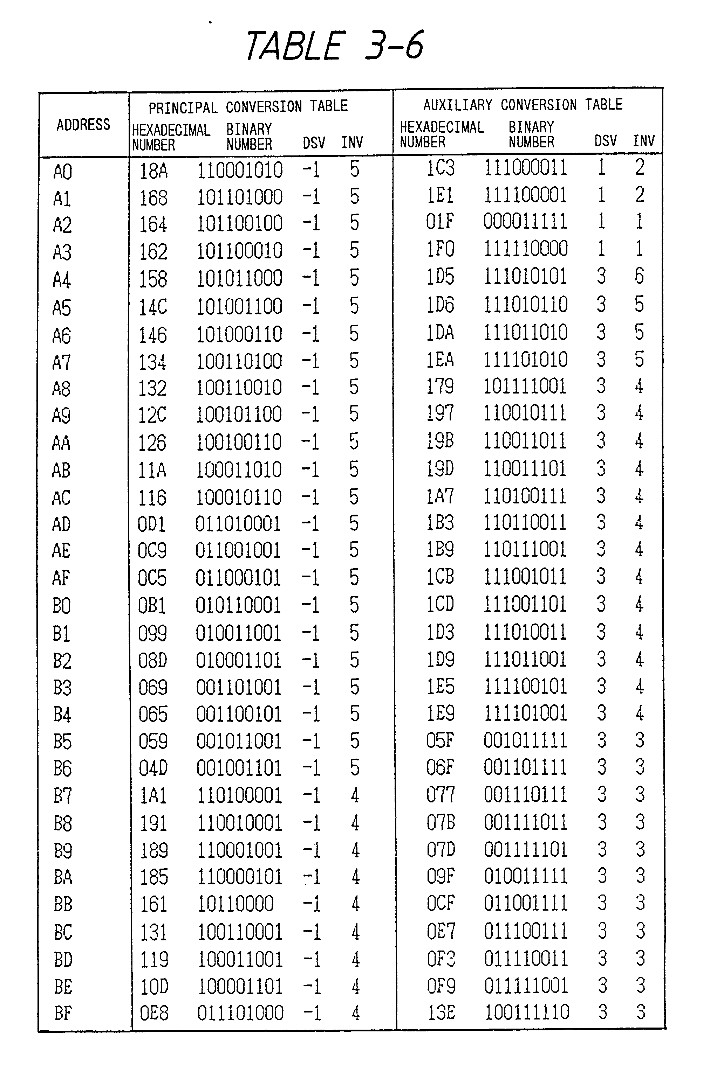

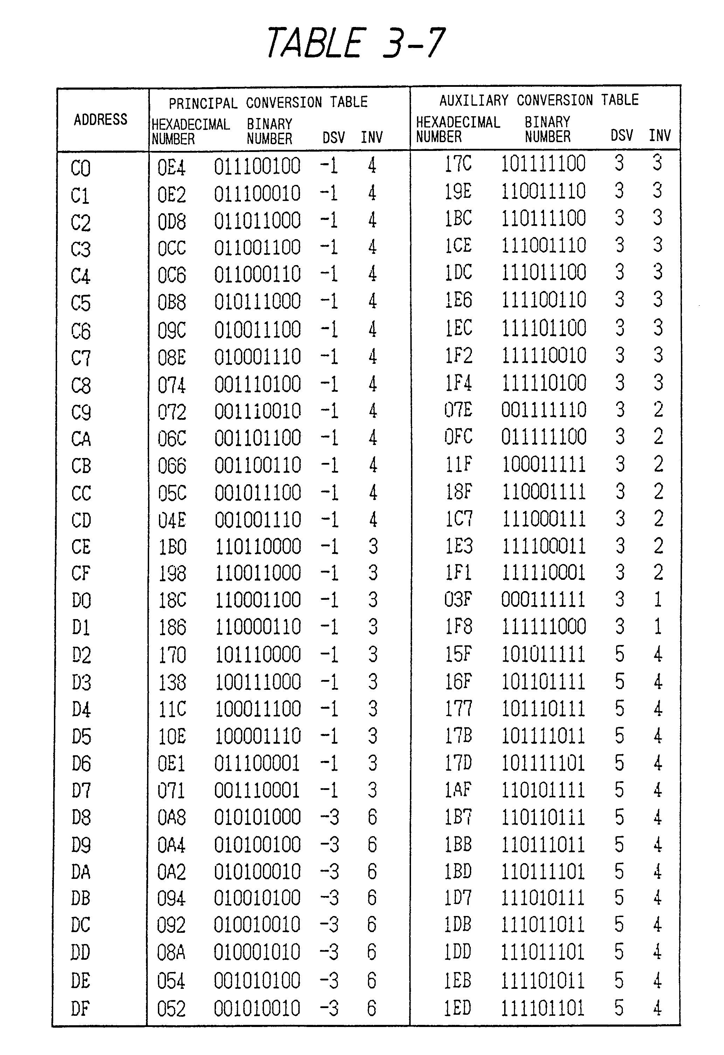

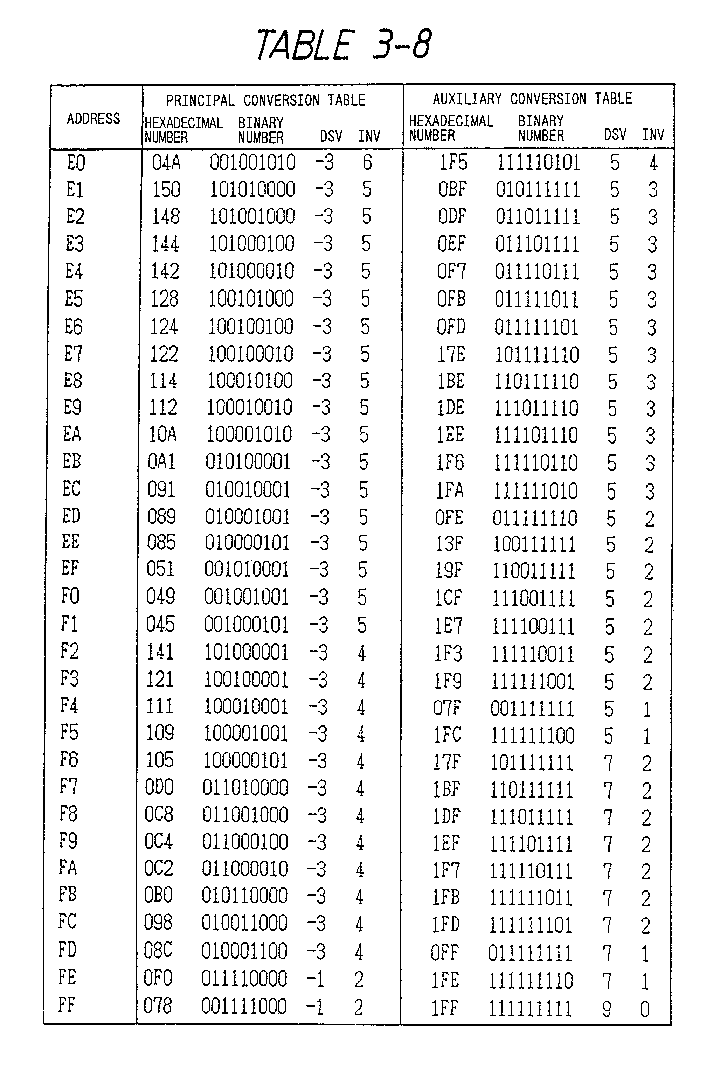

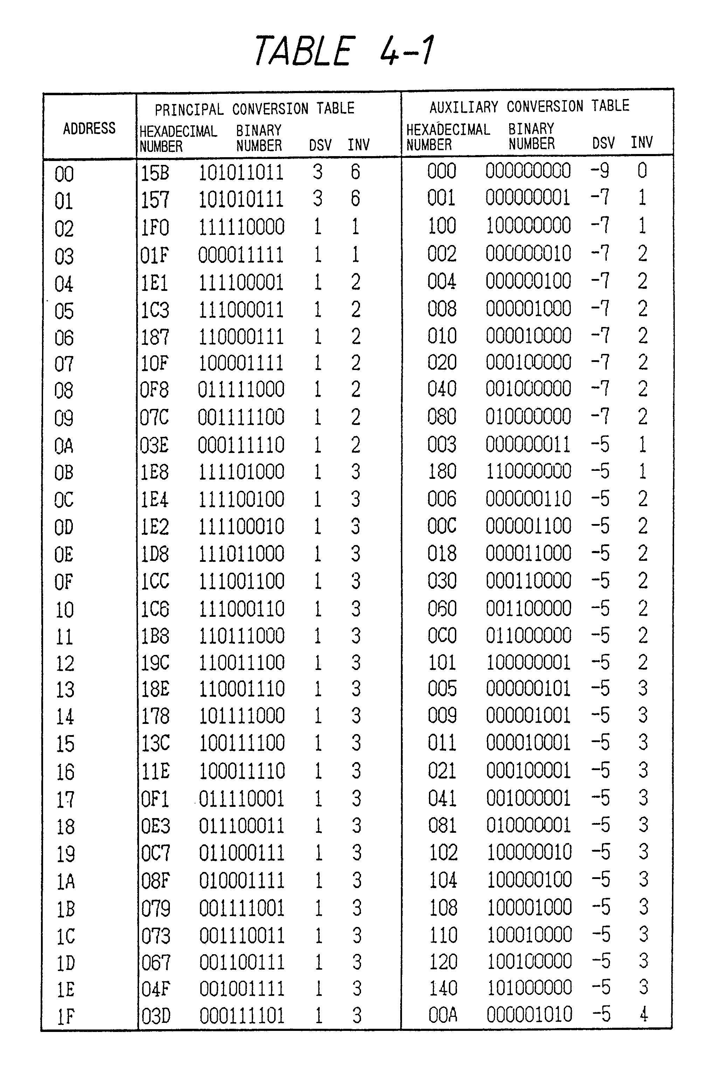

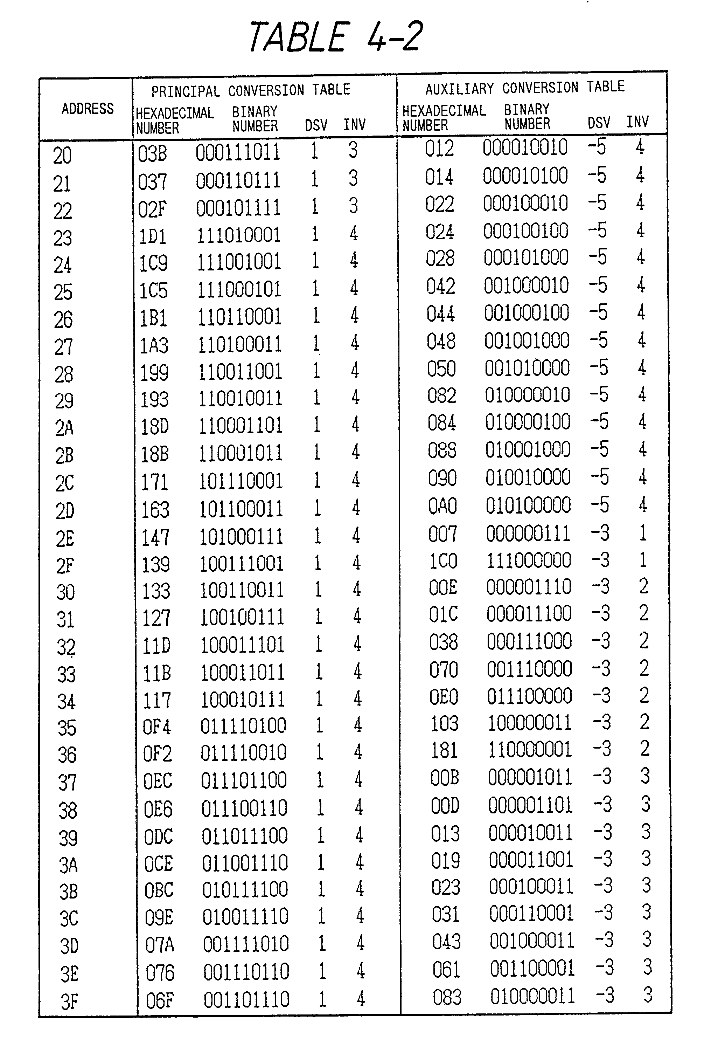

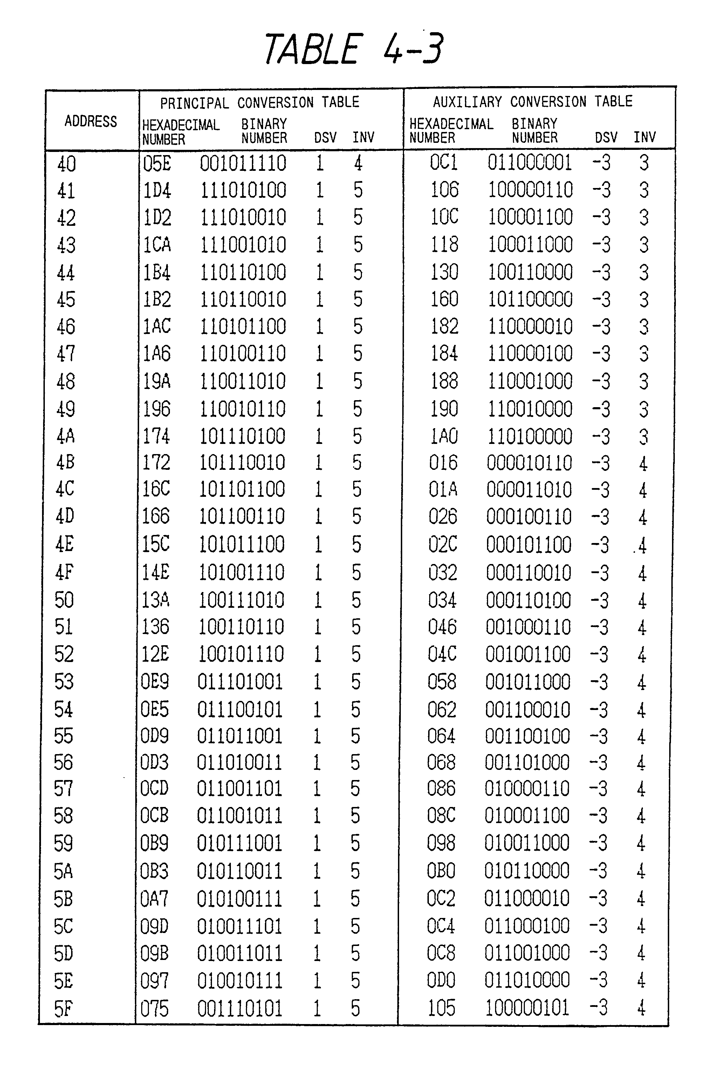

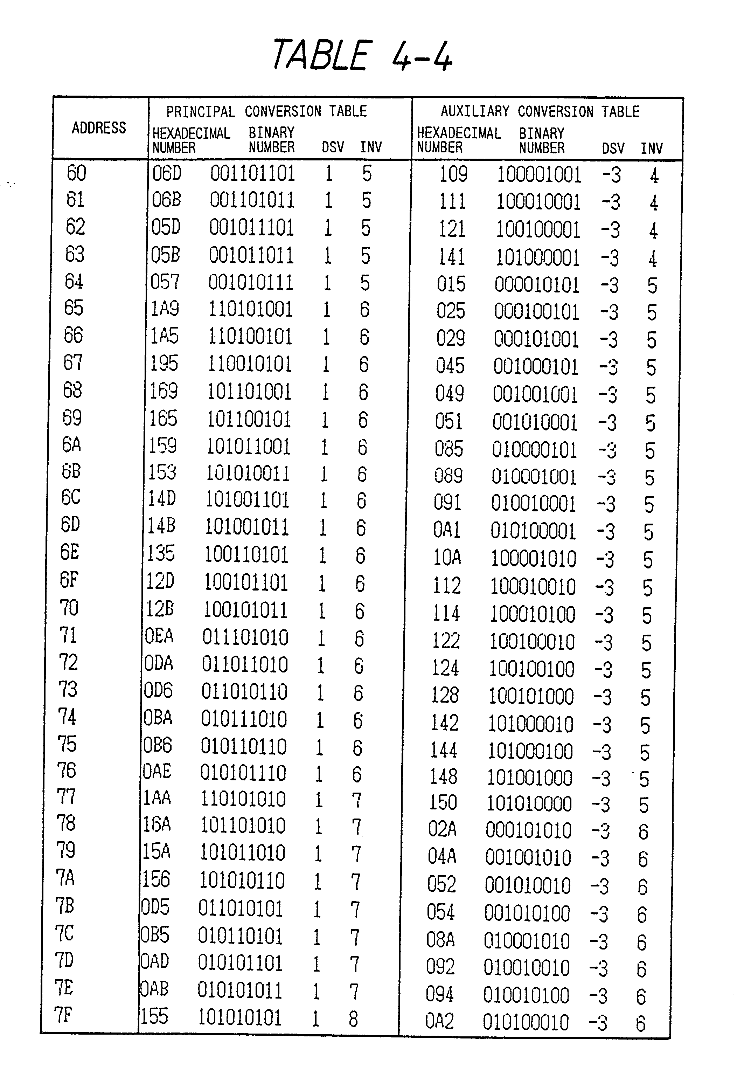

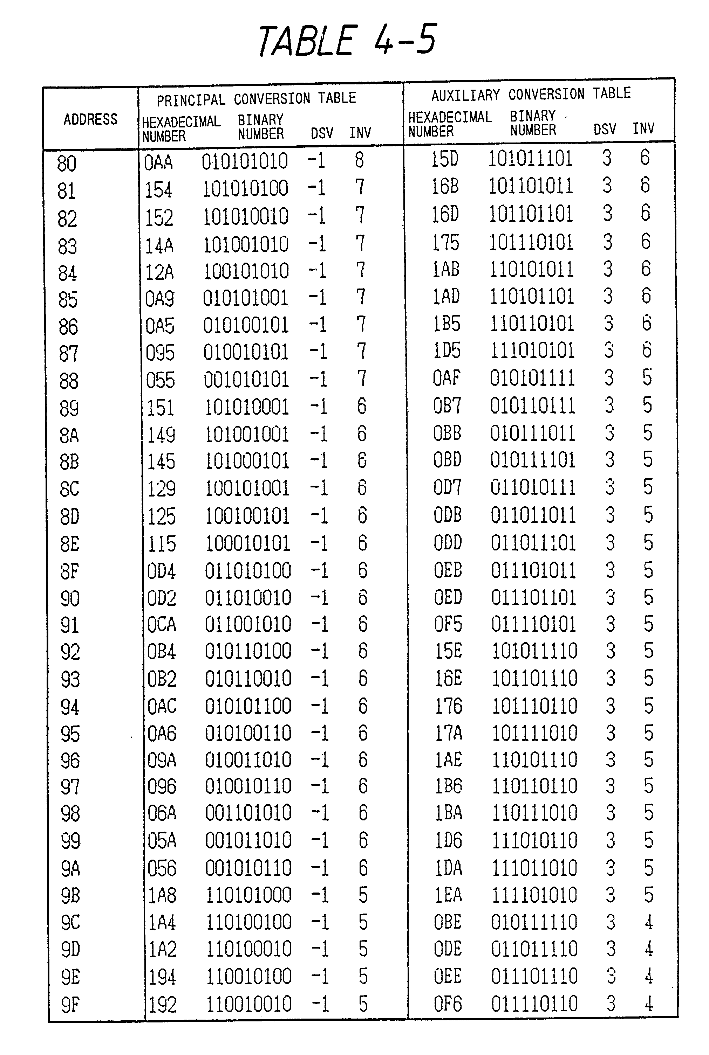

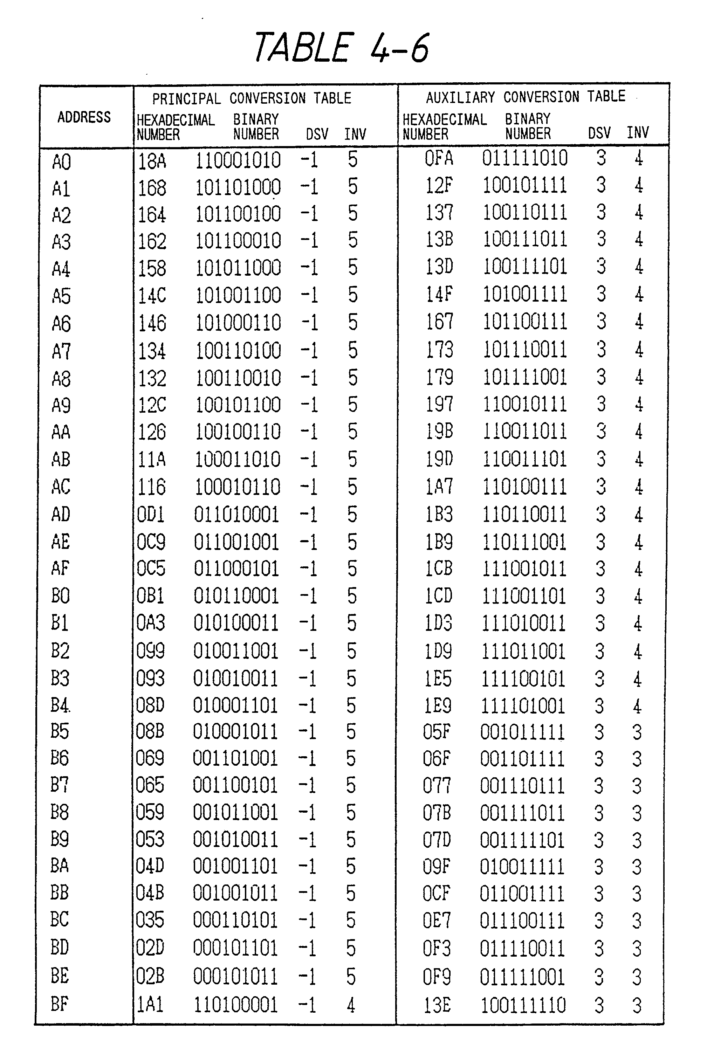

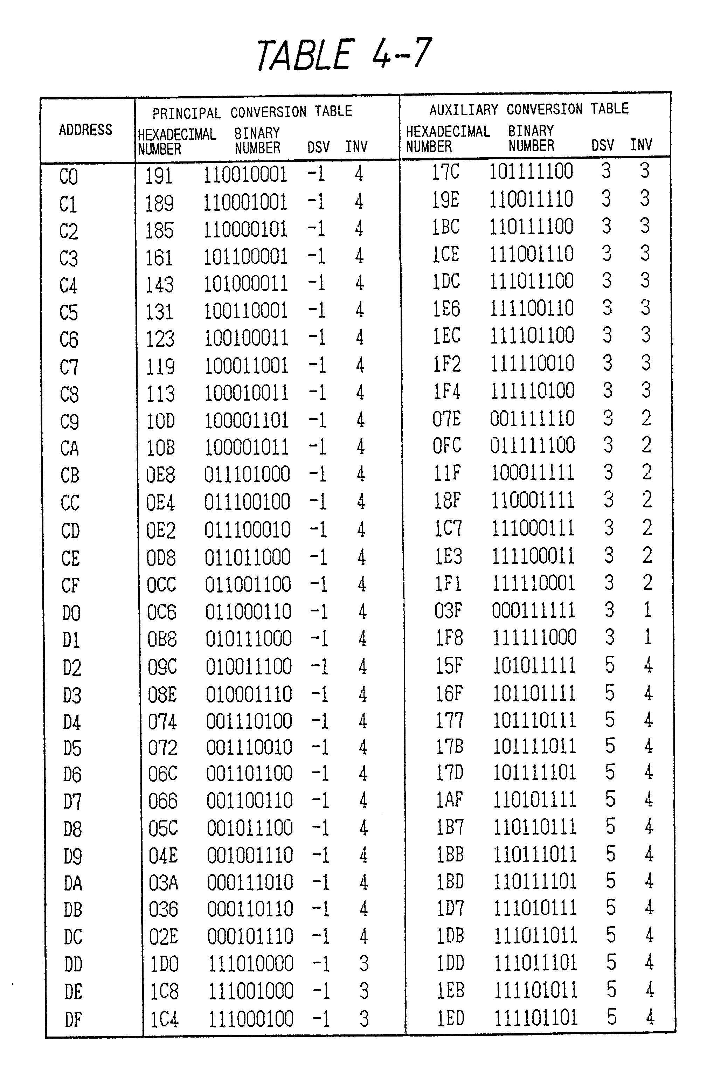

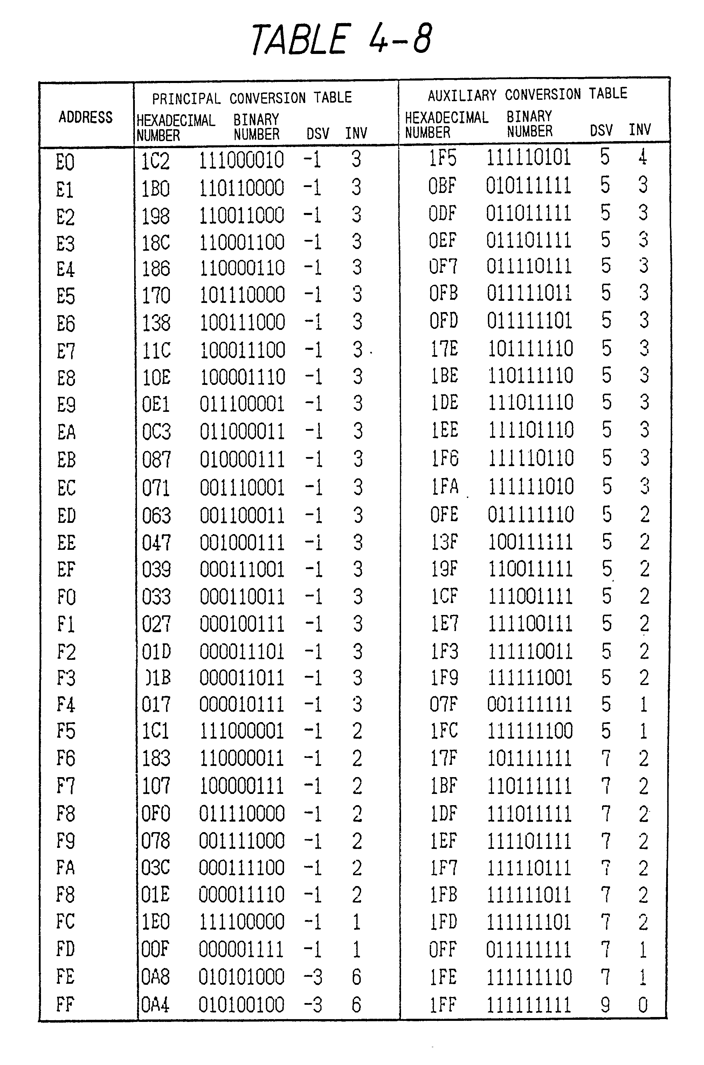

Fig. 4 is a circuit block diagram illustrating the third embodiment of the 8/9 encoder constructed by the application of the 8/9 code conversion method according to the fourth embodiment, and Table 4-1 through Table 4-8 are charts showing the conversion tables used for the code conversion performed with the 8/9 encoder illustrated in Fig. 4.

In Fig. 4, the 8/9 encoder 51 is used for the code conversion of 8-bit data into 9-bit data, and this encoder performs this code conversion in such a way that the integrated DSV values for the converted data converge on zero through differentiated utilization of a pair of conversion tables, i.e., the principal conversion table and the auxiliary conversion table, which are prepared in advance. The principal and auxiliary conversion tables are stored in the conversion ROM 53, which has 256 addresses from (00) H to (FF) H, which represent the 8-bit data in hexadecimal numbers. With the principal conversion table, the 8-bit data are converted into 9-bit data each having an absolute value not exceeding 3 for the DSV (or CDS) which indicates the direct current balance for the individual data, and with the auxiliary conversion table, the 8-bit data are converted into those 9-bit data which have absolute values not less than 3 and have a DSV polarity reverse to that of the data converted with the principal conversion table mentioned above.

In the fourth embodiment of this invention, the principal conversion table sets the 9-bit data with their DSV having a value of + 3 or + 1 in correspondence to the 8-bit data in (00) H ~ (7F) H, but with the 8-bit data in (80) H ~ (FF) H, on the other hand, the same conversion table sets those 9-bit data having the DSV value of - 3 or -1. The auxiliary conversion table, moreover, sets those 9-bit data having the DSV of - 9, -7, -5, or -3 in correspondence to the 8-bit data in (00) H ~ (7F) H, but, on the other hand, sets the 9-bit data having the DSV of + 9, + 7, +5 or + 3 in correspondence to the 8-bit data in (80) H ~ (FF) H. The DSV for the 9-bit data obtained by the conversion is expressed in terms of the complements of 2, and such complements are stored within each of the tables in the form of 5-bit data placed on the higher-order side of the 9-bit data for their linkage with such data.

Here, the 8-bit data which are to be processed for conversion are first fed into the conversion ROM 53 by way of the D flip-flop circuit 52 in the initial stage. Then, after they are converted into 14-bit data in accordance with either one of the conversion tables, i.e., the principal one and the auxiliary one which are stored inside the conversion ROM 53, the nine lower-order bits and the five higher-order bits of the converted data are supplied respectively to the D flip-flop circuit 54 for output to external equipment and to the DSV integrating circuit 55. The DSV integrating circuit 55 is composed of an addition circuit 56, which renews the integrated DSV value by the addition of the DSV registered up to that time to the five higher-order bit output in the conversion ROM 53, and a D flip-flop circuit 57, which latches the output from this addition circuit 56. The output which is obtained from the D flip-flop circuit and indicates the integrated DSV value as of the present moment is taken as the input to which an addition is to be made in the addition circuit 56.

The integrated DSV value which is obtained from the addition circuit 56 is fed into the table selection circuit 58, where it is judged, by means of the comparator circuits 59 and 60 having comparison criteria respectively set at + 9 and -9, whether or not the integrated DSV value is within a certain range from - 9 to + 9 as established in advance. The results obtained from the comparison performing by this pair of comparator circuits 59 and 60 are transmitted into the D flip-flop circuit 62 by way of the OR gate circuit 61 placed in the subsequent position. The latched output from the D flip-flop circuit 62 is supplied to the table selection input terminal in the conversion ROM 53 by way of the inverter circuit 63 and the NOR gate circuit 64, and, in case the integrated DSV value is within the above-mentioned range from - 9 to + 9, the selection of the principal conversion table is executed with the latched output which is obtained at a low level from the D flip-flop circuit 62.

However, the NOR gate circuit 64, which takes the low-level output as the signal for selection of the principal conversion table, uses the output from the inverter circuit 63 as one part of the input into it while it takes as the other part of the input into it the output from the EXCLUSIVE-OR gate circuit 65, which takes the value derived from the exclusive-or operation of the highest-order bit of the input 8-bit data and the highest-order bit of the integrated DSV value obtained from the DSV integrating circuit 55. The EXCLUSIVE-OR gate circuit 65 is the circuit which is designed to furnish the information for the selection of the particular table which works to achieve the convergence of the integrated DSV value on zero in case the integrated DSV value exceeds the range + 9 which is established in advance. This process consists in selecting the proper table by the utilization of the point that the "0" or "1" in the highest-order bit of the input 8-bit data is in correspondence within the former half or the latter half of the selection table, i.e., the positive or negative polarity of the DSV for the output 9-bit data and that the "0" or "1" in the highest-order bit in the integrated DSV value is in correspondence with the positive or negative polarity of the integrated DSV value.

Now, suppose for the present that the data 00001010 have come transmitted in the form of 8-bit data when the integrated DSV value is 01001, i.e. + 9, for example. In this case, the code conversion with the principal conversion table is performed since the output from the NOR gate circuit 64 is at a low level, and the data 00001111000110, which corresponds to the address (10) H, is output. In this regard, the five higher-order bits, 00001, in the output data in this instance express the DSV + I of the 9-bit data, 111000110, and as a result of the addition of this DSV value to be integrated DSV value + 9 up to that time in the DSV integrating circuit 15, the integrated DSV value changes to + 10.

Then, suppose that (5D) H has come transmitted as the input 8-bit data. In this case, one of the inputs into the NOR gate circuit 64 will be at a low level because the output from the OR gate circuit 61 was already changed to assume a high level at the point in time when the integrated DSV value exceeded + 9. On the other hand, the output from the EXCLUSIVE-OR gate 65, which provides the other input into the NOR gate 64, still remains at a low level, and the output from the NOR gate 64 shifts to a high level, by which the use of the auxiliary conversion table is instructed. Consequently, the 9-bit data 011001000 with the DSV at -3 is selected, eventually pulling back the integrated DSV value towards the zero side to assume the value of + 7. In any case in which (80) H through (FF) H is supplied in place of the input 8-bit data (5D) H, the code conversion is performed with the principal conversion table by the effect of the low-level output from the NOR gate circuit 64 since the output from the EXCLUSIVE-OR gate 65 assumes a high level then.

The 8-bit data which thus come transmitted one after another are processed for their code-conversion in such a manner that their integrated DSV values converge on zero, in which process the bit interval for the 9-bit data, i.e. the minimum code reversal interval, T min, is expressed by 8/9 T ( = 0.89 T), in relationship to the bit interval, T, for the 8-bit data. In this regard, the maximum code reversal interval, T max., which is considered to be so much better if it is as small as possible, will be 18 T min ( = 16 T), which represents the duration in which 18 "0"'s occur in succession, which is to be expected on the assumption of the worst case in which the 9-bit data occur in the sequence, 111110000, 000000000, 000001111.

As described hereinabove, the 8/9 encoder 51 is provided with a principal conversion table which performs the conversion of one 8-bit data into the 9-bit data with an absolute DSV value of 3 or less, which indicates the direct current balance of the individual data, and with an auxiliary conversion table which performs the conversion of such 8-bit data into the 9-bit data with an absolute DSV value of 3 or more and with a DSV polarity reverse to that of the data as converted with the principal conversion table mentioned above. This encoder performs the code conversion in accordance with the principal conversion table in case the integrated DSV value, which is renewed at each time of such conversion, is within a certain range, i.e. ± 9, established in advance, whereas when the integrated DSV value deviates from the range of ± 9, it performs the code conversion with either one of the principal conversion table or the auxiliary conversion table, as appropriate, in such a manner that the integrated DSV value converges on zero. Due to this construction, this encoder is capable of establishing ± 12, which is obtained by adding ± 3 to the limits ± 9 for the integrated DSV values which require the use of the principal conversion table, as the maximum limits for the direct current component in the converted data, wherein regarding the maximum code reversal interval, this encoder is capable of placing restraint on the limits in a value equivalent to 16 times that of the bit interval, T, since the limit value will occur in a case where bits of the same kind appear in a sequence consisting of 18 bits. Due to this feature, the encoder can place restraint on the maximum frequency for recording.

Moreover, the 8/9 encoder 51 can be applied adequately for the development of a PLA, as well as the simplification of the circuitry as a whole, through effective utilization of a small-scale ROM because the encoder can generate 9-bit data satisfying the RLLC (Run Length Limited Code) Rules with its capabilities of achieving the minimum code reversal interval, T min, at 0.89 T, the maximum code reversal interval, T min, at 16 T, and the detection port width, Tw, at 0.89 T, with a pair of conversion tables comprising the principal table and the auxiliary table which are accommodated in the conversion ROM 53 having 256 addresses, using the addition of a DSV integrating circuit 55, which is necessary for reading the 9-bit data out of the conversion ROM 53. In the fourth embodiment of this invention described above, the comparison criteria to be set, in respect of the integrated DSV values, in the comparator circuits 59 and 60 in the table selection circuit 58 may be a value other than ± 9.

With the embodiments according to this invention constructed as described above, it is possible to produce the following effects. It is possible to cancel the direct current component while maintaining the integrated DSV values within a certain range of limits, and it is also possible readily to generate such highly efficient codes that the minimum code reversal interval and the maximum code reversal interval for the signal waveforms after conversion satisfy the RLLC Rules. Besides, it is sufficient to provide two types of such conversion tables for 8-bit data, and it is therefore possible to read the pertinent 9-bit data with 256 addresses, by which it is possible for this encoder to develop a PLA through effective utilization of the features characteristic of a small-scale ROM.

This system also is capable of converting those 8-bit data with higher frequencies of occurrence into 9-bit data with proportionately smaller absolute DSV values, and in addition, since it is capable of performing the selection of tables in a manner designed to serve the purpose of attaining the convergence of the DSV values on zero, it is possible for the system to place the maximum restraint possible on the fluctuations of the direct current component while placing restrictions on the integrated DSV values of the 9-bit data obtained by the code conversion for confining such values within a certain range of limits.

Furthermore, with the integrated DSV values for the 9-bit data confined within a fixed range of limits, it is possible for the system to place restraints on the fluctuations of the direct current component, and particularly the maximum code reversal interval, which occurs at the time when bits of the same kind appear consecutively in a sequence of 12 bits of the same kind. The system can therefore place restraint on the maximum reversal interval at a value approximately 10.7 times as much as the bit interval for the 8-bit data, by which it is possible to place restraint on the maximum frequency for recording. The system is also capable of generating such 9-bit data as will satisfy the RLLC Rules with the minimum code reversal interval and the maximum code reversal interval which can be achieved by the addition of a DSV integrating circuit and a table selection circuit which are necessary to perform the reading of the 9-bit data with a pair of conversion tables comprising a principal one and an auxiliary one which are stored in the conversion ROM having 256 addresses set in it.

It is further possible with such embodiments to apply the value ± (N + 12) obtained by the addition of ± 3 to ± N, which marks the limits for the integrated DSV value which requires the use of the principal conversion table, to the setting of the maximum limits to the direct current component in the converted data, and with regard to the maximum code reversal interval, which can be so designed as to occur when bits of the same kind occur in a consecutive series of 18 bits, it is possible to hold down the interval to a value 16 times as much as the bit interval for the 8-bit data. It is thus possible to place restraint on the maximum frequency for recording. Also, in the conversion ROM which has 256 addresses set in it, a pair of conversion tables comprising a principal one and an auxiliary one can be accommodated, but with the addition of a DSV integrating circuit and a table selection circuit which are necessary for reading the 9-bit data, it is possible to obtain the 9-bit data which have a minimum code reversal interval and a maximum code reversal interval which satisfy the RLLC Rules.

Although a few exemplary embodiments have been discussed in detail above, one of ordinary skill in the art will realize that other similar embodiments are possible within the scope of the invention identified by the following claims.

Claims

1. An 8/9 code conversion system for performing the code conversion of 8-bit data into 9-bit data, comprising the steps of:
providing a pair of conversion tables which are differentiated by the distinction whether a digital sum variation (DSV) value, which indicates a direct current balance of the 9-bit data after the code conversion, is positive or negative in polarity;
integrating the DSV value;
selecting an appropriate conversion table of said pair of conversion tables in accordance with the positive or negative polarity of the integrated DSV value, said DSV value being updated at the time of each conversion; and
performing code conversion using said appropriate conversion table in such a manner as to make the integrated DSV value converge on zero.

2. An 8/9 code conversion system for performing code conversion of 8-bit data into 9-bit data, comprising the steps of:
differentiating the 9-bit data after code conversion in accordance with the distinction whether a digital sum variation (DSV) value, which indicates a direct current balance of said 9-bit converted data, is positive or negative in polarity;
providing conversion tables which set the converted 9-bit data respectively in correspondence to the 8-bit data in an order starting with the smallest of the absolute DSV values in an arrangement thereof centering around a value between a maximum value and a minimum value for the 8-bit data;
integrating the DSV value; and
performing code conversion using said conversion tables, with one conversion table being selected out of said conversion tables in such a manner as to make the integrated DSV value, which is updated at the time of each conversion, converge on zero.

3. An 8/9 code conversion system for performing the code conversion of 8-bit data into 9-bit data, comprising the steps of:
providing a principal conversion table and an auxiliary conversion table which set mutually different 9-bit data in correspondence with input 8-bit data;
integrating a digital sum variation (DSV) value of said 9-bit data;
performing code conversion in accordance with the principal conversion table when the integrated DSV value, which is updated at the time of each conversion, is within a predetermined range, but performing code conversion in accordance with either of an appropriate conversion table selected from the tables comprising the principal conversion table and the auxiliary conversion table in such a manner as to make the integrated DSV value converge on zero; and

giving priority during code conversion to the condition that 13 bits or more of the same polarity of bits should not be allowed to occur in succession when the integrated DSV value deviates from within said predetermined range.

4. An 8/9 code conversion system for performing the code conversion of 8-bit data into 9-bit data, comprising the steps of:
providing a principal conversion table which converts 8-bit into 9-bit data with an absolute value of its digital sum variation (DSV) value not exceeding 3, said DSV value indicating the direct current balance of the 9-bit data, and an auxiliary conversion table which converts the 8- bit data into 9-bit data having an absolute DSV value of not less than 3 and having a DSV polarity reverse to that of the data of said principal conversion table;
integrating the DSV value of said 9-bit data;
performing code conversion in accordance with the principal conversion table in case the integrated DSV value, which is updated at the time of each conversion, is within a predetermined range, but performing code conversion in accordance with an appropriate table selected from the principal conversion table and the auxiliary conversion table in such a manner as to make the integrated DSV value converge on zero when the integrated DSV value deviates from within said predetermined range.

5. An 8/9 converter for performing a code conversion of 8 -bit data into 9-bit data, comprising means for providing a pair of conversion tables (A1,B1) which are differentiated by the distinction whether a digital sum variation (DSV) value, which indicates a direct current balance of the 9-bit data after the code conversion, is positive or negative in polarity;
means (15) for integrating the DSV value;
means for selecting an appropriate conversion table of said pair of conversion tables (A1, B1) in accordance with the positive or negative polarity of the integrated DSV value, means for updating said DSV value at the time of each conversion; and
means (13) for performing a code conversion using said appropriate conversion table in such a manner as to make the integrating DSV value converge on zero.

6. An 8/9 converter for performing code conversion of 8-bit data into 9-bit data, comprising:
means for differentiating the 9-bit data after code conversion in accordance with the distinction whether a digital sum variation (DSV) value, which indicates a direct current balance of said 9-bit converted data, is positive or negative in polarity;
means for providing conversion tables (A2, B2) which set the converted 9-bit data respectively in correspondence to the 8-bit data in an order starting with the smallest of the absolute DSV values in an arrangement thereof centering around a value between a maximum value and a minimum value for the 8-bit data;

means (15) for integrating the DSV value; and

means (13) for performing code conversion using said conversion tables, with one conversion table being selected out of said conversion tables (A2, B2) in such a manner as to make the integrated DSV value, which is updated at the time of each conversion, converge on zero.

7. The 8/9 converter (11) of claim 5 or 6 comprising a conversion ROM (13) into which the 8-bit data are fed, in which the conversion tables (A1,B1; A2,B2) are provided and the data are converted into 14-bit data in accordance with either one of the conversion tables (A1,B1; A2,B2), and

means for dividing the 14-bit data into two groups, these groups of bits being respectively fed into an output circuit (14) for output to external equipment and into a DSV integrating circuit (15) for internal feedback in the system.

8. The 8/9 converter of claim 7, in which the DSV integrating circuit (15) is composed of an integrating circuit (16), which renews the integrated DSV value with the addition of the DSV up to that point in time to the output of the five higher-order bits from the conversion ROM (13) and a D flip-flop circuit (17) which latches the output from this integrating circuit (16), the highest-order bit in the output from the D flip-flop circuit (17) being fed into a polarity reversing circuit (18) as the data for the selection of the proper conversion table.

9. The converter of claim 7 or 8 in which the conversion tables A1 and B1 (Table 1-1 to 1-8) are used.

10. The converter of claim 7 or 8 in which the conversion tables A2 and B2 (Table 2-1 to 2-8) are used.

11. An 8/9 converter (21) for performing a code conversion of 8-bit data into 9-bit data, comprisng:

means (23) for providing a principal conversion table and an auxiliary conversion table which set mutually different 9-bit data in correspondence with input 8-bit data,

means (25) for integrating a digital sum variation (DSV) value of said 9-bit data;

means (23,26) for performing code conversion in accordance with the principal conversion table when the integrated DSV value, which is updated at the time of each conversion, is within a predetermined range, but performing code conversion in accordance with either of an appropriate conversion table selected from the tables comprising the principal conversion table and the auxiliary conversion table in such a manner as to make the integrated DSV value converge on zero whereby priority is given during code conversion to the condition that 13 bits or more of the same polarity of bits should not be allowed to occur in succession when the integrated DSV value deviates from within said predetermined range.

12. The 8/9 converter (21) of claim 11, comprising means (22) for transmitting the 8-bit data into a conversion ROM (23) which stores in its memory a principal conversion table and an auxiliary conversion table, and after the 8-bit data are converted into 24-bit data in accordance with either one of the conversion tables in the conversion ROM (23), the nine bits in the lower-order positions and the five bits in the higher-order positions as well as the two bits in the lower-order positions are respectively fed into an output circuit (24) for output to external equipment and into a DSV integrating circuit 25 and the table-selecting circuit (26).

13. The 8/9 converter of claim 12, in which the DSV-integrating circuit (25) is composed of an adding circuit (27), which effects the renewal of the integrated DSV value by the addition of the DSV on record up to that point in time to the output on the five higher-order bits from the conversion ROM (23) and a D flip-flop circuit (28), which latches the output from the adding circuit (27), the output of which is taken as the input into the adding circuit (27),

the integrated DSV value obtained from the adding circuit (27) being fed into comparator circuits (29) and (30) provided in table-selecting circuit (26).

14. The 8/9 converter of claim 12 or 13 in which the conversion tables 3-1 through 3-8 are used.

15. An 8/9 converter (51) for performing a code conversion of 8-bit data into 9-bit data, comprising

means (53) for providing a principal conversion table which converts 8-bit into 9-bit data with an absolute value of its digital sum variation (DSV) value not exceeding 3, said DSV value indicating the direct current balance of the 9-bit data, and an auxiliary conversion table which converts the 8-bit data into 9-bit data having an absolute DSV value of not less than 3 and having a DSV polarity reverse to that of the data of said principal conversion table;

means (55) for integrating the DSV value of said 9-bit data; and

means (53,58) for performing code conversion in accordance with the principal conversion table in case the integrated DSV value, which is updated at the time of each conversion, is within a predetermined range, but performing code conversion in accordance with an appropriate table selected from the principal conversion table and the auxiliary conversion table in such a manner as to make the integrated DSV value converge on zero when the integrated DSV value deviates from within said predetermined range.

16. The converter (51) of claim 15, for conversion of 8-bit data into 9-bit data, comprising a principal conversion table and an auxiliary conversion table, which are prepared in advance, and are stored in a conversion ROM (53), the 8-bit data which are to be processed for conversion being converted into 14-bit data in accordance with either one of the conversion tables, the nine lower-order bits and the five higher-order bits of the converted data are supplied respectively to an output circuit (54) for output to external equipment and to a DSV integrating circuit (55).

17. The 8/9 converter of claim 16 in which the DSV integrating circuit (55) is composed of an addition circuit (56) which renews the integrated DSV value by the addition of the DSV registered up to that time to the five higher-order bit output in the conversion ROM (53), and a D flip-flop circuit (57) which latches the output from this addition circuit (56),the integrated DSV value obtained from the addition circuit (56) being fed into a table selection circuit (58) which ends in a table selection input terminal in the conversion ROM (53).

18. The 8/9 converter of claim 16 or 17 in which the conversion Tables (4-1 to 4-8) are used.

## FIG. 1 PRIOR ART

## FIG. 2

# FIG. 3

<u>21</u>  8/9 ENCODER

# FIG. 4

51  8/9 ENCODER

TABLE SELECTION CKT

58

62 DFF

61

59 COMPARATOR CKT — A  +9 / B

A < B

A > B

60 COMPARATOR CKT — A  -9 / B

DSV INTEGRATING CKT

57 DFF

MSB 1

65

63

64

56 ADDITION CKT

5

5

55

52 DFF

MSB 1

53 CONVERSION ROM

MSB 5

54 DFF

LSB 9

8

8

9

BYTE CLOCK SIGNAL

TABLE 1-1

| ADDRESS | TABLE A1 | DSV | INV | TABLE B1 | DSV | INV |
|---|---|---|---|---|---|---|
| 0 0 | 1 1 1 1 1 1 1 0 | 7 | 1 | 0 0 0 0 0 0 0 1 | − 7 | 1 |
| 0 1 | 1 1 1 1 1 0 0 0 | 3 | 1 | 0 0 0 0 0 1 1 1 | − 3 | 1 |
| 0 2 | 0 1 1 1 1 1 1 1 | 7 | 1 | 1 0 0 0 0 0 0 0 | − 7 | 1 |
| 0 3 | 0 0 0 1 1 1 1 1 | 3 | 1 | 1 1 1 0 0 0 0 0 | − 3 | 1 |
| 0 4 | 1 1 1 1 1 1 0 1 | 7 | 2 | 0 0 0 0 0 0 1 0 | − 7 | 2 |
| 0 5 | 1 1 1 1 1 0 0 1 | 5 | 2 | 0 0 0 0 0 1 1 0 | − 5 | 2 |
| 0 6 | 1 1 1 1 0 0 1 1 | 5 | 2 | 0 0 0 0 1 1 0 0 | − 5 | 2 |
| 0 7 | 1 1 1 0 1 1 1 1 | 7 | 2 | 0 0 0 0 1 0 0 0 | − 7 | 2 |
| 0 8 | 1 1 1 1 0 0 0 1 1 | 3 | 2 | 0 0 0 0 1 1 1 0 0 | − 3 | 2 |
| 0 9 | 1 1 1 0 1 1 1 1 | 7 | 2 | 0 0 0 1 0 0 0 0 | − 7 | 2 |
| 0 A | 1 1 1 0 0 0 1 1 | 3 | 2 | 0 0 0 1 1 1 0 0 | − 3 | 2 |
| 0 B | 1 1 0 1 1 1 1 1 | 7 | 2 | 0 0 1 0 0 0 0 0 | − 7 | 2 |
| 0 C | 1 1 0 0 0 1 1 1 | 3 | 2 | 0 0 1 1 1 0 0 0 | − 3 | 2 |
| 0 D | 1 0 1 1 1 1 1 1 | 7 | 2 | 0 1 0 0 0 0 0 0 | − 7 | 2 |
| 0 E | 1 0 0 0 1 1 1 1 | 3 | 2 | 0 1 1 1 0 0 0 0 | − 3 | 2 |
| 0 F | 0 1 1 1 1 1 1 0 | 5 | 2 | 1 0 0 0 0 0 0 1 | − 5 | 2 |
| 1 0 | 0 1 1 1 1 0 0 0 | 1 | 2 | 1 0 0 0 0 1 1 1 | − 1 | 2 |
| 1 1 | 0 0 1 1 1 1 0 0 | 1 | 2 | 1 1 0 0 0 0 1 1 | − 1 | 2 |
| 1 2 | 1 1 1 1 1 1 0 1 0 | 5 | 3 | 0 0 0 0 0 0 1 0 1 | − 5 | 3 |
| 1 3 | 1 1 1 1 0 1 0 0 | 3 | 3 | 0 0 0 0 0 1 0 1 1 | − 3 | 3 |
| 1 4 | 1 1 1 0 1 1 1 0 | 5 | 3 | 0 0 0 0 1 0 0 1 | − 5 | 3 |
| 1 5 | 1 1 1 1 0 1 0 0 0 | 1 | 3 | 0 0 0 0 1 0 1 1 1 | − 1 | 3 |
| 1 6 | 1 1 1 1 0 0 1 0 0 | 1 | 3 | 0 0 0 0 1 1 0 1 1 | − 1 | 3 |
| 1 7 | 1 1 1 0 1 1 1 0 | 5 | 3 | 0 0 0 1 0 0 0 0 1 | − 5 | 3 |
| 1 8 | 1 1 1 0 1 1 0 0 0 | 1 | 3 | 0 0 0 1 0 0 1 1 1 | − 1 | 3 |
| 1 9 | 1 1 1 0 0 1 1 0 0 | 1 | 3 | 0 0 0 1 1 0 0 1 1 | − 1 | 3 |
| 1 A | 1 1 0 1 1 1 1 0 | 5 | 3 | 0 0 1 0 0 0 0 0 1 | − 5 | 3 |
| 1 B | 1 1 0 1 1 0 0 0 | 1 | 3 | 0 0 1 0 0 0 1 1 1 | − 1 | 3 |
| 1 C | 1 1 0 0 1 1 1 0 0 | 1 | 3 | 0 0 1 1 0 0 0 1 1 | − 1 | 3 |
| 1 D | 1 0 1 1 1 1 1 0 | 5 | 3 | 0 1 0 0 0 0 0 0 1 | − 5 | 3 |
| 1 E | 1 0 1 1 1 0 0 0 | 1 | 3 | 0 1 0 0 0 1 1 1 | − 1 | 3 |
| 1 F | 1 0 0 1 1 1 1 0 0 | 1 | 3 | 0 1 1 0 0 0 0 1 1 | − 1 | 3 |

# TABLE 1-2

| ADDRESS | TABLE A1 | DSV | INV | TABLE B1 | DSV | INV |
|---------|----------|-----|-----|----------|-----|-----|
| 20 | 0 1 1 1 1 1 1 0 1 | 5 | 3 | 1 0 0 0 0 0 0 1 0 | -5 | 3 |
| 21 | 0 1 1 1 1 1 0 0 1 | 3 | 3 | 1 0 0 0 0 0 1 1 0 | -3 | 3 |
| 22 | 0 1 1 1 1 0 0 1 1 | 3 | 3 | 1 0 0 0 0 1 1 0 0 | -3 | 3 |
| 23 | 0 1 1 1 0 1 1 1 1 | 5 | 3 | 1 0 0 0 1 0 0 0 0 | -5 | 3 |
| 24 | 0 1 1 1 0 0 0 1 1 | 1 | 3 | 1 0 0 0 1 1 1 0 0 | -1 | 3 |
| 25 | 0 1 1 0 0 1 1 1 1 | 3 | 3 | 1 0 0 1 1 0 0 0 0 | -3 | 3 |
| 26 | 0 1 0 1 1 1 1 1 1 | 5 | 3 | 1 0 1 0 0 0 0 0 0 | -5 | 3 |
| 27 | 0 1 0 0 0 1 1 1 1 | 1 | 3 | 1 0 1 1 1 0 0 0 0 | -1 | 3 |
| 28 | 0 0 1 1 1 1 0 1 1 | 3 | 3 | 1 1 0 0 0 0 1 0 0 | -3 | 3 |
| 29 | 0 0 1 1 1 0 1 1 1 | 3 | 3 | 1 1 0 0 0 1 0 0 0 | -3 | 3 |
| 2A | 0 0 1 1 0 1 1 1 1 | 3 | 3 | 1 1 0 0 1 0 0 0 0 | -3 | 3 |
| 2B | 0 0 1 0 1 1 1 1 1 | 3 | 3 | 1 1 0 1 0 0 0 0 0 | -3 | 3 |
| 2C | 0 0 0 1 1 1 1 0 1 | 1 | 3 | 1 1 1 0 0 0 0 1 0 | -1 | 3 |
| 2D | 0 0 0 1 1 0 1 1 1 | 1 | 3 | 1 1 1 0 0 1 0 0 0 | -1 | 3 |
| 2E | 1 1 1 1 1 0 1 0 1 | 5 | 4 | 0 0 0 0 0 1 0 1 0 | -5 | 4 |
| 2F | 1 1 1 1 0 1 0 1 1 | 5 | 4 | 0 0 0 0 1 0 1 0 0 | -5 | 4 |
| 30 | 1 1 1 1 0 0 1 0 1 | 3 | 4 | 0 0 0 0 1 1 0 1 0 | -3 | 4 |
| 31 | 1 1 1 0 1 1 0 1 1 | 5 | 4 | 0 0 0 1 0 0 1 0 0 | -5 | 4 |
| 32 | 1 1 1 0 1 0 1 1 1 | 5 | 4 | 0 0 0 1 0 1 0 0 0 | -5 | 4 |
| 33 | 1 1 1 0 1 0 0 0 1 | 1 | 4 | 0 0 0 1 0 1 1 1 0 | -1 | 4 |
| 34 | 1 1 1 0 0 1 0 1 1 | 3 | 4 | 0 0 0 1 1 0 1 0 0 | -3 | 4 |
| 35 | 1 1 1 0 0 0 1 0 1 | 1 | 4 | 0 0 0 1 1 1 0 1 0 | -1 | 4 |
| 36 | 1 1 0 1 1 1 0 1 1 | 5 | 4 | 0 0 1 0 0 0 1 0 0 | -5 | 4 |
| 37 | 1 1 0 1 1 0 1 1 1 | 5 | 4 | 0 0 1 0 0 1 0 0 0 | -5 | 4 |
| 38 | 1 1 0 1 1 0 0 0 1 | 1 | 4 | 0 0 1 0 0 1 1 1 0 | -1 | 4 |
| 39 | 1 1 0 1 0 0 1 1 1 | 3 | 4 | 0 0 1 0 1 1 0 0 0 | -3 | 4 |
| 3A | 1 1 0 0 1 1 1 0 1 | 3 | 4 | 0 0 1 1 0 0 0 1 0 | -3 | 4 |
| 3B | 1 1 0 0 1 1 0 0 1 | 1 | 4 | 0 0 1 1 0 0 1 1 0 | -1 | 4 |
| 3C | 1 1 0 0 1 0 0 1 1 | 1 | 4 | 0 0 1 1 0 1 1 0 0 | -1 | 4 |
| 3D | 1 1 0 0 0 1 0 1 1 | 1 | 4 | 0 0 1 1 1 0 1 0 0 | -1 | 4 |
| 3E | 1 0 1 1 1 1 0 1 1 | 5 | 4 | 0 1 0 0 0 0 1 0 0 | -5 | 4 |
| 3F | 1 0 1 1 1 0 1 1 1 | 5 | 4 | 0 1 0 0 0 1 0 0 0 | -5 | 4 |

# TABLE 1-3

| ADDRESS | TABLE A1 | DSV | INV | TABLE B1 | DSV | INV |
|---|---|---|---|---|---|---|
| 4 0 | 1 0 1 1 1 0 0 0 1 | 1 | 4 | 0 1 0 0 0 1 1 1 0 | − 1 | 4 |
| 4 1 | 1 0 1 1 0 0 1 1 1 | 3 | 4 | 0 1 0 0 1 1 0 0 0 | − 3 | 4 |
| 4 2 | 1 0 1 0 1 1 1 1 1 | 5 | 4 | 0 1 0 1 0 0 0 0 0 | − 5 | 4 |
| 4 3 | 1 0 1 0 0 0 1 1 1 | 1 | 4 | 0 1 0 1 1 1 0 0 0 | − 1 | 4 |
| 4 4 | 1 0 0 1 1 1 0 1 1 | 3 | 4 | 0 1 1 0 0 0 1 0 0 | − 3 | 4 |
| 4 5 | 1 0 0 1 1 0 1 1 1 | 3 | 4 | 0 1 1 0 0 1 0 0 0 | − 3 | 4 |
| 4 6 | 1 0 0 1 0 1 1 1 1 | 3 | 4 | 0 1 1 0 1 0 0 0 0 | − 3 | 4 |
| 4 7 | 1 0 0 0 1 1 1 0 1 | 1 | 4 | 0 1 1 1 0 0 0 1 0 | − 1 | 4 |
| 4 8 | 1 0 0 0 1 0 1 1 1 | 1 | 4 | 0 1 1 1 0 1 0 0 0 | − 1 | 4 |
| 4 9 | 0 1 1 1 1 0 1 1 0 | 3 | 4 | 1 0 0 0 0 1 0 0 1 | − 3 | 4 |
| 4 A | 0 1 1 1 1 0 0 1 0 | 1 | 4 | 1 0 0 0 0 1 1 0 1 | − 1 | 4 |
| 4 B | 0 1 1 1 0 1 1 0 0 | 1 | 4 | 1 0 0 0 1 0 0 1 1 | − 1 | 4 |
| 4 C | 0 1 1 0 1 1 1 1 0 | 3 | 4 | 1 0 0 1 0 0 0 0 1 | − 3 | 4 |
| 4 D | 0 1 1 0 0 1 1 1 0 | 1 | 4 | 1 0 0 1 1 0 0 0 1 | − 1 | 4 |
| 4 E | 0 1 0 1 1 1 1 0 0 | 1 | 4 | 1 0 1 0 0 0 0 1 1 | − 1 | 4 |
| 4 F | 0 0 1 1 1 1 0 1 0 | 1 | 4 | 1 1 0 0 0 0 1 0 1 | − 1 | 4 |
| 5 0 | 0 0 1 1 0 1 1 1 0 | 1 | 4 | 1 1 0 0 1 0 0 0 1 | − 1 | 4 |
| 5 1 | 1 1 1 1 0 1 0 1 0 | 3 | 5 | 0 0 0 0 1 0 1 0 1 | − 3 | 5 |
| 5 2 | 1 1 1 0 1 0 1 1 0 | 3 | 5 | 0 0 0 1 0 1 0 0 1 | − 3 | 5 |
| 5 3 | 1 1 1 0 1 0 0 1 0 | 1 | 5 | 0 0 0 1 0 1 1 0 1 | − 1 | 5 |
| 5 4 | 1 1 0 1 1 1 0 1 0 | 3 | 5 | 0 0 1 0 0 0 1 0 1 | − 3 | 5 |
| 5 5 | 1 1 0 1 1 0 1 0 0 | 1 | 5 | 0 0 1 0 0 1 0 1 1 | − 1 | 5 |
| 5 6 | 1 1 0 1 0 1 1 1 0 | 3 | 5 | 0 0 1 0 1 0 0 0 1 | − 3 | 5 |
| 5 7 | 1 1 0 1 0 0 1 1 0 | 1 | 5 | 0 0 1 0 1 1 0 0 1 | − 1 | 5 |
| 5 8 | 1 1 0 0 1 0 1 1 0 | 1 | 5 | 0 0 1 1 0 1 0 0 1 | − 1 | 5 |
| 5 9 | 1 0 1 1 1 0 1 1 0 | 3 | 5 | 0 1 0 0 0 1 0 0 1 | − 3 | 5 |
| 5 A | 1 0 1 1 1 0 0 1 0 | 1 | 5 | 0 1 0 0 0 1 1 0 1 | − 1 | 5 |
| 5 B | 1 0 1 1 0 1 1 0 0 | 1 | 5 | 0 1 0 0 1 0 0 1 1 | − 1 | 5 |
| 5 C | 1 0 1 0 1 1 1 1 0 | 3 | 5 | 0 1 0 1 0 0 0 0 1 | − 3 | 5 |
| 5 D | 1 0 1 0 0 1 1 1 0 | 1 | 5 | 0 1 0 1 1 0 0 0 1 | − 1 | 5 |
| 5 E | 1 0 0 1 1 0 1 1 0 | 1 | 5 | 0 1 1 0 0 1 0 0 1 | − 1 | 5 |
| 5 F | 0 1 1 1 1 0 1 0 1 | 3 | 5 | 1 0 0 0 0 1 0 1 0 | − 3 | 5 |

# TABLE 1-4

| ADDRESS | TABLE A1 | DSV | INV | TABLE B1 | DSV | INV |
|---|---|---|---|---|---|---|
| 60 | 0 1 1 1 0 1 0 1 1 | 3 | 5 | 1 0 0 0 1 0 1 0 0 | −3 | 5 |
| 61 | 0 1 1 1 0 0 1 0 1 | 1 | 5 | 1 0 0 0 1 1 0 1 0 | −1 | 5 |
| 62 | 0 1 1 0 1 1 0 1 1 | 3 | 5 | 1 0 0 1 0 0 1 0 0 | −3 | 5 |
| 63 | 0 1 1 0 1 0 1 1 1 | 3 | 5 | 1 0 0 1 0 1 0 0 0 | −3 | 5 |
| 64 | 0 1 1 0 0 1 1 0 1 | 1 | 5 | 1 0 0 1 1 0 0 1 0 | −1 | 5 |
| 65 | 0 1 0 1 1 1 1 0 1 | 3 | 5 | 1 0 1 0 0 0 0 1 0 | −3 | 5 |
| 66 | 0 1 0 1 1 1 0 0 1 | 1 | 5 | 1 0 1 0 0 0 1 1 0 | −1 | 5 |
| 67 | 0 1 0 1 1 0 0 1 1 | 1 | 5 | 1 0 1 0 0 1 1 0 0 | −1 | 5 |
| 68 | 0 1 0 1 0 0 1 1 1 | 1 | 5 | 1 0 1 0 1 1 0 0 0 | −1 | 5 |
| 69 | 0 1 0 0 1 1 0 1 1 | 1 | 5 | 1 0 1 1 0 0 1 0 0 | −1 | 5 |
| 6A | 0 0 1 1 1 0 1 0 1 | 1 | 5 | 1 1 0 0 0 1 0 1 0 | −1 | 5 |
| 6B | 0 0 1 1 0 1 0 1 1 | 1 | 5 | 1 1 0 0 1 0 1 0 0 | −1 | 5 |
| 6C | 0 0 1 0 1 1 0 1 1 | 1 | 5 | 1 1 0 1 0 0 1 0 0 | −1 | 5 |
| 6D | 1 1 1 0 1 0 1 0 1 | 3 | 6 | 0 0 0 1 0 1 0 1 0 | −3 | 6 |
| 6E | 1 1 0 1 0 1 1 0 1 | 3 | 6 | 0 0 1 0 1 0 0 1 0 | −3 | 6 |
| 6F | 1 1 0 1 0 1 0 0 1 | 1 | 6 | 0 0 1 0 1 0 1 1 0 | −1 | 6 |
| 70 | 1 1 0 0 1 0 1 0 1 | 1 | 6 | 0 0 1 1 0 1 0 1 0 | −1 | 6 |
| 71 | 1 0 1 1 0 1 1 0 1 | 3 | 6 | 0 1 0 0 1 0 0 1 0 | −3 | 6 |
| 72 | 1 0 1 1 0 1 0 0 1 | 1 | 6 | 0 1 0 0 1 0 1 1 0 | −1 | 6 |
| 73 | 1 0 1 0 1 1 1 0 1 | 3 | 6 | 0 1 0 1 0 0 0 1 0 | −3 | 6 |
| 74 | 1 0 1 0 1 1 0 0 1 | 1 | 6 | 0 1 0 1 0 0 1 1 0 | −1 | 6 |
| 75 | 1 0 1 0 1 0 0 1 1 | 1 | 6 | 0 1 0 1 0 1 1 0 0 | −1 | 6 |
| 76 | 1 0 1 0 0 1 0 1 1 | 1 | 6 | 0 1 0 1 1 0 1 0 0 | −1 | 6 |
| 77 | 1 0 0 1 0 1 1 0 1 | 1 | 6 | 0 1 1 0 1 0 0 1 0 | −1 | 6 |
| 78 | 0 1 1 1 0 1 0 1 0 | 1 | 6 | 1 0 0 0 1 0 1 0 1 | −1 | 6 |
| 79 | 0 1 1 0 1 0 1 1 0 | 1 | 6 | 1 0 0 1 0 1 0 0 1 | −1 | 6 |
| 7A | 0 1 0 1 1 0 1 1 0 | 1 | 6 | 1 0 1 0 0 1 0 0 1 | −1 | 6 |
| 7B | 1 1 0 1 0 1 0 1 0 | 1 | 7 | 0 0 1 0 1 0 1 0 1 | −1 | 7 |
| 7C | 1 0 1 0 1 1 0 1 0 | 1 | 7 | 0 1 0 1 0 0 1 0 1 | −1 | 7 |
| 7D | 0 1 1 0 1 0 1 0 1 | 1 | 7 | 1 0 0 1 0 1 0 1 0 | −1 | 7 |
| 7E | 0 1 0 1 0 1 1 0 1 | 1 | 7 | 1 0 1 0 1 0 0 1 0 | −1 | 7 |
| 7F | 1 0 1 0 1 0 1 0 1 | 1 | 8 | 0 1 0 1 0 1 0 1 0 | −1 | 8 |

## TABLE 1-5

| ADDRESS | TABLE A1 | DSV | INV | TABLE B1 | DSV | INV |
|---------|----------|-----|-----|----------|-----|-----|
| 8 0 | 0 1 0 1 0 1 0 1 1 | 1 | 7 | 1 0 1 0 1 0 1 0 0 | − 1 | 7 |
| 8 1 | 0 1 0 1 1 0 1 0 1 | 1 | 7 | 1 0 1 0 0 1 0 1 0 | − 1 | 7 |
| 8 2 | 1 0 1 0 1 0 1 1 0 | 1 | 7 | 0 1 0 1 0 1 0 0 1 | − 1 | 7 |
| 8 3 | 1 0 1 1 0 1 0 1 0 | 1 | 7 | 0 1 0 0 1 0 1 0 1 | − 1 | 7 |
| 8 4 | 0 1 0 1 0 1 1 1 0 | 1 | 6 | 1 0 1 0 1 0 0 0 1 | − 1 | 6 |
| 8 5 | 0 1 0 1 1 1 0 1 0 | 1 | 6 | 1 0 1 0 0 0 1 0 1 | − 1 | 6 |
| 8 6 | 0 1 1 0 1 1 0 1 0 | 1 | 6 | 1 0 0 1 0 0 1 0 1 | − 1 | 6 |
| 8 7 | 1 0 0 1 0 1 0 1 1 | 1 | 6 | 0 1 1 0 1 0 1 0 0 | − 1 | 6 |
| 8 8 | 1 0 0 1 1 0 1 0 1 | 1 | 6 | 0 1 1 0 0 1 0 1 0 | − 1 | 6 |
| 8 9 | 1 0 1 0 0 1 1 0 1 | 1 | 6 | 0 1 0 1 1 0 0 1 0 | − 1 | 6 |
| 8 A | 1 0 1 0 1 0 1 1 1 | 3 | 6 | 0 1 0 1 0 1 0 0 0 | − 3 | 6 |
| 8 B | 1 0 1 0 1 1 0 1 1 | 3 | 6 | 0 1 0 1 0 0 1 0 0 | − 3 | 6 |
| 8 C | 1 0 1 1 0 0 1 0 1 | 1 | 6 | 0 1 0 0 1 1 0 1 0 | − 1 | 6 |
| 8 D | 1 0 1 1 0 1 0 1 1 | 3 | 6 | 0 1 0 0 1 0 1 0 0 | − 3 | 6 |
| 8 E | 1 0 1 1 1 0 1 0 1 | 3 | 6 | 0 1 0 0 0 1 0 1 0 | − 3 | 6 |
| 8 F | 1 1 0 1 0 0 1 0 1 | 1 | 6 | 0 0 1 0 1 1 0 1 0 | − 1 | 6 |
| 9 0 | 1 1 0 1 0 1 0 1 1 | 3 | 6 | 0 0 1 0 1 0 1 0 0 | − 3 | 6 |
| 9 1 | 1 1 0 1 1 0 1 0 1 | 3 | 6 | 0 0 1 0 0 1 0 1 0 | − 3 | 6 |
| 9 2 | 0 0 1 0 1 0 1 1 1 | 1 | 5 | 1 1 0 1 0 1 0 0 0 | − 1 | 5 |
| 9 3 | 0 0 1 0 1 1 1 0 1 | 1 | 5 | 1 1 0 1 0 0 0 1 0 | − 1 | 5 |
| 9 4 | 0 0 1 1 0 1 1 0 1 | 1 | 5 | 1 1 0 0 1 0 0 1 0 | − 1 | 5 |
| 9 5 | 0 1 0 0 1 0 1 1 1 | 1 | 5 | 1 0 1 1 0 1 0 0 0 | − 1 | 5 |
| 9 6 | 0 1 0 0 1 1 1 0 1 | 1 | 5 | 1 0 1 1 0 0 0 1 0 | − 1 | 5 |
| 9 7 | 0 1 0 1 0 1 1 1 1 | 3 | 5 | 1 0 1 0 1 0 0 0 0 | − 3 | 5 |
| 9 8 | 0 1 0 1 1 0 1 1 1 | 3 | 5 | 1 0 1 0 0 1 0 0 0 | − 3 | 5 |
| 9 9 | 0 1 0 1 1 1 0 1 1 | 3 | 5 | 1 0 1 0 0 0 1 0 0 | − 3 | 5 |
| 9 A | 0 1 1 0 0 1 0 1 1 | 1 | 5 | 1 0 0 1 1 0 1 0 0 | − 1 | 5 |
| 9 B | 0 1 1 0 1 0 0 1 1 | 1 | 5 | 1 0 0 1 0 1 1 0 0 | − 1 | 5 |
| 9 C | 0 1 1 0 1 1 0 0 1 | 1 | 5 | 1 0 0 1 0 0 1 1 0 | − 1 | 5 |
| 9 D | 0 1 1 0 1 1 1 0 1 | 3 | 5 | 1 0 0 1 0 0 0 1 0 | − 3 | 5 |
| 9 E | 0 1 1 1 0 1 0 0 1 | 1 | 5 | 1 0 0 0 1 0 1 1 0 | − 1 | 5 |
| 9 F | 0 1 1 1 0 1 1 0 1 | 3 | 5 | 1 0 0 0 1 0 0 1 0 | − 3 | 5 |

# TABLE 1-6

| ADDRESS | TABLE A1 | DSV | INV | TABLE B1 | DSV | INV |
|---------|----------|-----|-----|----------|-----|-----|
| A 0 | 1 0 0 1 0 1 1 1 0 | 1 | 5 | 0 1 1 0 1 0 0 0 1 | − 1 | 5 |
| A 1 | 1 0 0 1 1 1 0 1 0 | 1 | 5 | 0 1 1 0 0 0 1 0 1 | − 1 | 5 |
| A 2 | 1 0 1 0 1 1 1 0 0 | 1 | 5 | 0 1 0 1 0 0 0 1 1 | − 1 | 5 |
| A 3 | 1 0 1 1 0 0 1 1 0 | 1 | 5 | 0 1 0 0 1 1 0 0 1 | − 1 | 5 |
| A 4 | 1 0 1 1 0 1 1 1 0 | 3 | 5 | 0 1 0 0 1 0 0 0 1 | − 3 | 5 |
| A 5 | 1 0 1 1 1 0 1 0 0 | 1 | 5 | 0 1 0 0 0 1 0 1 1 | − 1 | 5 |
| A 6 | 1 0 1 1 1 1 0 1 0 | 3 | 5 | 0 1 0 0 0 0 1 0 1 | − 3 | 5 |
| A 7 | 1 1 0 0 1 1 0 1 0 | 1 | 5 | 0 0 1 1 0 0 1 0 1 | − 1 | 5 |
| A 8 | 1 1 0 1 0 1 1 0 0 | 1 | 5 | 0 0 1 0 1 0 0 1 1 | − 1 | 5 |
| A 9 | 1 1 0 1 1 0 0 1 0 | 1 | 5 | 0 0 1 0 0 1 1 0 1 | − 1 | 5 |
| A A | 1 1 0 1 1 0 1 1 0 | 3 | 5 | 0 0 1 0 0 1 0 0 1 | − 3 | 5 |
| A B | 1 1 1 0 0 1 0 1 0 | 1 | 5 | 0 0 0 1 1 0 1 0 1 | − 1 | 5 |
| A C | 1 1 1 0 1 0 1 0 0 | 1 | 5 | 0 0 0 1 0 1 0 1 1 | − 1 | 5 |
| A D | 1 1 1 0 1 1 0 1 0 | 3 | 5 | 0 0 0 1 0 0 1 0 1 | − 3 | 5 |
| A E | 0 0 1 0 1 1 1 1 0 | 1 | 4 | 1 1 0 1 0 0 0 0 1 | − 1 | 4 |
| A F | 0 0 1 1 1 0 1 1 0 | 1 | 4 | 1 1 0 0 0 1 0 0 1 | − 1 | 4 |
| B 0 | 0 1 0 0 1 1 1 1 0 | 1 | 4 | 1 0 1 1 0 0 0 0 1 | − 1 | 4 |
| B 1 | 0 1 0 1 1 1 1 0 | 3 | 4 | 1 0 1 0 0 0 0 0 1 | − 3 | 4 |
| B 2 | 0 1 1 0 1 1 1 0 0 | 1 | 4 | 1 0 0 1 0 0 0 1 1 | − 1 | 4 |
| B 3 | 0 1 1 1 0 0 1 1 0 | 1 | 4 | 1 0 0 0 1 1 0 0 1 | − 1 | 4 |
| B 4 | 0 1 1 1 0 1 1 1 0 | 3 | 4 | 1 0 0 0 1 0 0 0 1 | − 3 | 4 |
| B 5 | 0 1 1 1 1 0 1 0 0 | 1 | 4 | 1 0 0 0 0 1 0 1 1 | − 1 | 4 |
| B 6 | 0 1 1 1 1 1 0 1 0 | 3 | 4 | 1 0 0 0 0 0 1 0 1 | − 3 | 4 |
| B 7 | 1 0 0 0 1 1 0 1 1 | 1 | 4 | 0 1 1 1 0 0 1 0 0 | − 1 | 4 |
| B 8 | 1 0 0 1 0 0 1 1 1 | 1 | 4 | 0 1 1 0 1 1 0 0 0 | − 1 | 4 |
| B 9 | 1 0 0 1 1 0 0 1 1 | 1 | 4 | 0 1 1 0 0 1 1 0 0 | − 1 | 4 |
| B A | 1 0 0 1 1 1 0 0 1 | 1 | 4 | 0 1 1 0 0 0 1 1 0 | − 1 | 4 |
| B B | 1 0 0 1 1 1 1 0 1 | 3 | 4 | 0 1 1 0 0 0 0 1 0 | − 3 | 4 |
| B C | 1 0 1 0 0 1 1 1 1 | 3 | 4 | 0 1 0 1 1 0 0 0 0 | − 3 | 4 |
| B D | 1 0 1 1 0 0 0 1 1 | 1 | 4 | 0 1 0 0 1 1 1 0 0 | − 1 | 4 |
| B E | 1 0 1 1 0 1 1 1 1 | 5 | 4 | 0 1 0 0 1 0 0 0 0 | − 5 | 4 |
| B F | 1 0 1 1 1 0 0 1 1 | 3 | 4 | 0 1 0 0 0 1 1 0 0 | − 3 | 4 |

# TABLE 1-7

| ADDRESS | TABLE A1 | DSV | INV | TABLE B1 | DSV | INV |
|---------|----------|-----|-----|----------|-----|-----|
| C 0 | 1 0 1 1 1 1 0 0 1 | 3 | 4 | 0 1 0 0 0 0 1 1 0 | −3 | 4 |
| C 1 | 1 0 1 1 1 1 1 0 1 | 5 | 4 | 0 1 0 0 0 0 0 1 0 | −5 | 4 |
| C 2 | 1 1 0 0 0 1 1 0 1 | 1 | 4 | 0 0 1 1 1 0 0 1 0 | −1 | 4 |
| C 3 | 1 1 0 0 1 0 1 1 1 | 3 | 4 | 0 0 1 1 0 1 0 0 0 | −3 | 4 |
| C 4 | 1 1 0 0 1 1 0 1 1 | 3 | 4 | 0 0 1 1 0 0 1 0 0 | −3 | 4 |
| C 5 | 1 1 0 1 0 0 0 1 1 | 1 | 4 | 0 0 1 0 1 1 1 0 0 | −1 | 4 |
| C 6 | 1 1 0 1 0 1 1 1 1 | 5 | 4 | 0 0 1 0 1 0 0 0 0 | −5 | 4 |
| C 7 | 1 1 0 1 1 0 0 1 1 | 3 | 4 | 0 0 1 0 0 1 1 0 0 | −3 | 4 |
| C 8 | 1 1 0 1 1 1 0 0 1 | 3 | 4 | 0 0 1 0 0 0 1 1 0 | −3 | 4 |
| C 9 | 1 1 0 1 1 1 1 0 1 | 5 | 4 | 0 0 1 0 0 0 0 1 0 | −5 | 4 |
| C A | 1 1 1 0 0 1 0 0 1 | 1 | 4 | 0 0 0 1 1 0 1 1 0 | −1 | 4 |
| C B | 1 1 1 0 0 1 1 0 1 | 3 | 4 | 0 0 0 1 1 0 0 1 0 | −3 | 4 |
| C C | 1 1 1 0 1 0 0 1 1 | 3 | 4 | 0 0 0 1 0 1 1 0 0 | −3 | 4 |
| C D | 1 1 1 0 1 1 0 0 1 | 3 | 4 | 0 0 0 1 0 0 1 1 0 | −3 | 4 |
| C E | 1 1 1 0 1 1 1 0 1 | 5 | 4 | 0 0 0 1 0 0 0 1 0 | −5 | 4 |
| C F | 1 1 1 1 0 1 0 0 1 | 3 | 4 | 0 0 0 0 1 0 1 1 0 | −3 | 4 |
| D 0 | 1 1 1 1 0 1 1 0 1 | 5 | 4 | 0 0 0 0 1 0 0 1 0 | −5 | 4 |
| D 1 | 0 0 0 1 0 1 1 1 1 | 1 | 3 | 1 1 1 0 1 0 0 0 0 | −1 | 3 |
| D 2 | 0 0 0 1 1 1 0 1 1 | 1 | 3 | 1 1 1 0 0 0 1 0 0 | −1 | 3 |
| D 3 | 0 0 1 0 0 1 1 1 1 | 1 | 3 | 1 1 0 1 1 0 0 0 0 | −1 | 3 |
| D 4 | 0 0 1 1 0 0 1 1 1 | 1 | 3 | 1 1 0 0 1 1 0 0 0 | −1 | 3 |
| D 5 | 0 0 1 1 1 0 0 1 1 | 1 | 3 | 1 1 0 0 0 1 1 0 0 | −1 | 3 |
| D 6 | 0 0 1 1 1 1 0 0 1 | 1 | 3 | 1 1 0 0 0 0 1 1 0 | −1 | 3 |
| D 7 | 0 0 1 1 1 1 1 0 1 | 3 | 3 | 1 1 0 0 0 0 0 1 0 | −3 | 3 |
| D 8 | 0 1 0 0 1 1 1 1 1 | 3 | 3 | 1 0 1 1 0 0 0 0 0 | −3 | 3 |
| D 9 | 0 1 1 0 0 0 1 1 1 | 1 | 3 | 1 0 0 1 1 1 0 0 0 | −1 | 3 |
| D A | 0 1 1 0 1 1 1 1 1 | 5 | 3 | 1 0 0 1 0 0 0 0 0 | −5 | 3 |
| D B | 0 1 1 1 0 0 1 1 1 | 3 | 3 | 1 0 0 0 1 1 0 0 0 | −3 | 3 |
| D C | 0 1 1 1 1 0 0 0 1 | 1 | 3 | 1 0 0 0 0 1 1 1 0 | −1 | 3 |
| D D | 0 1 1 1 1 0 1 1 1 | 5 | 3 | 1 0 0 0 0 1 0 0 0 | −5 | 3 |
| D E | 0 1 1 1 1 1 0 1 1 | 5 | 3 | 1 0 0 0 0 0 1 0 0 | −5 | 3 |
| D F | 1 0 0 0 1 1 1 1 0 | 1 | 3 | 0 1 1 1 0 0 0 0 1 | −1 | 3 |

## TABLE 1-8

| ADDRESS | TABLE A1 | DSV | INV | TABLE B1 | DSV | INV |
|---|---|---|---|---|---|---|
| E 0 | 1 0 0 1 1 1 1 0 | 3 | 3 | 0 1 1 0 0 0 0 1 | -3 | 3 |
| E 1 | 1 0 1 1 1 1 0 0 | 3 | 3 | 0 1 0 0 0 0 1 1 | -3 | 3 |
| E 2 | 1 1 0 0 0 1 1 0 | 1 | 3 | 0 0 1 1 1 0 0 1 | -1 | 3 |
| E 3 | 1 1 0 0 1 1 1 0 | 3 | 3 | 0 0 1 1 0 0 0 1 | -3 | 3 |
| E 4 | 1 1 0 1 1 1 0 0 | 3 | 3 | 0 0 1 0 0 0 1 1 | -3 | 3 |
| E 5 | 1 1 1 0 0 0 1 0 | 1 | 3 | 0 0 0 1 1 1 0 1 | -1 | 3 |
| E 6 | 1 1 1 0 0 1 1 0 | 3 | 3 | 0 0 0 1 1 0 0 1 | -3 | 3 |
| E 7 | 1 1 1 0 1 1 0 0 | 3 | 3 | 0 0 0 1 0 0 1 1 | -3 | 3 |
| E 8 | 1 1 1 1 0 0 1 0 | 1 | 3 | 0 0 0 0 1 1 0 1 | -1 | 3 |
| E 9 | 1 1 1 1 0 1 1 0 | 3 | 3 | 0 0 0 0 1 0 0 1 | -3 | 3 |
| E A | 1 1 1 1 0 1 0 0 | 3 | 3 | 0 0 0 0 1 0 1 1 | -3 | 3 |
| E B | 1 1 1 1 1 0 1 0 | 3 | 3 | 0 0 0 0 0 1 0 1 | -3 | 3 |
| E C | 1 1 1 1 1 1 1 0 | 5 | 3 | 0 0 0 0 0 0 0 1 | -5 | 3 |
| E D | 0 0 0 1 1 1 1 0 | 1 | 2 | 1 1 1 0 0 0 0 1 | -1 | 2 |
| E E | 0 0 1 1 1 1 1 0 | 3 | 2 | 1 1 0 0 0 0 0 1 | -3 | 2 |
| E F | 0 1 1 1 1 1 0 0 | 3 | 2 | 1 0 0 0 0 0 1 1 | -3 | 2 |
| F 0 | 1 0 0 0 0 1 1 1 | 1 | 2 | 0 1 1 1 1 0 0 0 | -1 | 2 |
| F 1 | 1 0 0 1 1 1 1 1 | 5 | 2 | 0 1 1 0 0 0 0 0 | -5 | 2 |
| F 2 | 1 1 0 0 0 0 1 1 | 1 | 2 | 0 0 1 1 1 1 0 0 | -1 | 2 |
| F 3 | 1 1 0 0 1 1 1 1 | 5 | 2 | 0 0 1 1 0 0 0 0 | -5 | 2 |
| F 4 | 1 1 1 0 0 0 1 1 | 1 | 2 | 0 0 0 1 1 1 0 0 | -1 | 2 |
| F 5 | 1 1 1 0 0 1 1 1 | 5 | 2 | 0 0 0 1 1 0 0 0 | -5 | 2 |
| F 6 | 1 1 1 1 0 0 0 1 | 1 | 2 | 0 0 0 0 1 1 1 0 | -1 | 2 |
| F 7 | 1 1 1 1 0 1 1 1 | 5 | 2 | 0 0 0 0 1 0 0 0 | -5 | 2 |
| F 8 | 1 1 1 1 1 0 0 1 | 3 | 2 | 0 0 0 0 0 1 1 0 | -3 | 2 |
| F 9 | 1 1 1 1 1 0 1 1 | 7 | 2 | 0 0 0 0 0 1 0 0 | -7 | 2 |
| F A | 1 1 1 1 1 1 0 1 | 7 | 2 | 0 0 0 0 0 0 1 0 | -7 | 2 |
| F B | 0 0 0 0 1 1 1 1 | 1 | 1 | 1 1 1 1 0 0 0 0 | -1 | 1 |
| F C | 0 0 1 1 1 1 1 1 | 5 | 1 | 1 1 0 0 0 0 0 0 | -5 | 1 |
| F D | 1 1 1 1 0 0 0 0 | 1 | 1 | 0 0 0 0 1 1 1 1 | -1 | 1 |
| F E | 1 1 1 1 1 1 0 0 | 5 | 1 | 0 0 0 0 0 0 1 1 | -5 | 1 |
| F F | 1 1 1 1 1 1 1 1 | 9 | 0 | 0 0 0 0 0 0 0 0 | -9 | 0 |

# TABLE 2-1

| ADDRESS | TABLE A2 | | | | TABLE B2 | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 00 | 1FE | 111111110 | 7 | 1 | 001 | 000000001 | -7 | 1 |
| 01 | 1FD | 111111101 | 7 | 2 | 002 | 000000010 | -7 | 2 |
| 02 | 1F7 | 111110111 | 7 | 2 | 008 | 000001000 | -7 | 2 |
| 03 | 1DF | 111011111 | 7 | 2 | 020 | 000100000 | -7 | 2 |
| 04 | 17F | 101111111 | 7 | 2 | 080 | 010000000 | -7 | 2 |
| 05 | 07F | 001111111 | 5 | 1 | 180 | 110000000 | -5 | 1 |
| 06 | 1F3 | 111110011 | 5 | 2 | 00C | 000001100 | -5 | 2 |
| 07 | 1CF | 111001111 | 5 | 2 | 030 | 000110000 | -5 | 2 |
| 08 | 13F | 100111111 | 5 | 2 | 0C0 | 011000000 | -5 | 2 |
| 09 | 1FA | 111111010 | 5 | 3 | 005 | 000000101 | -5 | 3 |
| 0A | 1EE | 111101110 | 5 | 3 | 011 | 000010001 | -5 | 3 |
| 0B | 1BE | 110111110 | 5 | 3 | 041 | 001000001 | -5 | 3 |
| 0C | 0FD | 011111101 | 5 | 3 | 102 | 100000010 | -5 | 3 |
| 0D | 0F7 | 011110111 | 5 | 3 | 108 | 100001000 | -5 | 3 |
| 0E | 0DF | 011011111 | 5 | 3 | 120 | 100100000 | -5 | 3 |
| 0F | 1F5 | 111110101 | 5 | 4 | 00A | 000001010 | -5 | 4 |
| 10 | 1EB | 111101011 | 5 | 4 | 014 | 000010100 | -5 | 4 |
| 11 | 1DB | 111011011 | 5 | 4 | 024 | 000100100 | -5 | 4 |
| 12 | 1BD | 110111101 | 5 | 4 | 042 | 001000010 | -5 | 4 |
| 13 | 1B7 | 110110111 | 5 | 4 | 048 | 001001000 | -5 | 4 |
| 14 | 17D | 101111101 | 5 | 4 | 082 | 010000010 | -5 | 4 |
| 15 | 177 | 101110111 | 5 | 4 | 088 | 010001000 | -5 | 4 |
| 16 | 15F | 101011111 | 5 | 4 | 0A0 | 010100000 | -5 | 4 |
| 17 | 03F | 000111111 | 3 | 1 | 1C0 | 111000000 | -3 | 1 |
| 18 | 1E3 | 111100011 | 3 | 2 | 01C | 000011100 | -3 | 2 |
| 19 | 18F | 110001111 | 3 | 2 | 070 | 001110000 | -3 | 2 |
| 1A | 0FC | 011111100 | 3 | 2 | 103 | 100000011 | -3 | 2 |
| 1B | 1F4 | 111110100 | 3 | 3 | 00B | 000001011 | -3 | 3 |
| 1C | 1EC | 111101100 | 3 | 3 | 013 | 000010011 | -3 | 3 |
| 1D | 1DC | 111011100 | 3 | 3 | 023 | 000100011 | -3 | 3 |
| 1E | 1BC | 110111100 | 3 | 3 | 043 | 001000011 | -3 | 3 |
| 1F | 17C | 101111100 | 3 | 3 | 083 | 010000011 | -3 | 3 |

# TABLE 2-2

| ADDRESS | TABLE A2 | | | | TABLE B2 | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 20 | 0F9 | 011111001 | 3 | 3 | 106 | 100000110 | -3 | 3 |
| 21 | 0E7 | 011100111 | 3 | 3 | 118 | 100011000 | -3 | 3 |
| 22 | 09F | 010011111 | 3 | 3 | 160 | 101100000 | -3 | 3 |
| 23 | 07B | 001111011 | 3 | 3 | 184 | 110000100 | -3 | 3 |
| 24 | 06F | 001101111 | 3 | 3 | 190 | 110010000 | -3 | 3 |
| 25 | 1E9 | 111101001 | 3 | 4 | 016 | 000010110 | -3 | 4 |
| 26 | 1D9 | 111011001 | 3 | 4 | 026 | 000100110 | -3 | 4 |
| 27 | 1CD | 111001101 | 3 | 4 | 032 | 000110010 | -3 | 4 |
| 28 | 1B9 | 110111001 | 3 | 4 | 046 | 001000110 | -3 | 4 |
| 29 | 1A7 | 110100111 | 3 | 4 | 058 | 001011000 | -3 | 4 |
| 2A | 19B | 110011011 | 3 | 4 | 064 | 001100100 | -3 | 4 |
| 2B | 179 | 101111001 | 3 | 4 | 086 | 010000110 | -3 | 4 |
| 2C | 167 | 101100111 | 3 | 4 | 098 | 010011000 | -3 | 4 |
| 2D | 13D | 100111101 | 3 | 4 | 0C2 | 011000010 | -3 | 4 |
| 2E | 137 | 100110111 | 3 | 4 | 0C8 | 011001000 | -3 | 4 |
| 2F | 0FA | 011111010 | 3 | 4 | 105 | 100000101 | -3 | 4 |
| 30 | 0EE | 011101110 | 3 | 4 | 111 | 100010001 | -3 | 4 |
| 31 | 0BE | 010111110 | 3 | 4 | 141 | 101000001 | -3 | 4 |
| 23 | 1DA | 111011010 | 3 | 5 | 025 | 000100101 | -3 | 5 |
| 33 | 1BA | 110111010 | 3 | 5 | 045 | 001000101 | -3 | 5 |
| 34 | 1AE | 110101110 | 3 | 5 | 051 | 001010001 | -3 | 5 |
| 35 | 176 | 101110110 | 3 | 5 | 089 | 010001001 | -3 | 5 |
| 36 | 15E | 101011110 | 3 | 5 | 0A1 | 010100001 | -3 | 5 |
| 37 | 0ED | 011101101 | 3 | 5 | 112 | 100010010 | -3 | 5 |
| 38 | 0DD | 011011101 | 3 | 5 | 122 | 100100010 | -3 | 5 |
| 39 | 0D7 | 011010111 | 3 | 5 | 128 | 100101000 | -3 | 5 |
| 3A | 0BB | 010111011 | 3 | 5 | 144 | 101000100 | -3 | 5 |
| 3B | 0AF | 010101111 | 3 | 5 | 150 | 101010000 | -3 | 5 |
| 3C | 1B5 | 110110101 | 3 | 6 | 04A | 001001010 | -3 | 6 |
| 3D | 1AB | 110101011 | 3 | 6 | 054 | 001010100 | -3 | 6 |
| 3E | 16D | 101101101 | 3 | 6 | 092 | 010010010 | -3 | 6 |
| 3F | 15D | 101011101 | 3 | 6 | 0A2 | 010100010 | -3 | 6 |

# *TABLE 2-3*

| ADDRESS | TABLE A2 | | | | TABLE B2 | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 40 | 157 | 101011101 | 3 | 6 | 0A8 | 010101000 | -3 | 6 |
| 41 | 01F | 000011111 | 1 | 1 | 1E0 | 111100000 | -1 | 1 |
| 42 | 1C3 | 111000011 | 1 | 2 | 03C | 000111100 | -1 | 2 |
| 43 | 10F | 100001111 | 1 | 2 | 0F0 | 011110000 | -1 | 2 |
| 44 | 07C | 001111100 | 1 | 2 | 183 | 110000011 | -1 | 2 |
| 45 | 1E8 | 111101000 | 1 | 3 | 017 | 000010111 | -1 | 3 |
| 46 | 1E2 | 111100010 | 1 | 3 | 01D | 000011101 | -1 | 3 |
| 47 | 1CC | 111001100 | 1 | 3 | 033 | 000110011 | -1 | 3 |
| 48 | 1B8 | 110111000 | 1 | 3 | 047 | 001000111 | -1 | 3 |
| 49 | 18E | 110001110 | 1 | 3 | 071 | 001110001 | -1 | 3 |
| 4A | 13C | 100111100 | 1 | 3 | 0C3 | 011000011 | -1 | 3 |
| 4B | 0F1 | 011110001 | 1 | 3 | 10E | 100001110 | -1 | 3 |
| 4C | 0C7 | 011000111 | 1 | 3 | 138 | 100111000 | -1 | 3 |
| 4D | 079 | 001111001 | 1 | 3 | 186 | 110000110 | -1 | 3 |
| 4E | 067 | 001100111 | 1 | 3 | 198 | 110011000 | -1 | 3 |
| 4F | 03D | 000111101 | 1 | 3 | 1C2 | 111000010 | -1 | 3 |
| 50 | 037 | 000110111 | 1 | 3 | 1C8 | 111001000 | -1 | 3 |
| 51 | 1D1 | 111010001 | 1 | 4 | 02E | 000101110 | -1 | 4 |
| 52 | 1C5 | 111000101 | 1 | 4 | 03A | 000111010 | -1 | 4 |
| 53 | 1A3 | 110100011 | 1 | 4 | 05C | 001011100 | -1 | 4 |
| 54 | 193 | 110010011 | 1 | 4 | 06C | 001101100 | -1 | 4 |
| 55 | 18B | 110001011 | 1 | 4 | 074 | 001110100 | -1 | 4 |
| 56 | 163 | 101100011 | 1 | 4 | 09C | 010011100 | -1 | 4 |
| 57 | 139 | 100111001 | 1 | 4 | 0C6 | 011000110 | -1 | 4 |
| 58 | 127 | 100100111 | 1 | 4 | 0D8 | 011011000 | -1 | 4 |
| 59 | 11B | 100011011 | 1 | 4 | 0E4 | 011100100 | -1 | 4 |
| 5A | 0F4 | 011110100 | 1 | 4 | 10B | 100001011 | -1 | 4 |
| 5B | 0EC | 011101100 | 1 | 4 | 113 | 100010011 | -1 | 4 |
| 5C | 0DC | 011011100 | 1 | 4 | 123 | 100100011 | -1 | 4 |
| 5D | 0BC | 010111100 | 1 | 4 | 143 | 101000011 | -1 | 4 |
| 5E | 07A | 001111010 | 1 | 4 | 185 | 110000101 | -1 | 4 |
| 5F | 06E | 001101110 | 1 | 4 | 191 | 110010001 | -1 | 4 |

# TABLE 2-4

| ADDRESS | TABLE A2 | | | | TABLE B2 | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 60 | 1D4 | 111010100 | 1 | 5 | 02B | 000101011 | -1 | 5 |
| 61 | 1CA | 111001010 | 1 | 5 | 035 | 000110101 | -1 | 5 |
| 62 | 1B2 | 110110010 | 1 | 5 | 04D | 001001101 | -1 | 5 |
| 63 | 1A6 | 110100110 | 1 | 5 | 059 | 001011001 | -1 | 5 |
| 64 | 196 | 110010110 | 1 | 5 | 069 | 001101001 | -1 | 5 |
| 65 | 172 | 101110010 | 1 | 5 | 08D | 010001101 | -1 | 5 |
| 66 | 166 | 101100110 | 1 | 5 | 099 | 010011001 | -1 | 5 |
| 67 | 14E | 101001110 | 1 | 5 | 0B1 | 010110001 | -1 | 5 |
| 68 | 136 | 100110110 | 1 | 5 | 0C9 | 011001001 | -1 | 5 |
| 69 | 0E9 | 011101001 | 1 | 5 | 116 | 100010110 | -1 | 5 |
| 6A | 0D9 | 011011001 | 1 | 5 | 126 | 100100110 | -1 | 5 |
| 6B | 0CD | 011001101 | 1 | 5 | 132 | 100110010 | -1 | 5 |
| 6C | 0B9 | 010111001 | 1 | 5 | 146 | 101000110 | -1 | 5 |
| 6D | 0A7 | 010100111 | 1 | 5 | 158 | 101011000 | -1 | 5 |
| 6E | 09B | 010011011 | 1 | 5 | 164 | 101100100 | -1 | 5 |
| 6F | 075 | 001110101 | 1 | 5 | 18A | 110001010 | -1 | 5 |
| 70 | 06B | 001101011 | 1 | 5 | 194 | 110010100 | -1 | 5 |
| 71 | 05B | 001011011 | 1 | 5 | 1A4 | 110100100 | -1 | 5 |
| 72 | 1A9 | 110101001 | 1 | 6 | 056 | 001010110 | -1 | 6 |
| 73 | 195 | 110010101 | 1 | 6 | 06A | 001101010 | -1 | 6 |
| 74 | 165 | 101100101 | 1 | 6 | 09A | 010011010 | -1 | 6 |
| 75 | 153 | 101010011 | 1 | 6 | 0AC | 010101100 | -1 | 6 |
| 76 | 14B | 101001011 | 1 | 6 | 0B4 | 010110100 | -1 | 6 |
| 77 | 12D | 100101101 | 1 | 6 | 0D2 | 011010010 | -1 | 6 |
| 78 | 0EA | 011101010 | 1 | 6 | 115 | 100010101 | -1 | 6 |
| 79 | 0D6 | 011010110 | 1 | 6 | 129 | 100101001 | -1 | 6 |
| 7A | 0B6 | 010110110 | 1 | 6 | 149 | 101001001 | -1 | 6 |
| 7B | 1AA | 110101010 | 1 | 7 | 055 | 001010101 | -1 | 7 |
| 7C | 15A | 101011010 | 1 | 7 | 0A5 | 010100101 | -1 | 7 |
| 7D | 0D5 | 011010101 | 1 | 7 | 12A | 100101010 | -1 | 7 |
| 7E | 0AD | 010101101 | 1 | 7 | 152 | 101010010 | -1 | 7 |
| 7F | 155 | 101010101 | 1 | 8 | 0AA | 010101010 | -1 | 8 |

# TABLE 2-5

| ADDRESS | TABLE A2 | | | | TABLE B2 | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 80 | 0AB | 010101011 | 1 | 7 | 154 | 101010100 | -1 | 7 |
| 81 | 0B5 | 010110101 | 1 | 7 | 14A | 101001010 | -1 | 7 |
| 82 | 156 | 101010110 | 1 | 7 | 0A9 | 010101001 | -1 | 7 |
| 83 | 16A | 101101010 | 1 | 7 | 095 | 010010101 | -1 | 7 |
| 84 | 0AE | 010101110 | 1 | 6 | 151 | 101010001 | -1 | 6 |
| 85 | 0BA | 010111010 | 1 | 6 | 145 | 101000101 | -1 | 6 |
| 86 | 0DA | 011011010 | 1 | 6 | 125 | 100100101 | -1 | 6 |
| 87 | 12B | 100101011 | 1 | 6 | 0D4 | 011010100 | -1 | 6 |
| 88 | 135 | 100110101 | 1 | 6 | 0CA | 011001010 | -1 | 6 |
| 89 | 14D | 101001101 | 1 | 6 | 0B2 | 010110010 | -1 | 6 |
| 8A | 159 | 101011001 | 1 | 6 | 0A6 | 010100110 | -1 | 6 |
| 8B | 169 | 101101001 | 1 | 6 | 096 | 010010110 | -1 | 6 |
| 8C | 1A5 | 110100101 | 1 | 6 | 05A | 001011010 | -1 | 6 |
| 8D | 057 | 001010111 | 1 | 5 | 1A8 | 110101000 | -1 | 5 |
| 8E | 05D | 001011101 | 1 | 5 | 1A2 | 110100010 | -1 | 5 |
| 8F | 06D | 001101101 | 1 | 5 | 192 | 110010010 | -1 | 5 |
| 90 | 097 | 010010111 | 1 | 5 | 168 | 101101000 | -1 | 5 |
| 91 | 09D | 010011101 | 1 | 5 | 162 | 101100010 | -1 | 5 |
| 92 | 0B3 | 010110011 | 1 | 5 | 14C | 101001100 | -1 | 5 |
| 93 | 0CB | 011001011 | 1 | 5 | 134 | 100110100 | -1 | 5 |
| 94 | 0D3 | 011010011 | 1 | 5 | 12C | 100101100 | -1 | 5 |
| 95 | 0E5 | 011100101 | 1 | 5 | 11A | 100011010 | -1 | 5 |
| 96 | 12E | 100101110 | 1 | 5 | 0D1 | 011010001 | -1 | 5 |
| 97 | 13A | 100111010 | 1 | 5 | 0C5 | 011000101 | -1 | 5 |
| 98 | 15C | 101011100 | 1 | 5 | 0A3 | 010100011 | -1 | 5 |
| 99 | 16C | 101101100 | 1 | 5 | 093 | 010010011 | -1 | 5 |
| 9A | 174 | 101110100 | 1 | 5 | 08B | 010001011 | -1 | 5 |
| 9B | 19A | 110011010 | 1 | 5 | 065 | 001100101 | -1 | 5 |
| 9C | 1AC | 110101100 | 1 | 5 | 053 | 001010011 | -1 | 5 |
| 9D | 1B4 | 110110100 | 1 | 5 | 04B | 001001011 | -1 | 5 |
| 9E | 1D2 | 111010010 | 1 | 5 | 02D | 000101101 | -1 | 5 |
| 9F | 05E | 001011110 | 1 | 4 | 1A1 | 110100001 | -1 | 4 |

# TABLE 2-6

| ADDRESS | TABLE A2 | | | | TABLE B2 | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| A0 | 076 | 001110110 | 1 | 4 | 189 | 110001001 | -1 | 4 |
| A1 | 09E | 010011110 | 1 | 4 | 161 | 101100001 | -1 | 4 |
| A2 | 0CE | 011001110 | 1 | 4 | 131 | 100110001 | -1 | 4 |
| A3 | 0E6 | 011100110 | 1 | 4 | 119 | 100011001 | -1 | 4 |
| A4 | 0F2 | 011110010 | 1 | 4 | 10D | 100001101 | -1 | 4 |
| A5 | 117 | 100010111 | 1 | 4 | 0E8 | 011101000 | -1 | 4 |
| A6 | 11D | 100011101 | 1 | 4 | 0E2 | 011100010 | -1 | 4 |
| A7 | 133 | 100110011 | 1 | 4 | 0CC | 011001100 | -1 | 4 |
| A8 | 147 | 101000111 | 1 | 4 | 0B8 | 010111000 | -1 | 4 |
| A9 | 171 | 101110001 | 1 | 4 | 08E | 010001110 | -1 | 4 |
| AA | 18D | 110001101 | 1 | 4 | 072 | 001110010 | -1 | 4 |
| AB | 199 | 110011001 | 1 | 4 | 066 | 001100110 | -1 | 4 |
| AC | 1B1 | 110110001 | 1 | 4 | 04E | 001001110 | -1 | 4 |
| AD | 1C9 | 111001001 | 1 | 4 | 036 | 000110110 | -1 | 4 |
| AE | 02F | 000101111 | 1 | 3 | 1D0 | 111010000 | -1 | 3 |
| AF | 03B | 000111011 | 1 | 3 | 1C4 | 111000100 | -1 | 3 |
| B0 | 04F | 001001111 | 1 | 3 | 1B0 | 110110000 | -1 | 3 |
| B1 | 073 | 001110011 | 1 | 3 | 18C | 110001100 | -1 | 3 |
| B2 | 08F | 010001111 | 1 | 3 | 170 | 101110000 | -1 | 3 |
| B3 | 0E3 | 011100011 | 1 | 3 | 11C | 100011100 | -1 | 3 |
| B4 | 11E | 100011110 | 1 | 3 | 0E1 | 011100001 | -1 | 3 |
| B5 | 178 | 101111000 | 1 | 3 | 087 | 010000111 | -1 | 3 |
| B6 | 19C | 110011100 | 1 | 3 | 063 | 001100011 | -1 | 3 |
| B7 | 1C6 | 111000110 | 1 | 3 | 039 | 000111001 | -1 | 3 |
| B8 | 1D8 | 111011000 | 1 | 3 | 027 | 000100111 | -1 | 3 |
| B9 | 1E4 | 111100100 | 1 | 3 | 01B | 000011011 | -1 | 3 |
| BA | 03E | 000111110 | 1 | 2 | 1C1 | 111000001 | -1 | 2 |
| BB | 0F8 | 011111000 | 1 | 2 | 107 | 100000111 | -1 | 2 |
| BC | 187 | 110000111 | 1 | 2 | 078 | 001111000 | -1 | 2 |
| BD | 1E1 | 111100001 | 1 | 2 | 01E | 000011110 | -1 | 2 |
| BE | 1F0 | 111110000 | 1 | 1 | 00F | 000001111 | -1 | 1 |
| BF | 15B | 101011011 | 3 | 6 | 0A4 | 010100100 | -3 | 6 |

# TABLE 2-7

| ADDRESS | TABLE A2 | | | | TABLE B2 | | | |
|---------|---------------------|---------------|-----|-----|---------------------|---------------|-----|-----|
| | HEXADECIMAL NUMBER | BINARY NUMBER | DSV | INV | HEXADECIMAL NUMBER | BINARY NUMBER | DSV | INV |
| C0 | 16B | 101101011 | 3 | 6 | 094 | 010010100 | -3 | 6 |
| C1 | 175 | 101110101 | 3 | 6 | 08A | 010001010 | -3 | 6 |
| C2 | 1AD | 110101101 | 3 | 6 | 052 | 001010010 | -3 | 6 |
| C3 | 1D5 | 111010101 | 3 | 6 | 02A | 000101010 | -3 | 6 |
| C4 | 0B7 | 010110111 | 3 | 5 | 148 | 101001000 | -3 | 5 |
| C5 | 0BD | 010111101 | 3 | 5 | 142 | 101000010 | -3 | 5 |
| C6 | 0DB | 011011011 | 3 | 5 | 124 | 100100100 | -3 | 5 |
| C7 | 0EB | 011101011 | 3 | 5 | 114 | 100010100 | -3 | 5 |
| C8 | 0F5 | 011110101 | 3 | 5 | 10A | 100001010 | -3 | 5 |
| C9 | 16E | 101101110 | 3 | 5 | 091 | 010010001 | -3 | 5 |
| CA | 17A | 101111010 | 3 | 5 | 085 | 010000101 | -3 | 5 |
| CB | 1B6 | 110110110 | 3 | 5 | 049 | 001001001 | -3 | 5 |
| CC | 1D6 | 111010110 | 3 | 5 | 029 | 000101001 | -3 | 5 |
| CD | 1EA | 111101010 | 3 | 5 | 015 | 000010101 | -3 | 5 |
| CE | 0DE | 011011110 | 3 | 4 | 121 | 100100001 | -3 | 4 |
| CF | 0F6 | 011110110 | 3 | 4 | 109 | 100001001 | -3 | 4 |
| D0 | 12F | 100101111 | 3 | 4 | 0D0 | 011010000 | -3 | 4 |
| D1 | 13B | 100111011 | 3 | 4 | 0C4 | 011000100 | -3 | 4 |
| D2 | 14F | 101001111 | 3 | 4 | 0B0 | 010110000 | -3 | 4 |
| D3 | 173 | 101110011 | 3 | 4 | 08C | 010001100 | -3 | 4 |
| D4 | 197 | 110010111 | 3 | 4 | 068 | 001101000 | -3 | 4 |
| D5 | 19D | 110011101 | 3 | 4 | 062 | 001100010 | -3 | 4 |
| D6 | 1B3 | 110110011 | 3 | 4 | 04C | 001001100 | -3 | 4 |
| D7 | 1CB | 111001011 | 3 | 4 | 034 | 000110100 | -3 | 4 |
| D8 | 1D3 | 111010011 | 3 | 4 | 02C | 000101100 | -3 | 4 |
| D9 | 1E5 | 111100101 | 3 | 4 | 01A | 000011010 | -3 | 4 |
| DA | 05F | 001011111 | 3 | 3 | 1A0 | 110100000 | -3 | 3 |
| DB | 077 | 001110111 | 3 | 3 | 188 | 110001000 | -3 | 3 |
| DC | 07D | 001111101 | 3 | 3 | 182 | 110000010 | -3 | 3 |
| DD | 0CF | 011001111 | 3 | 3 | 130 | 100110000 | -3 | 3 |
| DE | 0F3 | 011110011 | 3 | 3 | 10C | 100001100 | -3 | 3 |
| DF | 13E | 100111110 | 3 | 3 | 0C1 | 011000001 | -3 | 3 |

# TABLE 2-8

| ADDRESS | TABLE A2 | | | | TABLE B2 | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| E0 | 19E | 110011110 | 3 | 3 | 061 | 001100001 | -3 | 3 |
| E1 | 1CE | 111001110 | 3 | 3 | 031 | 000110001 | -3 | 3 |
| E2 | 1E6 | 111100110 | 3 | 3 | 019 | 000011001 | -3 | 3 |
| E3 | 1F2 | 111110010 | 3 | 3 | 00D | 000001101 | -3 | 3 |
| E4 | 07E | 001111110 | 3 | 2 | 181 | 110000001 | -3 | 2 |
| E5 | 11F | 100011111 | 3 | 2 | 0E0 | 011100000 | -3 | 2 |
| E6 | 1C7 | 111000111 | 3 | 2 | 038 | 000111000 | -3 | 2 |
| E7 | 1F1 | 111110001 | 3 | 2 | 00E | 000001110 | -3 | 2 |
| E8 | 1F8 | 111111000 | 3 | 1 | 007 | 000000111 | -3 | 1 |
| E9 | 16F | 101101111 | 5 | 4 | 090 | 010010000 | -5 | 4 |
| EA | 17B | 101111011 | 5 | 4 | 084 | 010000100 | -5 | 4 |
| EB | 1AF | 110101111 | 5 | 4 | 050 | 001010000 | -5 | 4 |
| EC | 1BB | 110111011 | 5 | 4 | 044 | 001000100 | -5 | 4 |
| ED | 1D7 | 111010111 | 5 | 4 | 028 | 000101000 | -5 | 4 |
| EE | 1DD | 111011101 | 5 | 4 | 022 | 000100010 | -5 | 4 |
| EF | 1ED | 111101101 | 5 | 4 | 012 | 000010010 | -5 | 4 |
| F0 | 0BF | 010111111 | 5 | 3 | 140 | 101000000 | -5 | 3 |
| F1 | 0EF | 011101111 | 5 | 3 | 110 | 100010000 | -5 | 3 |
| F2 | 0FB | 011111011 | 5 | 3 | 104 | 100000100 | -5 | 3 |
| F3 | 17E | 101111110 | 5 | 3 | 081 | 010000001 | -5 | 3 |
| F4 | 1DE | 111011110 | 5 | 3 | 021 | 000100001 | -5 | 3 |
| F5 | 1F6 | 111110110 | 5 | 3 | 009 | 000001001 | -5 | 3 |
| F6 | 0FE | 011111110 | 5 | 2 | 101 | 100000001 | -5 | 2 |
| F7 | 19F | 110011111 | 5 | 2 | 060 | 001100000 | -5 | 2 |
| F8 | 1E7 | 111100111 | 5 | 2 | 018 | 000011000 | -5 | 2 |
| F9 | 1F9 | 111111001 | 5 | 2 | 006 | 000000110 | -5 | 2 |
| FA | 1FC | 111111100 | 5 | 1 | 003 | 000000011 | -5 | 1 |
| FB | 1BF | 110111111 | 7 | 2 | 040 | 001000000 | -7 | 2 |
| FC | 1EF | 111101111 | 7 | 2 | 010 | 000010000 | -7 | 2 |
| FD | 1FB | 111111011 | 7 | 2 | 004 | 000000100 | -7 | 2 |
| FE | 0FF | 011111111 | 7 | 1 | 100 | 100000000 | -7 | 1 |
| FF | 1FF | 111111111 | 9 | 0 | 000 | 000000000 | -9 | 0 |

# TABLE 3-1

| ADDRESS | PRINCIPAL CONVERSION TABLE | | | | AUXILIARY CONVERSION TABLE | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 00 | 187 | 110000111 | 1 | 2 | 000 | 000000000 | -9 | 0 |
| 01 | 10F | 100001111 | 1 | 2 | 001 | 000000001 | -7 | 1 |
| 02 | 173 | 101110011 | 3 | 4 | 100 | 100000000 | -7 | 1 |
| 03 | 167 | 101100111 | 3 | 4 | 002 | 000000010 | -7 | 2 |
| 04 | 14F | 101001111 | 3 | 4 | 004 | 000000100 | -7 | 2 |
| 05 | 13D | 100111101 | 3 | 4 | 008 | 000001000 | -7 | 2 |
| 06 | 13B | 100111011 | 3 | 4 | 010 | 000010000 | -7 | 2 |
| 07 | 137 | 100110111 | 3 | 4 | 020 | 000100000 | -7 | 2 |
| 08 | 12F | 100101111 | 3 | 4 | 040 | 001000000 | -7 | 2 |
| 09 | 0FA | 011111010 | 3 | 4 | 080 | 010000000 | -7 | 2 |
| 0A | 0F6 | 011110110 | 3 | 4 | 003 | 000000011 | -5 | 1 |
| 0B | 0EE | 011101110 | 3 | 4 | 180 | 110000000 | -5 | 1 |
| 0C | 0DE | 011011110 | 3 | 4 | 006 | 000000110 | -5 | 2 |
| 0D | 0BE | 010111110 | 3 | 4 | 00C | 000001100 | -5 | 2 |
| 0E | 1BA | 110111010 | 3 | 5 | 018 | 000011000 | -5 | 2 |
| 0F | 1B6 | 110110110 | 3 | 5 | 030 | 000110000 | -5 | 2 |
| 10 | 1AE | 110101110 | 3 | 5 | 060 | 001100000 | -5 | 2 |
| 11 | 17A | 101111010 | 3 | 5 | 0C0 | 011000000 | -5 | 2 |
| 12 | 176 | 101110110 | 3 | 5 | 101 | 100000001 | -5 | 2 |
| 13 | 16E | 101101110 | 3 | 5 | 005 | 000000101 | -5 | 3 |
| 14 | 15E | 101011110 | 3 | 5 | 009 | 000001001 | -5 | 3 |
| 15 | 0F5 | 011110101 | 3 | 5 | 011 | 000010001 | -5 | 3 |
| 16 | 0ED | 011101101 | 3 | 5 | 021 | 000100001 | -5 | 3 |
| 17 | 0EB | 011101011 | 3 | 5 | 041 | 001000001 | -5 | 3 |
| 18 | 0DD | 011011101 | 3 | 5 | 081 | 010000001 | -5 | 3 |
| 19 | 0DB | 011011011 | 3 | 5 | 102 | 100000010 | -5 | 3 |
| 1A | 0D7 | 011010111 | 3 | 5 | 104 | 100000100 | -5 | 3 |
| 1B | 0BD | 010111101 | 3 | 5 | 108 | 100001000 | -5 | 3 |
| 1C | 0BB | 010111011 | 3 | 5 | 110 | 100010000 | -5 | 3 |
| 1D | 0B7 | 010110111 | 3 | 5 | 120 | 100100000 | -5 | 3 |
| 1E | 0AF | 010101111 | 3 | 5 | 140 | 101000000 | -5 | 3 |
| 1F | 1B5 | 110110101 | 3 | 6 | 00A | 000001010 | -5 | 4 |

# TABLE 3-2

| ADDRESS | PRINCIPAL CONVERSION TABLE | | | | AUXILIARY CONVERSION TABLE | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 20 | 1AD | 110101101 | 3 | 6 | 012 | 000010010 | -5 | 4 |
| 21 | 1AB | 110101011 | 3 | 6 | 014 | 000010100 | -5 | 4 |
| 22 | 175 | 101110101 | 3 | 6 | 022 | 000100010 | -5 | 4 |
| 23 | 16D | 101101101 | 3 | 6 | 024 | 000100100 | -5 | 4 |
| 24 | 16B | 101101011 | 3 | 6 | 028 | 000101000 | -5 | 4 |
| 25 | 15D | 101011101 | 3 | 6 | 042 | 001000010 | -5 | 4 |
| 26 | 15B | 101011011 | 3 | 6 | 044 | 001000100 | -5 | 4 |
| 27 | 157 | 101010111 | 3 | 6 | 048 | 001001000 | -5 | 4 |
| 28 | 18E | 110001110 | 1 | 3 | 050 | 001010000 | -5 | 4 |
| 29 | 11E | 100011110 | 1 | 3 | 082 | 010000010 | -5 | 4 |
| 2A | 0F1 | 011110001 | 1 | 3 | 084 | 010000100 | -5 | 4 |
| 2B | 0E3 | 011100011 | 1 | 3 | 088 | 010001000 | -5 | 4 |
| 2C | 0C7 | 011000111 | 1 | 3 | 090 | 010010000 | -5 | 4 |
| 2D | 08F | 010001111 | 1 | 3 | 0A0 | 010100000 | -5 | 4 |
| 2E | 079 | 001111001 | 1 | 3 | 007 | 000000111 | -3 | 1 |
| 2F | 073 | 001110011 | 1 | 3 | 1C0 | 111000000 | -3 | 1 |
| 30 | 067 | 001100111 | 1 | 3 | 00E | 000001110 | -3 | 2 |
| 31 | 04F | 001001111 | 1 | 3 | 01C | 000011100 | -3 | 2 |
| 32 | 1B1 | 110110001 | 1 | 4 | 038 | 000111000 | -3 | 2 |
| 33 | 1A3 | 110100011 | 1 | 4 | 070 | 001110000 | -3 | 2 |
| 34 | 199 | 110011001 | 1 | 4 | 0E0 | 011100000 | -3 | 2 |
| 35 | 198 | 110010011 | 1 | 4 | 103 | 100000011 | -3 | 2 |
| 36 | 18D | 110001101 | 1 | 4 | 181 | 110000001 | -3 | 2 |
| 37 | 18B | 110001011 | 1 | 4 | 00B | 000001011 | -3 | 3 |
| 38 | 171 | 101110001 | 1 | 4 | 00D | 000001101 | -3 | 3 |
| 39 | 163 | 101100011 | 1 | 4 | 013 | 000010011 | -3 | 3 |
| 3A | 147 | 101000111 | 1 | 4 | 019 | 000011001 | -3 | 3 |
| 3B | 139 | 100111001 | 1 | 4 | 023 | 000100011 | -3 | 3 |
| 3C | 133 | 100110011 | 1 | 4 | 031 | 000110001 | -3 | 3 |
| 3D | 127 | 100100111 | 1 | 4 | 043 | 001000011 | -3 | 3 |
| 3E | 11D | 100011101 | 1 | 4 | 061 | 001100001 | -3 | 3 |
| 3F | 11B | 100011011 | 1 | 4 | 083 | 010000011 | -3 | 3 |

# TABLE 3-3

| ADDRESS | PRINCIPAL CONVERSION TABLE | | | | AUXILIARY CONVERSION TABLE | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 40 | 117 | 100010111 | 1 | 4 | 0C1 | 011000001 | -3 | 3 |
| 41 | 0F2 | 011110010 | 1 | 4 | 106 | 100000110 | -3 | 3 |
| 42 | 0E6 | 011100110 | 1 | 4 | 10C | 100001100 | -3 | 3 |
| 43 | 0CE | 011001110 | 1 | 4 | 118 | 100011000 | -3 | 3 |
| 44 | 09E | 010011110 | 1 | 4 | 130 | 100110000 | -3 | 3 |
| 45 | 07A | 001111010 | 1 | 4 | 160 | 101100000 | -3 | 3 |
| 46 | 076 | 001110110 | 1 | 4 | 182 | 110000010 | -3 | 3 |
| 47 | 06E | 001101110 | 1 | 4 | 184 | 110000100 | -3 | 3 |
| 48 | 05E | 001011110 | 1 | 4 | 188 | 110001000 | -3 | 3 |
| 49 | 1B2 | 110110010 | 1 | 5 | 190 | 110010000 | -3 | 3 |
| 4A | 1A6 | 110100110 | 1 | 5 | 1A0 | 110100000 | -3 | 3 |
| 4B | 19A | 110011010 | 1 | 5 | 016 | 000010110 | -3 | 4 |
| 4C | 196 | 110010110 | 1 | 5 | 01A | 000011010 | -3 | 4 |
| 4D | 172 | 101110010 | 1 | 5 | 026 | 000100110 | -3 | 4 |
| 4E | 166 | 101100110 | 1 | 5 | 02C | 000101100 | -3 | 4 |
| 4F | 14E | 101001110 | 1 | 5 | 032 | 000110010 | -3 | 4 |
| 50 | 13A | 100111010 | 1 | 5 | 034 | 000110100 | -3 | 4 |
| 51 | 136 | 100110110 | 1 | 5 | 046 | 001000110 | -3 | 4 |
| 52 | 12E | 100101110 | 1 | 5 | 04C | 001001100 | -3 | 4 |
| 53 | 0E9 | 011101001 | 1 | 5 | 058 | 001011000 | -3 | 4 |
| 54 | 0E5 | 011100101 | 1 | 5 | 062 | 001100010 | -3 | 4 |
| 55 | 0D9 | 011011001 | 1 | 5 | 064 | 001100100 | -3 | 4 |
| 56 | 0D3 | 011010011 | 1 | 5 | 068 | 001101000 | -3 | 4 |
| 57 | 0CD | 011001101 | 1 | 5 | 086 | 010000110 | -3 | 4 |
| 58 | 0CB | 011001011 | 1 | 5 | 015 | 000010101 | -3 | 5 |
| 59 | 0B9 | 010111001 | 1 | 5 | 025 | 000100101 | -3 | 5 |
| 5A | 0B3 | 010110011 | 1 | 5 | 029 | 000101001 | -3 | 5 |
| 5B | 0A7 | 010100111 | 1 | 5 | 02A | 000101010 | -3 | 6 |
| 5C | 09D | 010011101 | 1 | 5 | 00F | 000001111 | -1 | 1 |
| 5D | 09B | 010011011 | 1 | 5 | 1E0 | 111100000 | -1 | 1 |
| 5E | 097 | 010010111 | 1 | 5 | 01E | 000011110 | -1 | 2 |
| 5F | 075 | 001110101 | 1 | 5 | 03C | 000111100 | -1 | 2 |

# TABLE 3-4

| ADDRESS | PRINCIPAL CONVERSION TABLE | | | | AUXILIARY CONVERSION TABLE | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 60 | 06D | 001101101 | 1 | 5 | 107 | 100000111 | -1 | 2 |
| 61 | 06B | 001101011 | 1 | 5 | 183 | 110000011 | -1 | 2 |
| 62 | 05D | 001011101 | 1 | 5 | 1C1 | 111000001 | -1 | 2 |
| 63 | 05B | 001011011 | 1 | 5 | 017 | 000010111 | -1 | 3 |
| 64 | 057 | 001010111 | 1 | 5 | 01B | 000011011 | -1 | 3 |
| 65 | 1A9 | 110101001 | 1 | 6 | 01D | 000011101 | -1 | 3 |
| 66 | 1A5 | 110100101 | 1 | 6 | 027 | 000100111 | -1 | 3 |
| 67 | 195 | 110010101 | 1 | 6 | 033 | 000110011 | -1 | 3 |
| 68 | 169 | 101101001 | 1 | 6 | 039 | 000111001 | -1 | 3 |
| 69 | 165 | 101100101 | 1 | 6 | 047 | 001000111 | -1 | 3 |
| 6A | 159 | 101011001 | 1 | 6 | 063 | 001100011 | -1 | 3 |
| 6B | 153 | 101010011 | 1 | 6 | 087 | 010000111 | -1 | 3 |
| 6C | 14D | 101001101 | 1 | 6 | 0C3 | 011000011 | -1 | 3 |
| 6D | 14B | 101001011 | 1 | 6 | 1C2 | 111000010 | -1 | 3 |
| 6E | 135 | 100110101 | 1 | 6 | 1C4 | 111000100 | -1 | 3 |
| 6F | 12D | 100101101 | 1 | 6 | 1C8 | 111001000 | -1 | 3 |
| 70 | 12B | 100101011 | 1 | 6 | 1D0 | 111010000 | -1 | 3 |
| 71 | 0EA | 011101010 | 1 | 6 | 02E | 000101110 | -1 | 4 |
| 72 | 0DA | 011011010 | 1 | 6 | 036 | 000110110 | -1 | 4 |
| 73 | 0D6 | 011010110 | 1 | 6 | 03A | 000111010 | -1 | 4 |
| 74 | 0BA | 010111010 | 1 | 6 | 10B | 100001011 | -1 | 4 |
| 75 | 0B6 | 010110110 | 1 | 6 | 113 | 100010011 | -1 | 4 |
| 76 | 0AE | 010101110 | 1 | 6 | 123 | 100100011 | -1 | 4 |
| 77 | 1AA | 110101010 | 1 | 7 | 143 | 101000011 | -1 | 4 |
| 78 | 16A | 101101010 | 1 | 7 | 02B | 000101011 | -1 | 5 |
| 79 | 15A | 101011010 | 1 | 7 | 02D | 000101101 | -1 | 5 |
| 7A | 156 | 101010110 | 1 | 7 | 035 | 000110101 | -1 | 5 |
| 7B | 0D5 | 011010101 | 1 | 7 | 04B | 001001011 | -1 | 5 |
| 7C | 0B5 | 010110101 | 1 | 7 | 053 | 001010011 | -1 | 5 |
| 7D | 0AD | 010101101 | 1 | 7 | 08B | 010001011 | -1 | 5 |
| 7E | 0AB | 010101011 | 1 | 7 | 093 | 010010011 | -1 | 5 |
| 7F | 155 | 101010101 | 1 | 8 | 0A3 | 010100011 | -1 | 5 |

# TABLE 3-5

| ADDRESS | PRINCIPAL CONVERSION TABLE | | | | AUXILIARY CONVERSION TABLE | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 80 | 0AA | 010101010 | -1 | 8 | 15C | 101011100 | 1 | 5 |
| 81 | 154 | 101010100 | -1 | 7 | 16C | 101101100 | 1 | 5 |
| 82 | 152 | 101010010 | -1 | 7 | 174 | 101110100 | 1 | 5 |
| 83 | 14A | 101001010 | -1 | 7 | 1AC | 110101100 | 1 | 5 |
| 84 | 12A | 100101010 | -1 | 7 | 1B4 | 110110100 | 1 | 5 |
| 85 | 0A9 | 010101001 | -1 | 7 | 1CA | 111001010 | 1 | 5 |
| 86 | 0A5 | 010100101 | -1 | 7 | 1D2 | 111010010 | 1 | 5 |
| 87 | 095 | 010010101 | -1 | 7 | 1D4 | 111010100 | 1 | 5 |
| 88 | 055 | 001010101 | -1 | 7 | 0BC | 010111100 | 1 | 4 |
| 89 | 151 | 101010001 | -1 | 6 | 0DC | 011011100 | 1 | 4 |
| 8A | 149 | 101001001 | -1 | 6 | 0EC | 011101100 | 1 | 4 |
| 8B | 145 | 101000101 | -1 | 6 | 0F4 | 011110100 | 1 | 4 |
| 8C | 129 | 100101001 | -1 | 6 | 1C5 | 111000101 | 1 | 4 |
| 8D | 125 | 100100101 | -1 | 6 | 1C9 | 111001001 | 1 | 4 |
| 8E | 115 | 100010101 | -1 | 6 | 1D1 | 111010001 | 1 | 4 |
| 8F | 0D4 | 011010100 | -1 | 6 | 02F | 000101111 | 1 | 3 |
| 90 | 0D2 | 011010010 | -1 | 6 | 037 | 000110111 | 1 | 3 |
| 91 | 0CA | 011001010 | -1 | 6 | 03B | 000111011 | 1 | 3 |
| 92 | 0B4 | 010110100 | -1 | 6 | 03D | 000111101 | 1 | 3 |
| 93 | 0B2 | 010110010 | -1 | 6 | 13C | 100111100 | 1 | 3 |
| 94 | 0AC | 010101100 | -1 | 6 | 178 | 101111000 | 1 | 3 |
| 95 | 0A6 | 010100110 | -1 | 6 | 19C | 110011100 | 1 | 3 |
| 96 | 09A | 010011010 | -1 | 6 | 1B8 | 110111000 | 1 | 3 |
| 97 | 096 | 010010110 | -1 | 6 | 1C6 | 111000110 | 1 | 3 |
| 98 | 06A | 001101010 | -1 | 6 | 1CC | 111001100 | 1 | 3 |
| 99 | 05A | 001011010 | -1 | 6 | 1D8 | 111011000 | 1 | 3 |
| 9A | 056 | 001010110 | -1 | 6 | 1E2 | 111100010 | 1 | 3 |
| 9B | 1A8 | 110101000 | -1 | 5 | 1E4 | 111100100 | 1 | 3 |
| 9C | 1A4 | 110100100 | -1 | 5 | 1E8 | 111101000 | 1 | 3 |
| 9D | 1A2 | 110100010 | -1 | 5 | 03E | 000111110 | 1 | 2 |
| 9E | 194 | 110010100 | -1 | 5 | 07C | 001111100 | 1 | 2 |
| 9F | 192 | 110010010 | -1 | 5 | 0F8 | 011111000 | 1 | 2 |

# TABLE 3-6

| ADDRESS | PRINCIPAL CONVERSION TABLE | | | | AUXILIARY CONVERSION TABLE | | | |
|---------|-----------------------|---------------|-----|-----|-----------------------|---------------|-----|-----|
| | HEXADECIMAL NUMBER | BINARY NUMBER | DSV | INV | HEXADECIMAL NUMBER | BINARY NUMBER | DSV | INV |
| A0 | 18A | 110001010 | -1 | 5 | 1C3 | 111000011 | 1 | 2 |
| A1 | 168 | 101101000 | -1 | 5 | 1E1 | 111100001 | 1 | 2 |
| A2 | 164 | 101100100 | -1 | 5 | 01F | 000011111 | 1 | 1 |
| A3 | 162 | 101100010 | -1 | 5 | 1F0 | 111110000 | 1 | 1 |
| A4 | 158 | 101011000 | -1 | 5 | 1D5 | 111010101 | 3 | 6 |
| A5 | 14C | 101001100 | -1 | 5 | 1D6 | 111010110 | 3 | 5 |
| A6 | 146 | 101000110 | -1 | 5 | 1DA | 111011010 | 3 | 5 |
| A7 | 134 | 100110100 | -1 | 5 | 1EA | 111101010 | 3 | 5 |
| A8 | 132 | 100110010 | -1 | 5 | 179 | 101111001 | 3 | 4 |
| A9 | 12C | 100101100 | -1 | 5 | 197 | 110010111 | 3 | 4 |
| AA | 126 | 100100110 | -1 | 5 | 19B | 110011011 | 3 | 4 |
| AB | 11A | 100011010 | -1 | 5 | 19D | 110011101 | 3 | 4 |
| AC | 116 | 100010110 | -1 | 5 | 1A7 | 110100111 | 3 | 4 |
| AD | 0D1 | 011010001 | -1 | 5 | 1B3 | 110110011 | 3 | 4 |
| AE | 0C9 | 011001001 | -1 | 5 | 1B9 | 110111001 | 3 | 4 |
| AF | 0C5 | 011000101 | -1 | 5 | 1CB | 111001011 | 3 | 4 |
| B0 | 0B1 | 010110001 | -1 | 5 | 1CD | 111001101 | 3 | 4 |
| B1 | 099 | 010011001 | -1 | 5 | 1D3 | 111010011 | 3 | 4 |
| B2 | 08D | 010001101 | -1 | 5 | 1D9 | 111011001 | 3 | 4 |
| B3 | 069 | 001101001 | -1 | 5 | 1E5 | 111100101 | 3 | 4 |
| B4 | 065 | 001100101 | -1 | 5 | 1E9 | 111101001 | 3 | 4 |
| B5 | 059 | 001011001 | -1 | 5 | 05F | 001011111 | 3 | 3 |
| B6 | 04D | 001001101 | -1 | 5 | 06F | 001101111 | 3 | 3 |
| B7 | 1A1 | 110100001 | -1 | 4 | 077 | 001110111 | 3 | 3 |
| B8 | 191 | 110010001 | -1 | 4 | 07B | 001111011 | 3 | 3 |
| B9 | 189 | 110001001 | -1 | 4 | 07D | 001111101 | 3 | 3 |
| BA | 185 | 110000101 | -1 | 4 | 09F | 010011111 | 3 | 3 |
| BB | 161 | 10110000 | -1 | 4 | 0CF | 011001111 | 3 | 3 |
| BC | 131 | 100110001 | -1 | 4 | 0E7 | 011100111 | 3 | 3 |
| BD | 119 | 100011001 | -1 | 4 | 0F3 | 011110011 | 3 | 3 |
| BE | 10D | 100001101 | -1 | 4 | 0F9 | 011111001 | 3 | 3 |
| BF | 0E8 | 011101000 | -1 | 4 | 13E | 100111110 | 3 | 3 |

# TABLE 3-7

| ADDRESS | PRINCIPAL CONVERSION TABLE | | | | AUXILIARY CONVERSION TABLE | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| C0 | 0E4 | 011100100 | -1 | 4 | 17C | 101111100 | 3 | 3 |
| C1 | 0E2 | 011100010 | -1 | 4 | 19E | 110011110 | 3 | 3 |
| C2 | 0D8 | 011011000 | -1 | 4 | 1BC | 110111100 | 3 | 3 |
| C3 | 0CC | 011001100 | -1 | 4 | 1CE | 111001110 | 3 | 3 |
| C4 | 0C6 | 011000110 | -1 | 4 | 1DC | 111011100 | 3 | 3 |
| C5 | 0B8 | 010111000 | -1 | 4 | 1E6 | 111100110 | 3 | 3 |
| C6 | 09C | 010011100 | -1 | 4 | 1EC | 111101100 | 3 | 3 |
| C7 | 08E | 010001110 | -1 | 4 | 1F2 | 111110010 | 3 | 3 |
| C8 | 074 | 001110100 | -1 | 4 | 1F4 | 111110100 | 3 | 3 |
| C9 | 072 | 001110010 | -1 | 4 | 07E | 001111110 | 3 | 2 |
| CA | 06C | 001101100 | -1 | 4 | 0FC | 011111100 | 3 | 2 |
| CB | 066 | 001100110 | -1 | 4 | 11F | 100011111 | 3 | 2 |
| CC | 05C | 001011100 | -1 | 4 | 18F | 110001111 | 3 | 2 |
| CD | 04E | 001001110 | -1 | 4 | 1C7 | 111000111 | 3 | 2 |
| CE | 1B0 | 110110000 | -1 | 3 | 1E3 | 111100011 | 3 | 2 |
| CF | 198 | 110011000 | -1 | 3 | 1F1 | 111110001 | 3 | 2 |
| D0 | 18C | 110001100 | -1 | 3 | 03F | 000111111 | 3 | 1 |
| D1 | 186 | 110000110 | -1 | 3 | 1F8 | 111111000 | 3 | 1 |
| D2 | 170 | 101110000 | -1 | 3 | 15F | 101011111 | 5 | 4 |
| D3 | 138 | 100111000 | -1 | 3 | 16F | 101101111 | 5 | 4 |
| D4 | 11C | 100011100 | -1 | 3 | 177 | 101110111 | 5 | 4 |
| D5 | 10E | 100001110 | -1 | 3 | 17B | 101111011 | 5 | 4 |
| D6 | 0E1 | 011100001 | -1 | 3 | 17D | 101111101 | 5 | 4 |
| D7 | 071 | 001110001 | -1 | 3 | 1AF | 110101111 | 5 | 4 |
| D8 | 0A8 | 010101000 | -3 | 6 | 1B7 | 110110111 | 5 | 4 |
| D9 | 0A4 | 010100100 | -3 | 6 | 1BB | 110111011 | 5 | 4 |
| DA | 0A2 | 010100010 | -3 | 6 | 1BD | 110111101 | 5 | 4 |
| DB | 094 | 010010100 | -3 | 6 | 1D7 | 111010111 | 5 | 4 |
| DC | 092 | 010010010 | -3 | 6 | 1DB | 111011011 | 5 | 4 |
| DD | 08A | 010001010 | -3 | 6 | 1DD | 111011101 | 5 | 4 |
| DE | 054 | 001010100 | -3 | 6 | 1EB | 111101011 | 5 | 4 |
| DF | 052 | 001010010 | -3 | 6 | 1ED | 111101101 | 5 | 4 |

# TABLE 3-8

| ADDRESS | PRINCIPAL CONVERSION TABLE | | | | AUXILIARY CONVERSION TABLE | | | |
| --- | --- | --- | --- | --- | --- | --- | --- | --- |
| | HEXADECIMAL NUMBER | BINARY NUMBER | DSV | INV | HEXADECIMAL NUMBER | BINARY NUMBER | DSV | INV |
| E0 | 04A | 001001010 | -3 | 6 | 1F5 | 111110101 | 5 | 4 |
| E1 | 150 | 101010000 | -3 | 5 | 0BF | 010111111 | 5 | 3 |
| E2 | 148 | 101001000 | -3 | 5 | 0DF | 011011111 | 5 | 3 |
| E3 | 144 | 101000100 | -3 | 5 | 0EF | 011101111 | 5 | 3 |
| E4 | 142 | 101000010 | -3 | 5 | 0F7 | 011110111 | 5 | 3 |
| E5 | 128 | 100101000 | -3 | 5 | 0FB | 011111011 | 5 | 3 |
| E6 | 124 | 100100100 | -3 | 5 | 0FD | 011111101 | 5 | 3 |
| E7 | 122 | 100100010 | -3 | 5 | 17E | 101111110 | 5 | 3 |
| E8 | 114 | 100010100 | -3 | 5 | 1BE | 110111110 | 5 | 3 |
| E9 | 112 | 100010010 | -3 | 5 | 1DE | 111011110 | 5 | 3 |
| EA | 10A | 100001010 | -3 | 5 | 1EE | 111101110 | 5 | 3 |
| EB | 0A1 | 010100001 | -3 | 5 | 1F6 | 111110110 | 5 | 3 |
| EC | 091 | 010010001 | -3 | 5 | 1FA | 111111010 | 5 | 3 |
| ED | 089 | 010001001 | -3 | 5 | 0FE | 011111110 | 5 | 2 |
| EE | 085 | 010000101 | -3 | 5 | 13F | 100111111 | 5 | 2 |
| EF | 051 | 001010001 | -3 | 5 | 19F | 110011111 | 5 | 2 |
| F0 | 049 | 001001001 | -3 | 5 | 1CF | 111001111 | 5 | 2 |
| F1 | 045 | 001000101 | -3 | 5 | 1E7 | 111100111 | 5 | 2 |
| F2 | 141 | 101000001 | -3 | 4 | 1F3 | 111110011 | 5 | 2 |
| F3 | 121 | 100100001 | -3 | 4 | 1F9 | 111111001 | 5 | 2 |
| F4 | 111 | 100010001 | -3 | 4 | 07F | 001111111 | 5 | 1 |
| F5 | 109 | 100001001 | -3 | 4 | 1FC | 111111100 | 5 | 1 |
| F6 | 105 | 100000101 | -3 | 4 | 17F | 101111111 | 7 | 2 |
| F7 | 0D0 | 011010000 | -3 | 4 | 1BF | 110111111 | 7 | 2 |
| F8 | 0C8 | 011001000 | -3 | 4 | 1DF | 111011111 | 7 | 2 |
| F9 | 0C4 | 011000100 | -3 | 4 | 1EF | 111101111 | 7 | 2 |
| FA | 0C2 | 011000010 | -3 | 4 | 1F7 | 111110111 | 7 | 2 |
| FB | 0B0 | 010110000 | -3 | 4 | 1FB | 111111011 | 7 | 2 |
| FC | 098 | 010011000 | -3 | 4 | 1FD | 111111101 | 7 | 2 |
| FD | 08C | 010001100 | -3 | 4 | 0FF | 011111111 | 7 | 1 |
| FE | 0F0 | 011110000 | -1 | 2 | 1FE | 111111110 | 7 | 1 |
| FF | 078 | 001111000 | -1 | 2 | 1FF | 111111111 | 9 | 0 |

# TABLE 4-1

| ADDRESS | PRINCIPAL CONVERSION TABLE | | | | AUXILIARY CONVERSION TABLE | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 00 | 15B | 101011011 | 3 | 6 | 000 | 000000000 | -9 | 0 |
| 01 | 157 | 101010111 | 3 | 6 | 001 | 000000001 | -7 | 1 |
| 02 | 1F0 | 111110000 | 1 | 1 | 100 | 100000000 | -7 | 1 |
| 03 | 01F | 000011111 | 1 | 1 | 002 | 000000010 | -7 | 2 |
| 04 | 1E1 | 111100001 | 1 | 2 | 004 | 000000100 | -7 | 2 |
| 05 | 1C3 | 111000011 | 1 | 2 | 008 | 000001000 | -7 | 2 |
| 06 | 187 | 110000111 | 1 | 2 | 010 | 000010000 | -7 | 2 |
| 07 | 10F | 100001111 | 1 | 2 | 020 | 000100000 | -7 | 2 |
| 08 | 0F8 | 011111000 | 1 | 2 | 040 | 001000000 | -7 | 2 |
| 09 | 07C | 001111100 | 1 | 2 | 080 | 010000000 | -7 | 2 |
| 0A | 03E | 000111110 | 1 | 2 | 003 | 000000011 | -5 | 1 |
| 0B | 1E8 | 111101000 | 1 | 3 | 180 | 110000000 | -5 | 1 |
| 0C | 1E4 | 111100100 | 1 | 3 | 006 | 000000110 | -5 | 2 |
| 0D | 1E2 | 111100010 | 1 | 3 | 00C | 000001100 | -5 | 2 |
| 0E | 1D8 | 111011000 | 1 | 3 | 018 | 000011000 | -5 | 2 |
| 0F | 1CC | 111001100 | 1 | 3 | 030 | 000110000 | -5 | 2 |
| 10 | 1C6 | 111000110 | 1 | 3 | 060 | 001100000 | -5 | 2 |
| 11 | 1B8 | 110111000 | 1 | 3 | 0C0 | 011000000 | -5 | 2 |
| 12 | 19C | 110011100 | 1 | 3 | 101 | 100000001 | -5 | 2 |
| 13 | 18E | 110001110 | 1 | 3 | 005 | 000000101 | -5 | 3 |
| 14 | 178 | 101111000 | 1 | 3 | 009 | 000001001 | -5 | 3 |
| 15 | 13C | 100111100 | 1 | 3 | 011 | 000010001 | -5 | 3 |
| 16 | 11E | 100011110 | 1 | 3 | 021 | 000100001 | -5 | 3 |
| 17 | 0F1 | 011110001 | 1 | 3 | 041 | 001000001 | -5 | 3 |
| 18 | 0E3 | 011100011 | 1 | 3 | 081 | 010000001 | -5 | 3 |
| 19 | 0C7 | 011000111 | 1 | 3 | 102 | 100000010 | -5 | 3 |
| 1A | 08F | 010001111 | 1 | 3 | 104 | 100000100 | -5 | 3 |
| 1B | 079 | 001111001 | 1 | 3 | 108 | 100001000 | -5 | 3 |
| 1C | 073 | 001110011 | 1 | 3 | 110 | 100010000 | -5 | 3 |
| 1D | 067 | 001100111 | 1 | 3 | 120 | 100100000 | -5 | 3 |
| 1E | 04F | 001001111 | 1 | 3 | 140 | 101000000 | -5 | 3 |
| 1F | 03D | 000111101 | 1 | 3 | 00A | 000001010 | -5 | 4 |

# TABLE 4-2

| ADDRESS | PRINCIPAL CONVERSION TABLE | | | | AUXILIARY CONVERSION TABLE | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 20 | 03B | 000111011 | 1 | 3 | 012 | 000010010 | -5 | 4 |
| 21 | 037 | 000110111 | 1 | 3 | 014 | 000010100 | -5 | 4 |
| 22 | 02F | 000101111 | 1 | 3 | 022 | 000100010 | -5 | 4 |
| 23 | 1D1 | 111010001 | 1 | 4 | 024 | 000100100 | -5 | 4 |
| 24 | 1C9 | 111001001 | 1 | 4 | 028 | 000101000 | -5 | 4 |
| 25 | 1C5 | 111000101 | 1 | 4 | 042 | 001000010 | -5 | 4 |
| 26 | 1B1 | 110110001 | 1 | 4 | 044 | 001000100 | -5 | 4 |
| 27 | 1A3 | 110100011 | 1 | 4 | 048 | 001001000 | -5 | 4 |
| 28 | 199 | 110011001 | 1 | 4 | 050 | 001010000 | -5 | 4 |
| 29 | 193 | 110010011 | 1 | 4 | 082 | 010000010 | -5 | 4 |
| 2A | 18D | 110001101 | 1 | 4 | 084 | 010000100 | -5 | 4 |
| 2B | 18B | 110001011 | 1 | 4 | 08S | 010001000 | -5 | 4 |
| 2C | 171 | 101110001 | 1 | 4 | 090 | 010010000 | -5 | 4 |
| 2D | 163 | 101100011 | 1 | 4 | 0A0 | 010100000 | -5 | 4 |
| 2E | 147 | 101000111 | 1 | 4 | 007 | 000000111 | -3 | 1 |
| 2F | 139 | 100111001 | 1 | 4 | 1C0 | 111000000 | -3 | 1 |
| 30 | 133 | 100110011 | 1 | 4 | 00E | 000001110 | -3 | 2 |
| 31 | 127 | 100100111 | 1 | 4 | 01C | 000011100 | -3 | 2 |
| 32 | 11D | 100011101 | 1 | 4 | 038 | 000111000 | -3 | 2 |
| 33 | 11B | 100011011 | 1 | 4 | 070 | 001110000 | -3 | 2 |
| 34 | 117 | 100010111 | 1 | 4 | 0E0 | 011100000 | -3 | 2 |
| 35 | 0F4 | 011110100 | 1 | 4 | 103 | 100000011 | -3 | 2 |
| 36 | 0F2 | 011110010 | 1 | 4 | 181 | 110000001 | -3 | 2 |
| 37 | 0EC | 011101100 | 1 | 4 | 00B | 000001011 | -3 | 3 |
| 38 | 0E6 | 011100110 | 1 | 4 | 00D | 000001101 | -3 | 3 |
| 39 | 0DC | 011011100 | 1 | 4 | 013 | 000010011 | -3 | 3 |
| 3A | 0CE | 011001110 | 1 | 4 | 019 | 000011001 | -3 | 3 |
| 3B | 0BC | 010111100 | 1 | 4 | 023 | 000100011 | -3 | 3 |
| 3C | 09E | 010011110 | 1 | 4 | 031 | 000110001 | -3 | 3 |
| 3D | 07A | 001111010 | 1 | 4 | 043 | 001000011 | -3 | 3 |
| 3E | 076 | 001110110 | 1 | 4 | 061 | 001100001 | -3 | 3 |
| 3F | 06F | 001101110 | 1 | 4 | 083 | 010000011 | -3 | 3 |

# TABLE 4-3

| ADDRESS | PRINCIPAL CONVERSION TABLE | | | | AUXILIARY CONVERSION TABLE | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 40 | 05E | 001011110 | 1 | 4 | 0C1 | 011000001 | -3 | 3 |
| 41 | 1D4 | 111010100 | 1 | 5 | 106 | 100000110 | -3 | 3 |
| 42 | 1D2 | 111010010 | 1 | 5 | 10C | 100001100 | -3 | 3 |
| 43 | 1CA | 111001010 | 1 | 5 | 118 | 100011000 | -3 | 3 |
| 44 | 1B4 | 110110100 | 1 | 5 | 130 | 100110000 | -3 | 3 |
| 45 | 1B2 | 110110010 | 1 | 5 | 160 | 101100000 | -3 | 3 |
| 46 | 1AC | 110101100 | 1 | 5 | 182 | 110000010 | -3 | 3 |
| 47 | 1A6 | 110100110 | 1 | 5 | 184 | 110000100 | -3 | 3 |
| 48 | 19A | 110011010 | 1 | 5 | 188 | 110001000 | -3 | 3 |
| 49 | 196 | 110010110 | 1 | 5 | 190 | 110010000 | -3 | 3 |
| 4A | 174 | 101110100 | 1 | 5 | 1A0 | 110100000 | -3 | 3 |
| 4B | 172 | 101110010 | 1 | 5 | 016 | 000010110 | -3 | 4 |
| 4C | 16C | 101101100 | 1 | 5 | 01A | 000011010 | -3 | 4 |
| 4D | 166 | 101100110 | 1 | 5 | 026 | 000100110 | -3 | 4 |
| 4E | 15C | 101011100 | 1 | 5 | 02C | 000101100 | -3 | 4 |
| 4F | 14E | 101001110 | 1 | 5 | 032 | 000110010 | -3 | 4 |
| 50 | 13A | 100111010 | 1 | 5 | 034 | 000110100 | -3 | 4 |
| 51 | 136 | 100110110 | 1 | 5 | 046 | 001000110 | -3 | 4 |
| 52 | 12E | 100101110 | 1 | 5 | 04C | 001001100 | -3 | 4 |
| 53 | 0E9 | 011101001 | 1 | 5 | 058 | 001011000 | -3 | 4 |
| 54 | 0E5 | 011100101 | 1 | 5 | 062 | 001100010 | -3 | 4 |
| 55 | 0D9 | 011011001 | 1 | 5 | 064 | 001100100 | -3 | 4 |
| 56 | 0D3 | 011010011 | 1 | 5 | 068 | 001101000 | -3 | 4 |
| 57 | 0CD | 011001101 | 1 | 5 | 086 | 010000110 | -3 | 4 |
| 58 | 0CB | 011001011 | 1 | 5 | 08C | 010001100 | -3 | 4 |
| 59 | 0B9 | 010111001 | 1 | 5 | 098 | 010011000 | -3 | 4 |
| 5A | 0B3 | 010110011 | 1 | 5 | 0B0 | 010110000 | -3 | 4 |
| 5B | 0A7 | 010100111 | 1 | 5 | 0C2 | 011000010 | -3 | 4 |
| 5C | 09D | 010011101 | 1 | 5 | 0C4 | 011000100 | -3 | 4 |
| 5D | 09B | 010011011 | 1 | 5 | 0C8 | 011001000 | -3 | 4 |
| 5E | 097 | 010010111 | 1 | 5 | 0D0 | 011010000 | -3 | 4 |
| 5F | 075 | 001110101 | 1 | 5 | 105 | 100000101 | -3 | 4 |

# TABLE 4-4

| ADDRESS | PRINCIPAL CONVERSION TABLE | | | | AUXILIARY CONVERSION TABLE | | | |
|---------|---------------------------|---|---|---|---------------------------|---|---|---|
| | HEXADECIMAL NUMBER | BINARY NUMBER | DSV | INV | HEXADECIMAL NUMBER | BINARY NUMBER | DSV | INV |
| 60 | 06D | 001101101 | 1 | 5 | 109 | 100001001 | -3 | 4 |
| 61 | 06B | 001101011 | 1 | 5 | 111 | 100010001 | -3 | 4 |
| 62 | 05D | 001011101 | 1 | 5 | 121 | 100100001 | -3 | 4 |
| 63 | 05B | 001011011 | 1 | 5 | 141 | 101000001 | -3 | 4 |
| 64 | 057 | 001010111 | 1 | 5 | 015 | 000010101 | -3 | 5 |
| 65 | 1A9 | 110101001 | 1 | 6 | 025 | 000100101 | -3 | 5 |
| 66 | 1A5 | 110100101 | 1 | 6 | 029 | 000101001 | -3 | 5 |
| 67 | 195 | 110010101 | 1 | 6 | 045 | 001000101 | -3 | 5 |
| 68 | 169 | 101101001 | 1 | 6 | 049 | 001001001 | -3 | 5 |
| 69 | 165 | 101100101 | 1 | 6 | 051 | 001010001 | -3 | 5 |
| 6A | 159 | 101011001 | 1 | 6 | 085 | 010000101 | -3 | 5 |
| 6B | 153 | 101010011 | 1 | 6 | 089 | 010001001 | -3 | 5 |
| 6C | 14D | 101001101 | 1 | 6 | 091 | 010010001 | -3 | 5 |
| 6D | 14B | 101001011 | 1 | 6 | 0A1 | 010100001 | -3 | 5 |
| 6E | 135 | 100110101 | 1 | 6 | 10A | 100001010 | -3 | 5 |
| 6F | 12D | 100101101 | 1 | 6 | 112 | 100010010 | -3 | 5 |
| 70 | 12B | 100101011 | 1 | 6 | 114 | 100010100 | -3 | 5 |
| 71 | 0EA | 011101010 | 1 | 6 | 122 | 100100010 | -3 | 5 |
| 72 | 0DA | 011011010 | 1 | 6 | 124 | 100100100 | -3 | 5 |
| 73 | 0D6 | 011010110 | 1 | 6 | 128 | 100101000 | -3 | 5 |
| 74 | 0BA | 010111010 | 1 | 6 | 142 | 101000010 | -3 | 5 |
| 75 | 0B6 | 010110110 | 1 | 6 | 144 | 101000100 | -3 | 5 |
| 76 | 0AE | 010101110 | 1 | 6 | 148 | 101001000 | -3 | 5 |
| 77 | 1AA | 110101010 | 1 | 7 | 150 | 101010000 | -3 | 5 |
| 78 | 16A | 101101010 | 1 | 7 | 02A | 000101010 | -3 | 6 |
| 79 | 15A | 101011010 | 1 | 7 | 04A | 001001010 | -3 | 6 |
| 7A | 156 | 101010110 | 1 | 7 | 052 | 001010010 | -3 | 6 |
| 7B | 0D5 | 011010101 | 1 | 7 | 054 | 001010100 | -3 | 6 |
| 7C | 0B5 | 010110101 | 1 | 7 | 08A | 010001010 | -3 | 6 |
| 7D | 0AD | 010101101 | 1 | 7 | 092 | 010010010 | -3 | 6 |
| 7E | 0AB | 010101011 | 1 | 7 | 094 | 010010100 | -3 | 6 |
| 7F | 155 | 101010101 | 1 | 8 | 0A2 | 010100010 | -3 | 6 |

# TABLE 4-5

| ADDRESS | PRINCIPAL CONVERSION TABLE | | | | AUXILIARY CONVERSION TABLE | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| 80 | 0AA | 010101010 | -1 | 8 | 15D | 101011101 | 3 | 6 |
| 81 | 154 | 101010100 | -1 | 7 | 16B | 101101011 | 3 | 6 |
| 82 | 152 | 101010010 | -1 | 7 | 16D | 101101101 | 3 | 6 |
| 83 | 14A | 101001010 | -1 | 7 | 175 | 101110101 | 3 | 6 |
| 84 | 12A | 100101010 | -1 | 7 | 1AB | 110101011 | 3 | 6 |
| 85 | 0A9 | 010101001 | -1 | 7 | 1AD | 110101101 | 3 | 6 |
| 86 | 0A5 | 010100101 | -1 | 7 | 1B5 | 110110101 | 3 | 6 |
| 87 | 095 | 010010101 | -1 | 7 | 1D5 | 111010101 | 3 | 6 |
| 88 | 055 | 001010101 | -1 | 7 | 0AF | 010101111 | 3 | 5 |
| 89 | 151 | 101010001 | -1 | 6 | 0B7 | 010110111 | 3 | 5 |
| 8A | 149 | 101001001 | -1 | 6 | 0BB | 010111011 | 3 | 5 |
| 8B | 145 | 101000101 | -1 | 6 | 0BD | 010111101 | 3 | 5 |
| 8C | 129 | 100101001 | -1 | 6 | 0D7 | 011010111 | 3 | 5 |
| 8D | 125 | 100100101 | -1 | 6 | 0DB | 011011011 | 3 | 5 |
| 8E | 115 | 100010101 | -1 | 6 | 0DD | 011011101 | 3 | 5 |
| 8F | 0D4 | 011010100 | -1 | 6 | 0EB | 011101011 | 3 | 5 |
| 90 | 0D2 | 011010010 | -1 | 6 | 0ED | 011101101 | 3 | 5 |
| 91 | 0CA | 011001010 | -1 | 6 | 0F5 | 011110101 | 3 | 5 |
| 92 | 0B4 | 010110100 | -1 | 6 | 15E | 101011110 | 3 | 5 |
| 93 | 0B2 | 010110010 | -1 | 6 | 16E | 101101110 | 3 | 5 |
| 94 | 0AC | 010101100 | -1 | 6 | 176 | 101110110 | 3 | 5 |
| 95 | 0A6 | 010100110 | -1 | 6 | 17A | 101111010 | 3 | 5 |
| 96 | 09A | 010011010 | -1 | 6 | 1AE | 110101110 | 3 | 5 |
| 97 | 096 | 010010110 | -1 | 6 | 1B6 | 110110110 | 3 | 5 |
| 98 | 06A | 001101010 | -1 | 6 | 1BA | 110111010 | 3 | 5 |
| 99 | 05A | 001011010 | -1 | 6 | 1D6 | 111010110 | 3 | 5 |
| 9A | 056 | 001010110 | -1 | 6 | 1DA | 111011010 | 3 | 5 |
| 9B | 1A8 | 110101000 | -1 | 5 | 1EA | 111101010 | 3 | 5 |
| 9C | 1A4 | 110100100 | -1 | 5 | 0BE | 010111110 | 3 | 4 |
| 9D | 1A2 | 110100010 | -1 | 5 | 0DE | 011011110 | 3 | 4 |
| 9E | 194 | 110010100 | -1 | 5 | 0EE | 011101110 | 3 | 4 |
| 9F | 192 | 110010010 | -1 | 5 | 0F6 | 011110110 | 3 | 4 |

# TABLE 4-6

| ADDRESS | PRINCIPAL CONVERSION TABLE | | | | AUXILIARY CONVERSION TABLE | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| A0 | 18A | 110001010 | -1 | 5 | 0FA | 011111010 | 3 | 4 |
| A1 | 168 | 101101000 | -1 | 5 | 12F | 100101111 | 3 | 4 |
| A2 | 164 | 101100100 | -1 | 5 | 137 | 100110111 | 3 | 4 |
| A3 | 162 | 101100010 | -1 | 5 | 13B | 100111011 | 3 | 4 |
| A4 | 158 | 101011000 | -1 | 5 | 13D | 100111101 | 3 | 4 |
| A5 | 14C | 101001100 | -1 | 5 | 14F | 101001111 | 3 | 4 |
| A6 | 146 | 101000110 | -1 | 5 | 167 | 101100111 | 3 | 4 |
| A7 | 134 | 100110100 | -1 | 5 | 173 | 101110011 | 3 | 4 |
| A8 | 132 | 100110010 | -1 | 5 | 179 | 101111001 | 3 | 4 |
| A9 | 12C | 100101100 | -1 | 5 | 197 | 110010111 | 3 | 4 |
| AA | 126 | 100100110 | -1 | 5 | 19B | 110011011 | 3 | 4 |
| AB | 11A | 100011010 | -1 | 5 | 19D | 110011101 | 3 | 4 |
| AC | 116 | 100010110 | -1 | 5 | 1A7 | 110100111 | 3 | 4 |
| AD | 0D1 | 011010001 | -1 | 5 | 1B3 | 110110011 | 3 | 4 |
| AE | 0C9 | 011001001 | -1 | 5 | 1B9 | 110111001 | 3 | 4 |
| AF | 0C5 | 011000101 | -1 | 5 | 1CB | 111001011 | 3 | 4 |
| B0 | 0B1 | 010110001 | -1 | 5 | 1CD | 111001101 | 3 | 4 |
| B1 | 0A3 | 010100011 | -1 | 5 | 1D3 | 111010011 | 3 | 4 |
| B2 | 099 | 010011001 | -1 | 5 | 1D9 | 111011001 | 3 | 4 |
| B3 | 093 | 010010011 | -1 | 5 | 1E5 | 111100101 | 3 | 4 |
| B4 | 08D | 010001101 | -1 | 5 | 1E9 | 111101001 | 3 | 4 |
| B5 | 08B | 010001011 | -1 | 5 | 05F | 001011111 | 3 | 3 |
| B6 | 069 | 001101001 | -1 | 5 | 06F | 001101111 | 3 | 3 |
| B7 | 065 | 001100101 | -1 | 5 | 077 | 001110111 | 3 | 3 |
| B8 | 059 | 001011001 | -1 | 5 | 07B | 001111011 | 3 | 3 |
| B9 | 053 | 001010011 | -1 | 5 | 07D | 001111101 | 3 | 3 |
| BA | 04D | 001001101 | -1 | 5 | 09F | 010011111 | 3 | 3 |
| BB | 04B | 001001011 | -1 | 5 | 0CF | 011001111 | 3 | 3 |
| BC | 035 | 000110101 | -1 | 5 | 0E7 | 011100111 | 3 | 3 |
| BD | 02D | 000101101 | -1 | 5 | 0F3 | 011110011 | 3 | 3 |
| BE | 02B | 000101011 | -1 | 5 | 0F9 | 011111001 | 3 | 3 |
| BF | 1A1 | 110100001 | -1 | 4 | 13E | 100111110 | 3 | 3 |

EP 0 310 041 A2

# TABLE 4-7

| ADDRESS | PRINCIPAL CONVERSION TABLE | | | | AUXILIARY CONVERSION TABLE | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| C0 | 191 | 110010001 | -1 | 4 | 17C | 101111100 | 3 | 3 |
| C1 | 189 | 110001001 | -1 | 4 | 19E | 110011110 | 3 | 3 |
| C2 | 185 | 110000101 | -1 | 4 | 1BC | 110111100 | 3 | 3 |
| C3 | 161 | 101100001 | -1 | 4 | 1CE | 111001110 | 3 | 3 |
| C4 | 143 | 101000011 | -1 | 4 | 1DC | 111011100 | 3 | 3 |
| C5 | 131 | 100110001 | -1 | 4 | 1E6 | 111100110 | 3 | 3 |
| C6 | 123 | 100100011 | -1 | 4 | 1EC | 111101100 | 3 | 3 |
| C7 | 119 | 100011001 | -1 | 4 | 1F2 | 111110010 | 3 | 3 |
| C8 | 113 | 100010011 | -1 | 4 | 1F4 | 111110100 | 3 | 3 |
| C9 | 10D | 100001101 | -1 | 4 | 07E | 001111110 | 3 | 2 |
| CA | 10B | 100001011 | -1 | 4 | 0FC | 011111100 | 3 | 2 |
| CB | 0E8 | 011101000 | -1 | 4 | 11F | 100011111 | 3 | 2 |
| CC | 0E4 | 011100100 | -1 | 4 | 18F | 110001111 | 3 | 2 |
| CD | 0E2 | 011100010 | -1 | 4 | 1C7 | 111000111 | 3 | 2 |
| CE | 0D8 | 011011000 | -1 | 4 | 1E3 | 111100011 | 3 | 2 |
| CF | 0CC | 011001100 | -1 | 4 | 1F1 | 111110001 | 3 | 2 |
| D0 | 0C6 | 011000110 | -1 | 4 | 03F | 000111111 | 3 | 1 |
| D1 | 0B8 | 010111000 | -1 | 4 | 1F8 | 111111000 | 3 | 1 |
| D2 | 09C | 010011100 | -1 | 4 | 15F | 101011111 | 5 | 4 |
| D3 | 08E | 010001110 | -1 | 4 | 16F | 101101111 | 5 | 4 |
| D4 | 074 | 001110100 | -1 | 4 | 177 | 101110111 | 5 | 4 |
| D5 | 072 | 001110010 | -1 | 4 | 17B | 101111011 | 5 | 4 |
| D6 | 06C | 001101100 | -1 | 4 | 17D | 101111101 | 5 | 4 |
| D7 | 066 | 001100110 | -1 | 4 | 1AF | 110101111 | 5 | 4 |
| D8 | 05C | 001011100 | -1 | 4 | 1B7 | 110110111 | 5 | 4 |
| D9 | 04E | 001001110 | -1 | 4 | 1BB | 110111011 | 5 | 4 |
| DA | 03A | 000111010 | -1 | 4 | 1BD | 110111101 | 5 | 4 |
| DB | 036 | 000110110 | -1 | 4 | 1D7 | 111010111 | 5 | 4 |
| DC | 02E | 000101110 | -1 | 4 | 1DB | 111011011 | 5 | 4 |
| DD | 1D0 | 111010000 | -1 | 3 | 1DD | 111011101 | 5 | 4 |
| DE | 1C8 | 111001000 | -1 | 3 | 1EB | 111101011 | 5 | 4 |
| DF | 1C4 | 111000100 | -1 | 3 | 1ED | 111101101 | 5 | 4 |

# TABLE 4-8

| ADDRESS | PRINCIPAL CONVERSION TABLE | | | | AUXILIARY CONVERSION TABLE | | | |
|---|---|---|---|---|---|---|---|---|
| | HEXADECIMAL NUMBER | BINARY NUMBER | DSV | INV | HEXADECIMAL NUMBER | BINARY NUMBER | DSV | INV |
| E0 | 1C2 | 111000010 | -1 | 3 | 1F5 | 111110101 | 5 | 4 |
| E1 | 1B0 | 110110000 | -1 | 3 | 0BF | 010111111 | 5 | 3 |
| E2 | 198 | 110011000 | -1 | 3 | 0DF | 011011111 | 5 | 3 |
| E3 | 18C | 110001100 | -1 | 3 | 0EF | 011101111 | 5 | 3 |
| E4 | 186 | 110000110 | -1 | 3 | 0F7 | 011110111 | 5 | 3 |
| E5 | 170 | 101110000 | -1 | 3 | 0FB | 011111011 | 5 | 3 |
| E6 | 138 | 100111000 | -1 | 3 | 0FD | 011111101 | 5 | 3 |
| E7 | 11C | 100011100 | -1 | 3 | 17E | 101111110 | 5 | 3 |
| E8 | 10E | 100001110 | -1 | 3 | 1BE | 110111110 | 5 | 3 |
| E9 | 0E1 | 011100001 | -1 | 3 | 1DE | 111011110 | 5 | 3 |
| EA | 0C3 | 011000011 | -1 | 3 | 1EE | 111101110 | 5 | 3 |
| EB | 087 | 010000111 | -1 | 3 | 1F6 | 111110110 | 5 | 3 |
| EC | 071 | 001110001 | -1 | 3 | 1FA | 111111010 | 5 | 3 |
| ED | 063 | 001100011 | -1 | 3 | 0FE | 011111110 | 5 | 2 |
| EE | 047 | 001000111 | -1 | 3 | 13F | 100111111 | 5 | 2 |
| EF | 039 | 000111001 | -1 | 3 | 19F | 110011111 | 5 | 2 |
| F0 | 033 | 000110011 | -1 | 3 | 1CF | 111001111 | 5 | 2 |
| F1 | 027 | 000100111 | -1 | 3 | 1E7 | 111100111 | 5 | 2 |
| F2 | 01D | 000011101 | -1 | 3 | 1F3 | 111110011 | 5 | 2 |
| F3 | 01B | 000011011 | -1 | 3 | 1F9 | 111111001 | 5 | 2 |
| F4 | 017 | 000010111 | -1 | 3 | 07F | 001111111 | 5 | 1 |
| F5 | 1C1 | 111000001 | -1 | 2 | 1FC | 111111100 | 5 | 1 |
| F6 | 183 | 110000011 | -1 | 2 | 17F | 101111111 | 7 | 2 |
| F7 | 107 | 100000111 | -1 | 2 | 1BF | 110111111 | 7 | 2 |
| F8 | 0F0 | 011110000 | -1 | 2 | 1DF | 111011111 | 7 | 2 |
| F9 | 078 | 001111000 | -1 | 2 | 1EF | 111101111 | 7 | 2 |
| FA | 03C | 000111100 | -1 | 2 | 1F7 | 111110111 | 7 | 2 |
| FB | 01E | 000011110 | -1 | 2 | 1FB | 111111011 | 7 | 2 |
| FC | 1E0 | 111100000 | -1 | 1 | 1FD | 111111101 | 7 | 2 |
| FD | 00F | 000001111 | -1 | 1 | 0FF | 011111111 | 7 | 1 |
| FE | 0A8 | 010101000 | -3 | 6 | 1FE | 111111110 | 7 | 1 |
| FF | 0A4 | 010100100 | -3 | 6 | 1FF | 111111111 | 9 | 0 |